(19) Europäisches Patentamt
European Patent Office
Office européen des brevets

(11) EP 3 418 283 A1

(12) DEMANDE DE BREVET EUROPEEN

(43) Date de publication:
26.12.2018 Bulletin 2018/52

(51) Int Cl.:
*C07F 5/02* (2006.01) *H01L 51/42* (2006.01)

(21) Numéro de dépôt: 18185979.4

(22) Date de dépôt: 18.07.2013

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: 19.07.2012 FR 1257017

(62) Numéro(s) de document de la (des) demande(s) initiale(s) en application de l'article 76 CBE:
13756574.3 / 2 875 031

(71) Demandeurs:
- CENTRE NATIONAL DE LA RECHERCHE SCIENTIFIQUE 75016 Paris (FR)
- Université de Strasbourg 67070 Strasbourg (FR)

(72) Inventeurs:
- BURA, Thomas 67000 Strasbourg (FR)
- LECLERC, Nicolas 67200 Strasbourg (FR)
- RIHN, Sandra 67000 Strasbourg (FR)
- ZIESSEL, Raymond 67460 Souffelweyersheim (FR)
- MIRLOUP, Antoine 45430 Bou (FR)
- HEISER, Thomas 67270 Hochfelden (FR)
- LEVEQUE, Patrick 67700 Saverne (FR)
- FALL, Sadiara 67000 Strasbourg (FR)

(74) Mandataire: LLR
11, boulevard de Sébastopol
75001 Paris (FR)

Remarques:
Cette demande a été déposée le 27-07-2018 comme demande divisionnaire de la demande mentionnée sous le code INID 62.

# (54) COMPOSÉS FLUORESCENTS DE TYPE THIÉNYLDIPYRROMÉTHÈNE BORÉS ET LEURS UTILISATIONS

(57) La présente invention concerne des composés fluorescents de type thiényldipyrrométhène borés, leur procédé de préparation, ainsi que leur utilisation à titre de donner d'électron dans le domaine de l'électronique plastique, notamment pour l'élaboration d'une couche photoactive dans les cellules photovoltaïques de type hétérojonction volumique ou pour l'élaboration de transistors à effet de champ.

EP 3 418 283 A1

## Description

La présente invention concerne des composés fluorescents de type thiényldipyrrométhènes borés, leurs procédés de préparation, ainsi que leur utilisation à titre de donneur d'électrons dans le domaine de l'électronique plastique, notamment pour l'élaboration d'une couche photoactive dans les cellules photovoltaïques de type hétérojonction volumique ou pour l'élaboration de transistors à effet de champ.

Les cellules photovoltaïques les plus répandues sont constituées de semi-conducteurs, principalement à base de silicium (Si) amorphe, polycristallin ou monocristallin. Elles se présentent généralement sous la forme de fines plaques d'une dizaine de centimètres de côté, prises en sandwich entre deux contacts métalliques, pour une épaisseur de l'ordre du millimètre. Les cellules à base de silicium les plus performantes comprennent une couche active de silicium monocristallin dont le rendement de conversion peut atteindre 25 % en laboratoire.

Bien que très performantes, les cellules photovoltaïques à base de silicium, et en particulier de silicium monocristallin, présentent l'inconvénient majeur d'être onéreuses en raison du coût élevé de cette matière première et des budgets thermiques mis en oeuvre lors de l'élaboration des cellules photovoltaïques. C'est pourquoi une partie de la recherche se tourne vers les cellules à base de semi-conducteurs en couches minces.

Des cellules à base de semi-conducteurs organiques, et de composés organométalliques dont le coût de revient est moindre que celui du silicium ont déjà été proposées. Leur utilisation dans le domaine photovoltaïque est basée sur la capacité de certains polymères et oligomères $\pi$-conjugués, ou encore de certaines petites molécules $\pi$-conjuguées, à convertir l'énergie lumineuse en énergie électrique. Lorsqu'on constitue une jonction composée de deux semi-conducteurs de nature différente, à caractère respectivement donneur et accepteur d'électrons et parmi lesquels au moins un est un composé organique, on définit ainsi une hétérojonction.

C'est pourquoi, les hétérojonctions comprenant un semi-conducteur organique de type donneur d'électrons et un semi-conducteur organique ou inorganique de type accepteur d'électrons connaissent depuis plusieurs années de nombreuses applications dans le domaine de l'électronique plastique, et notamment dans celui particulier des cellules photovoltaïques. Généralement, dans celles-ci, un polymère $\pi$-conjugué, un oligomère $\pi$-conjugué, ou une petite molécule $\pi$-conjuguée joue le rôle de donneur d'électrons et est mis(e) en présence d'un accepteur d'électrons tel que par exemple le fullerène, ou un dérivé de celui-ci. Sous irradiation lumineuse, une paire électron-trou liée (exciton) est créée sur le donneur d'électrons. Cet exciton est dissocié par saut de l'électron du niveau LUMO du donneur au niveau LUMO de l'accepteur, le trou restant sur le niveau HOMO du donneur. Les charges ainsi séparées sont ensuite collectées aux électrodes et génèrent un courant électrique.

Parmi les nombreux composés organiques connus de l'art antérieur et utilisables à titre de donneur d'électrons pour l'élaboration des couches actives, on peut citer notamment les oligothiophènes (Fitzner, R et al.. Adv. Funct. Mater, 2011, 21, 897-910), les dikétopyrrolopyrrole (DPP) comme décrit par exemple par Walker, B et al. (Adv. Funct. Mater., 2009, 19, 3063-3069), les squaraines (Wei, G. et al., Adv. Eng. Mater., 2011, 2, 184-187 et Ajayaghosh, A. Acc. Chem. Res., 2005, 38, 449-459), les hexabenzocoronènes (Wong, W. W. H. et al., Adv. Funct. Mater., 2010, 20, 927-938), les merocyanines (Kronenberg, N. M. et al., Chem. Commun., 2008, 6489-6491), les donneurs-accepteurs oxoindanes (Bürckstümmer, H. et al., Angew. Chem. Int. Ed., 2011, 4506, 11628-11632), et les thiadiazolo-bithiophènes (Sun, Y. et al., Nature Mater,. 2011, 11, 44-48).

Les cellules photovoltaïques mettant en oeuvre ces composés ne donnent cependant pas entièrement satisfaction dans la mesure où leurs performances en termes de conversion de l'énergie lumineuse en énergie électrique sont moindres que celle des cellules à base de silicium.

Il existe donc un besoin pour des composés ayant un prix de revient inférieur à celui du silicium et pouvant notamment être utilisés efficacement à titre de donneur d'électrons pour la préparation d'une couche active dans une cellule de conversion photovoltaïque ou pour l'élaboration de transistors à effet de champ.

Ce but est atteint avec les composés de formule (I) qui vont être décrits ci-après. En effet, les inventeurs ont maintenant découvert que certains dérivés de type thiényldipyrrométhène borés (thio-BODIPY) dont la formule va être définie ci-après, présentent d'excellentes propriétés de donneur d'électrons, ce qui leur permet d'être avantageusement utilisés, en combinaison avec un accepteur d'électorns, pour la préparation d'une couche active (hétérojonction volumique) dans une cellule photovoltaïque ou pour l'élaboration de transistors à effets de champ.

Un composé selon la présente invention est un dérivé de boredipyrrométhène (BODIPY) qui répond à la formule (I) suivante :

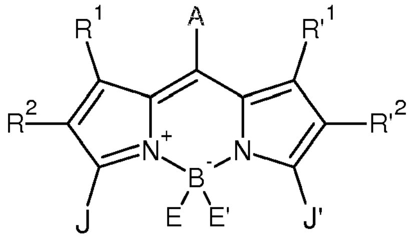

(I)

dans laquelle :

- A représente un atome d'hydrogène ; une chaîne alkyle $C_1$-$C_6$ et de préférence un groupe méthyle ; un cycle phényle ; un cycle phényle substitué par un ou plusieurs groupes W choisis parmi un atome d'halogène, de préférence l'iode ou le brome, une chaîne carbonée en $C_2$-$C_{20}$, linéaire ou ramifiée pouvant contenir un ou plusieurs hétéroatomes choisis parmi S, O et N, un groupe formyle, carboxyle, thiophène, bis-thiophène ou ter-thiophène, un cycle phényle, un cycle phényle substitué par une chaîne carbonée en $C_2$-$C_{20}$, linéaire ou ramifiée, pouvant contenir un ou plusieurs hétéroatomes choisis parmi S, O, Si et N, le ou lesdits groupes W étant en position 3, 4 et/ou 5 dudit cycle phényle ; un cycle aromatique contenant un hétéroatome choisi parmi S, O, N et Si, ledit cycle aromatique étant éventuellement substitué par un atome d'halogène (de préférence I ou Br) ou une chaîne carbonée en $C_2$-$C_{20}$, linéaire ou ramifiée pouvant contenir un ou plusieurs hétéroatomes choisis parmi S, O et N ;

- $R^1$, $R^2$, $R'^1$, $R'^2$, identiques ou différents, représentent un atome d'hydrogène, un atome d'halogène (de préférence I ou Br), un radical alkyle en $C_1$-$C_6$ (de préférence méthyle ou éthyle) ; les substituants $R^1$ et $R^2$ ensemble, et $R'^1$ et $R'^2$ ensemble peuvent également former un cycle carboné saturé ou insaturé à 5 ou 6 atomes, ledit cycle contenant éventuellement un hétéroatome choisi parmi S, Si, O, N et P ;

- E et E', identiques ou différents, représentent un atome de fluor ou un groupe de formule (II) suivante : -C=C-L, dans laquelle L est choisi parmi une liaison simple ; un alkénylène en $C_1$-$C_{10}$ et une chaîne carbonée saturée, linéaire ou ramifiée, en $C_1$-$C_{20}$ interrompue par 1 à 10 atomes d'oxygène et dans lequel cas L est terminé par un groupement choisi parmi un radical alkyle en $C_1$-$C_4$ (de préférence méthyle), un groupement phosphate ou un groupement silylé ; L peut également représenter un motif polyaromatique substitué ou comportant des hétéroatomes S, O ou N tel qu'un groupement thiophène, polythiophène, pyrène, pérylène, arylène, triazatruxène ou truxène ;

- J représente un groupement de formule (III) suivante :

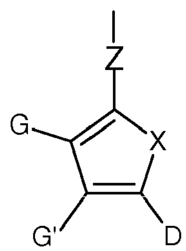

(III)

dans laquelle :

- Z est un lien assurant la liaison avec le groupement boredipyrrométhène de formule (I) et est choisi parmi une fonction vinyle, une fonction acétylène et une liaison C-C directement liée avec le groupement boredipyrrométhène de formule (I) ;

- X est choisi parmi les hétéroatomes, N, O, Si et S, S étant préféré ;

- D représente un groupement choisi parmi les groupements arylène, hétéroarylène, benzothiadiazole, et les chaînes carbonées en $C_2$-$C_{20}$, linéaires ou ramifiées ;

- G et G', identiques ou différents, représentent un atome d'hydrogène, une chaîne carbonée en $C_2$-$C_{20}$, linéaire ou ramifiée pouvant contenir un ou plusieurs hétéroatomes choisis parmi S, O, Si et N, étant entendu que G et G' deux à deux, ainsi que G' et D deux à deux, peuvent également former ensemble, et avec les atomes de

carbone du cycle auquel ils sont liés, un cycle fusionné choisi parmi les thiènothiophènes et les thiènopyrroles;

- J’ représente un groupement méthyle ou un groupement identique au groupement J de formule (III) tel que défini ci-dessus.

Les composés de formule (I) ci-dessus présentent les avantages suivants :

- une très forte absorption dans le visible entre 450 et 950 nm ;
- des niveaux énergétiques positionnés adéquatement pour assurer un transfert d’électrons efficace du donneur vers l’accepteur d’électrons de façon à élaborer une couche active d’une cellule photovoltaïque ;
- une orbitale HOMO relativement profonde de basse énergie de telle manière à obtenir des tensions élevées à circuit ouvert ;
- une structure moléculaire relativement plane permettant de favoriser l’organisation dans les couches minces de façon à faciliter le transport des charges et d’obtenir de fortes mobilités de ces charges pour obtenir des densités de courant élevées ;
- des fonctions assurant leur bonne solubilité et filmabilité sur des substrats plans ;
- des stabilités chimiques, électriques et photochimiques élevées ; et enfin
- une facilité de synthèse permettant de préparer de grandes quantités de composés de formule (I).

En effet, les composés de formule (I) conformes à l’invention possèdent des motifs thiophène, oligothiophène, furanne, oligofuranne ou benzothiadiazole directement impliqués dans le système de délocalisation en position 3,5, ce qui permet de faire varier à souhait les propriétés d’absorption et le gap optique de 1,70 (composé de formule B11 défini ci-après) et 1,40 (composé de formule B19 défini ci-après). Cette situation est favorable pour l’élaboration de cellules photovoltaïques tandem.

De plus la présence de motifs thiophène, oligothiophène, furanne, oligofuranne ou benzothiadiazole substituésq par des chaines flexibles favorise la solubilité et la filmabilité des composés de formule (I).

Selon une forme de réalisation préférée de l’invention, A est choisi parmi un atome d’hydrogène, un groupement phényle non substitué, un groupement phényle substitué, un groupement thiophène ou un groupement thiophène substitué. Selon une forme de réalisation plus particulièrement préférée, A est choisi parmi les groupements méthylphényle, iodophényle, et iodothiophène.

Également selon une forme de réalisation préférée, $R^1$ et $R'^1$ sont identiques et représentent un radical méthyle et $R^2$ et $R'^2$ sont identiques et représentent un atome d’hydrogène.

Encore selon une forme de réalisation préférée de l’invention, D est préférentiellement un groupe thiophène, furane, pyridine, naphtalène, anthracène, pyrène, pérylène, ou un benzothiadiazole substitué par un ou plusieurs groupements thiophène ou furane portant une ou plusieurs chaînes linéaires ou ramifiées comportant de 2 à 20 atomes de carbone pouvant contenir un ou plusieurs hétéroatomes choisis parmi S, O, Si et N.

Parmi les composés de formule (I) ci-dessus, on peut notamment mentionner les composés B2, B3, B4, B5, B6, B7, B8, B9, B10, B11, B12, B13, B15, B16, B17, B19, B20, B21, B22, B24, B25, B26, B27, B28, B29, B30, B31, B32, B33, B34, B35, B36 et B39 de formules suivantes :

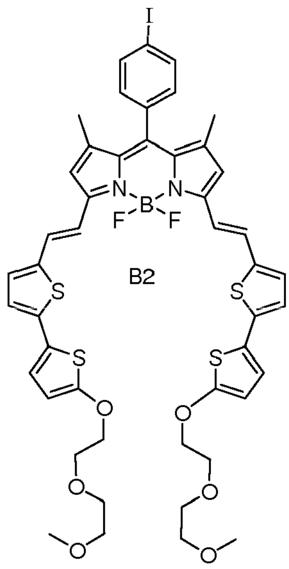

B2

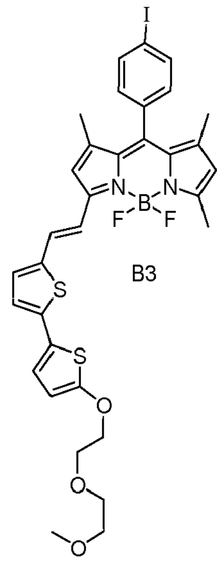

B3

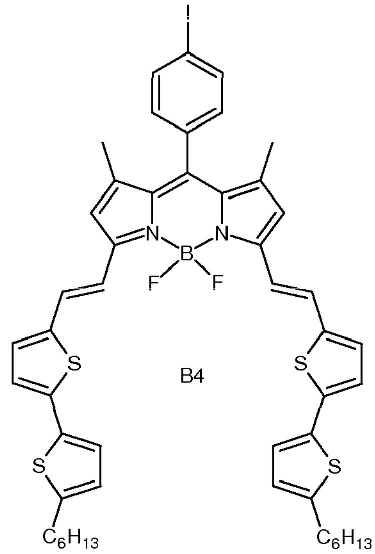

B4

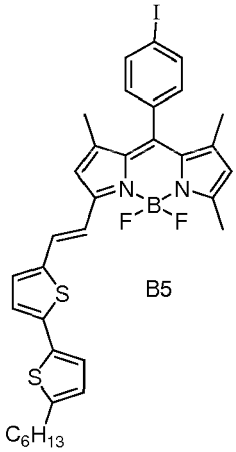

B5

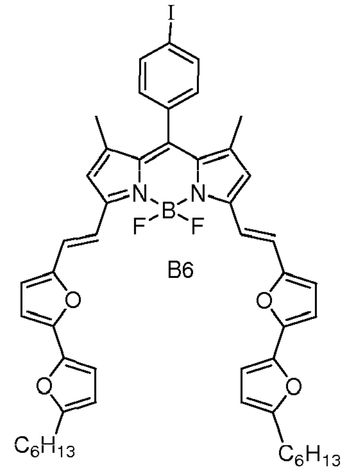

B6

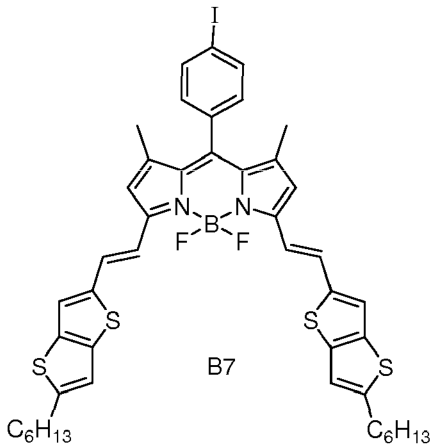

B7

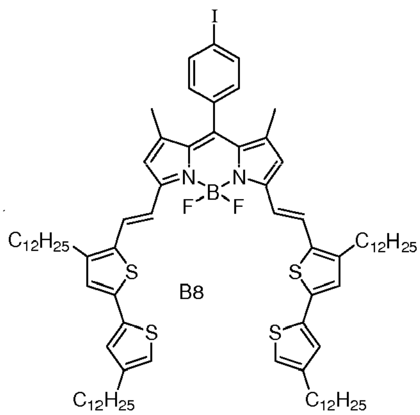

B8

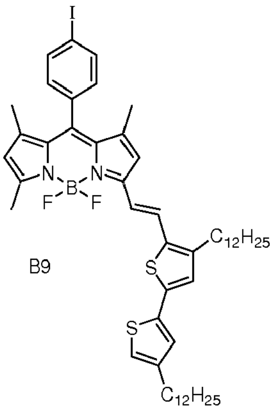

B9

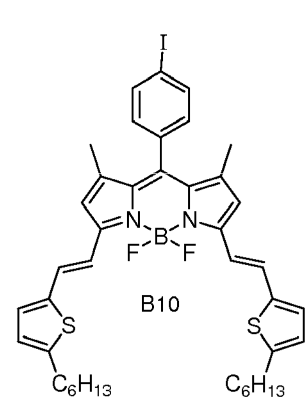

B10

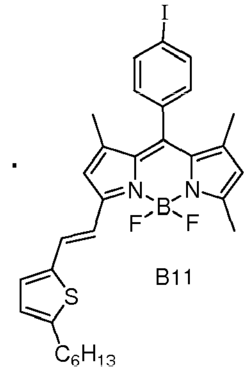

B11

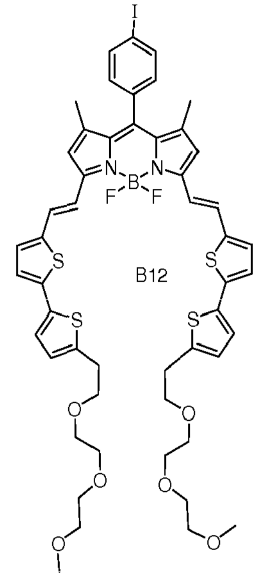

B12

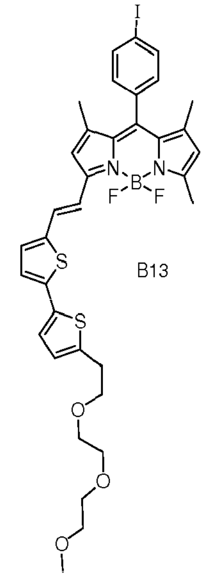

B13

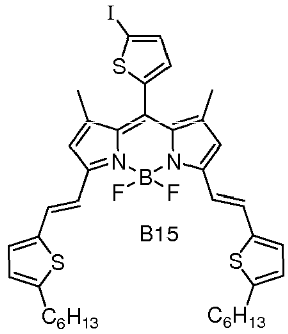

B15

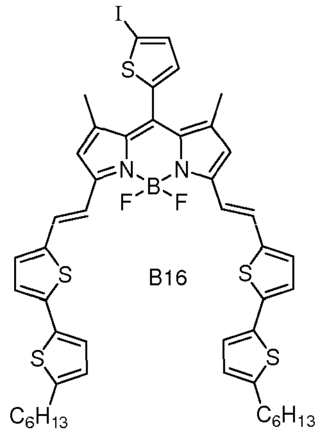

B16

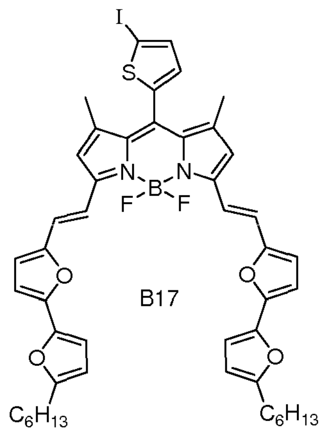

B17

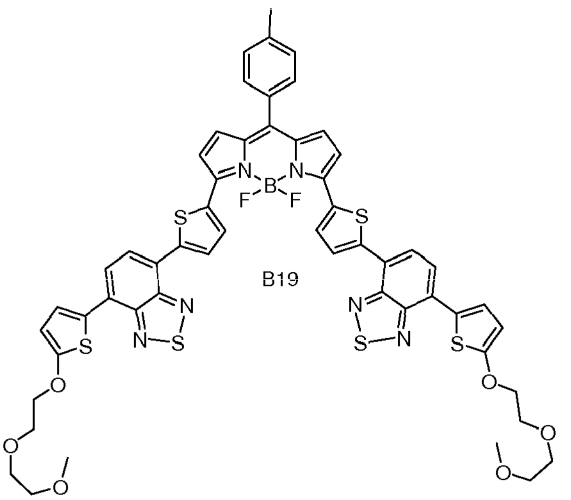

B19

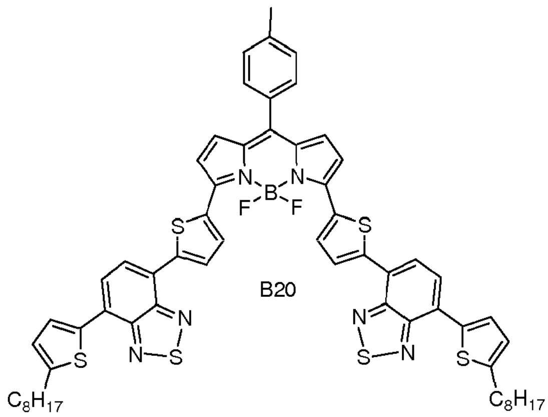

B20

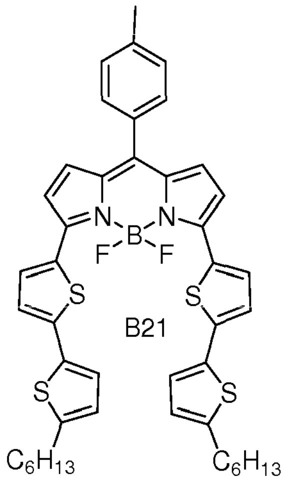

B21

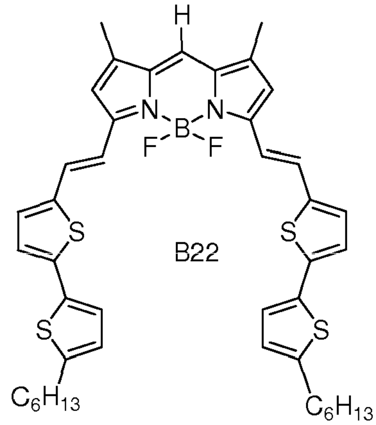

B22

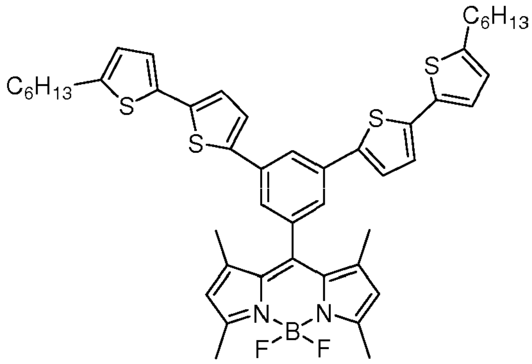

B24

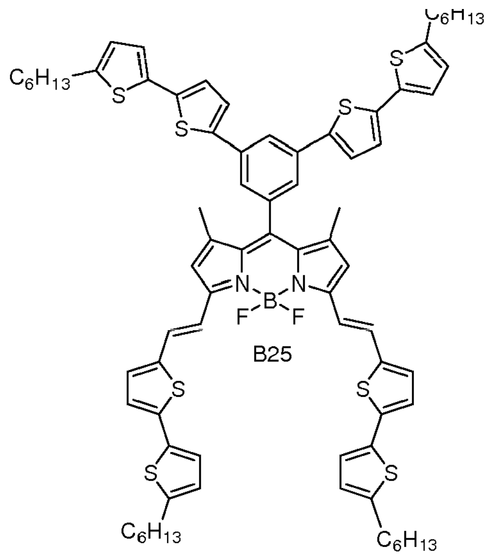

B25

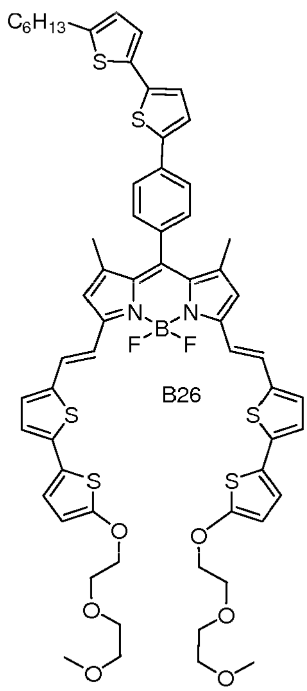

B26

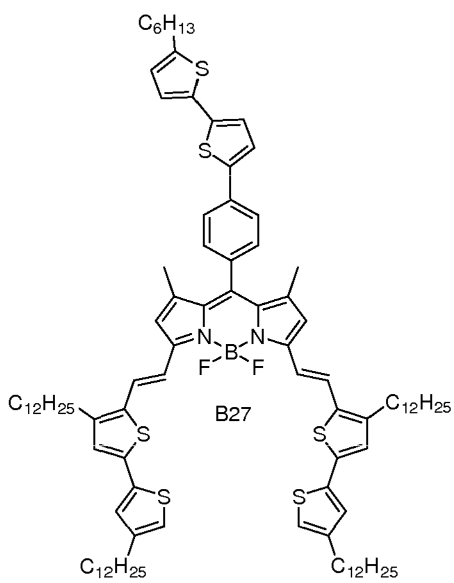

B27

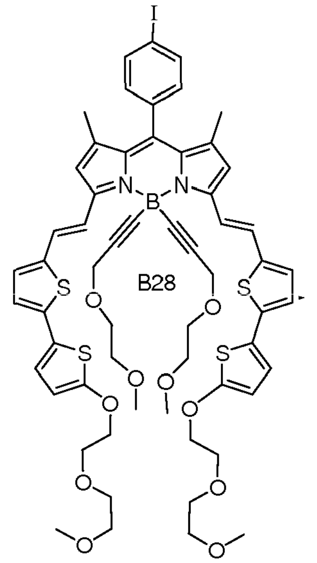

B28

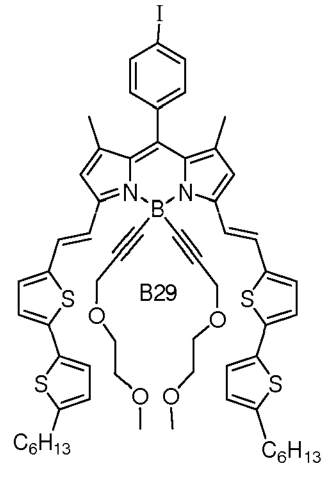

B29

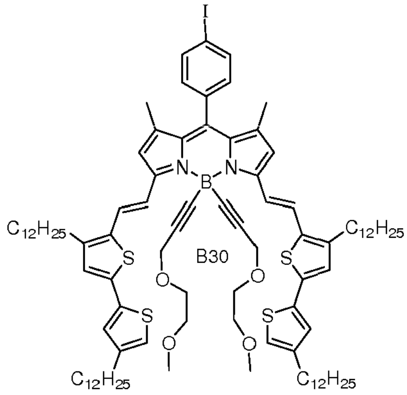

B30

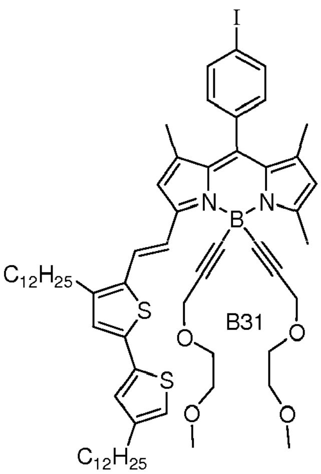

B31

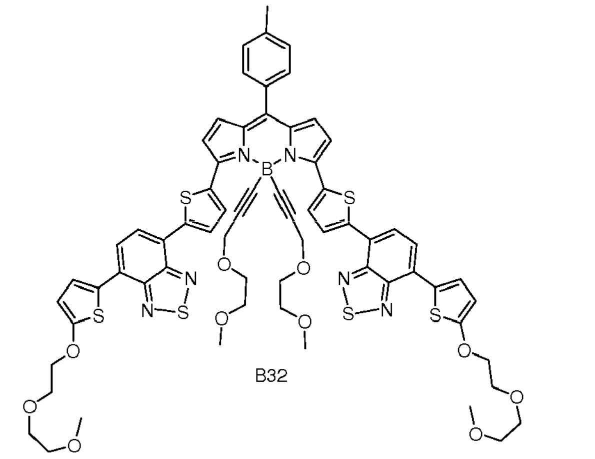

B32

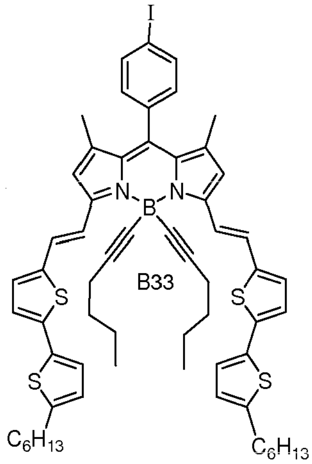

B33

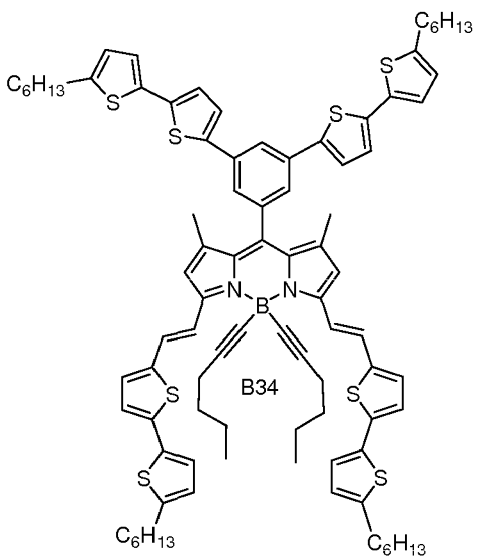

B34

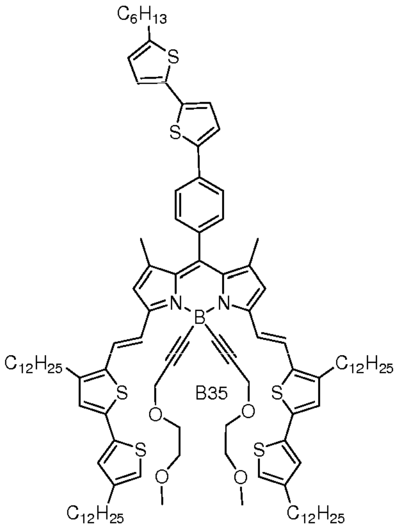

B35

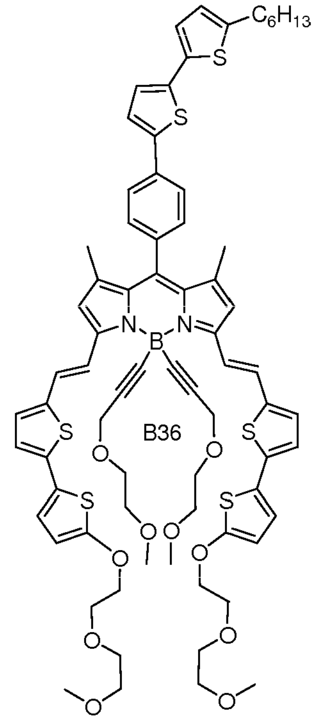

B36

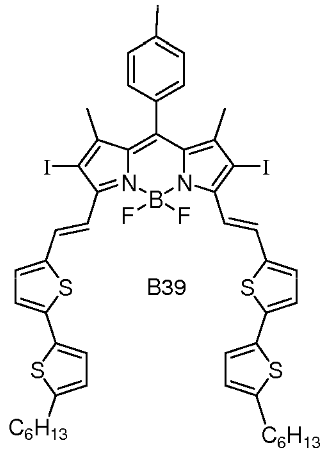

B39

Il est à noter que dans les composés ci-dessus, les charges positive et négative respectivement présentes sur l'atome d'azote et l'atome de bore du groupement boredipyrrométhène n'ont pas été représentées dans un souci de simplicité.

Parmi ces composés, on préfère tout particulièrement les composés B2, B4, B19, B28 et B32. Dans le cas particulier du composé B4, la présence de thiophène dans le système de délocalisation favorise la mobilité des charges et un caractères ambipolaire. Cette mobilité est importante pour l'extraction des charges.

Un composé de formule (I) selon la présente invention peut être préparé selon le schéma réactionnel suivant :

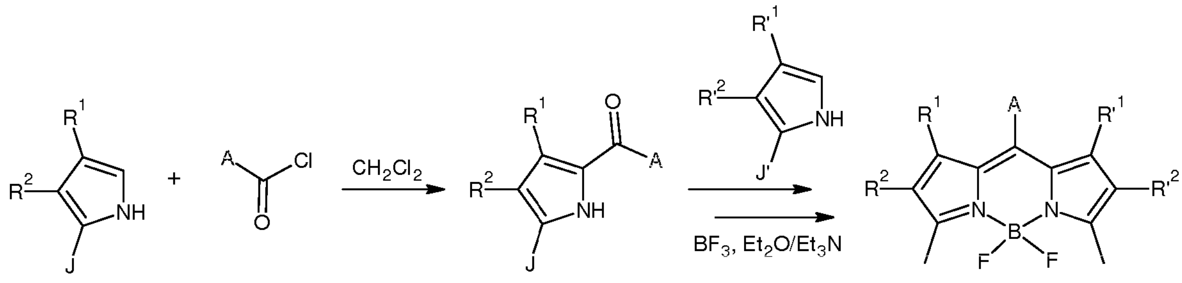


(I")

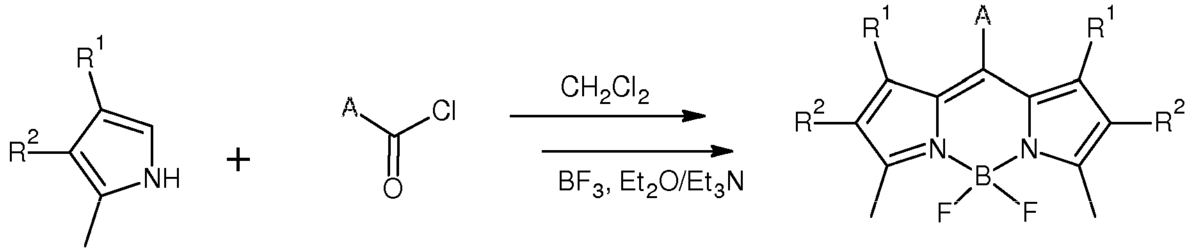


(I')

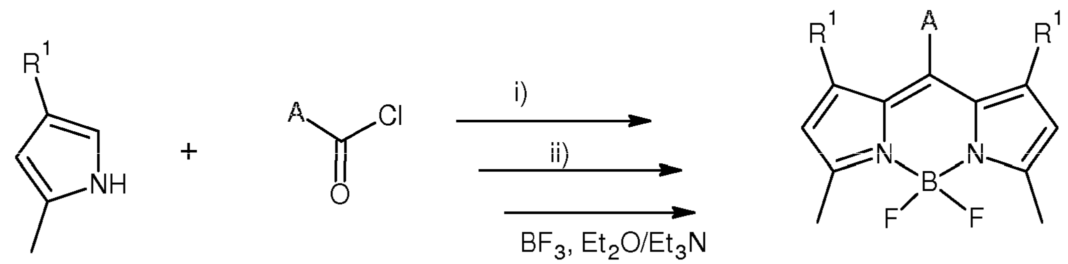


(I''')

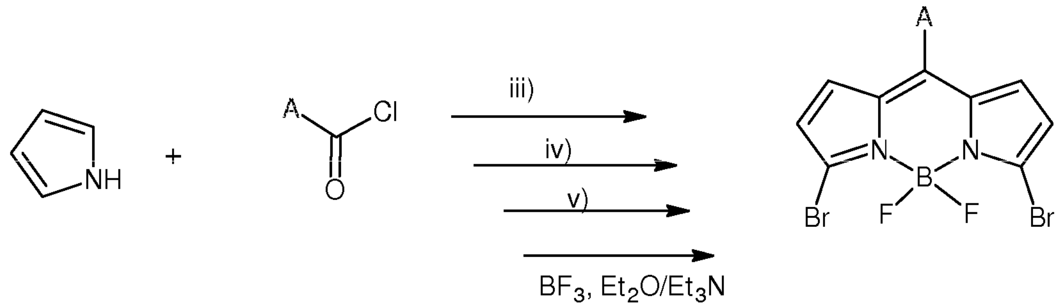


(I'''')

i) $CH_2Cl_2$ ; ii) DDQ ou Chloranil ; iii) pyrrole comme solvant ; iv) NBS/THF ; v) DDQ selon lequel on condense un dérivé de pyrrole avec un dérivé de chlorure d'acide ou d'aldéhyde porteur d'un groupement A tel que défini ci-dessus pour les composés de formule (I) dans des conditions anhydres pour obtenir un composé de formule (I'), (I'), (I''') ou (I'''') suivant les cas, formules dans lesquelles A, $R^1$, $R'^1$, $R^2$, $R'^2$, J et J' ont les mêmes significations que celles indiquées ci-dessus pour les composés de formule (I). Dans le cas des chlorures d'acide, les dérivés du dipyrrométhène peuvent être complexés en milieu basique avec du $BF_3$ éthérate. Avec les dérivés des aldéhydes le dipyrrométhane intermédiaire est oxydé en dipyrrométhène et complexé en milieu basique avec du $BF_3$ éthérate. Pour les composés dissymétriques la condensation se fait en deux étapes à partir des chlorures d'acides correspondants.

Les composés de formule (I) conformes à l'invention sont des donneurs d'électrons par rapport aux composés classiquement utilisés à titre d'accepteurs d'électrons dans les cellules de conversion photovoltaïques tels que par exemple les dérivés de fullerène. Cette propriété permet de les utiliser pour la préparation d'une hétérojonction d'une cellule de conversion photovoltaïque. Certains composés de formule (I) tels que le composé de formule **B4** constituent également de bons semi-conducteurs, ce qui permet par ailleurs de les utiliser pour l'élaboration de transistors à effet de champ ambipolaires.

L'invention a donc également pour objet l'utilisation d'au moins un composé de formule (I) tel que défini ci-dessus, à titre de donneurs d'électrons, pour la préparation d'une hétérojonction volumique dans une cellule photovoltaïque.

Un autre objet de l'invention est l'utilisation d'au moins un composé de formule **B4** tel que défini ci-dessus, comme matériau semi-conducteur pour l'élaboration d'un transistor à effet de champ ambipolaire, c'est-à-dire pouvant conduire à la fois les électrons et les trous.

L'invention a également pour objet une cellule photovoltaïque comprenant au moins un support, une anode (électrode positive), une couche active (hétérojonction) comprenant au moins un donneur d'électrons et au moins un accepteur d'électrons, et une cathode (électrode négative), ladite cellule étant caractérisée en ce que le donneur d'électrons est choisi parmi les composés de formule (I) tels que définis ci-dessus.

L'accepteur d'électrons est de préférence choisi parmi les dérivés de fullerène (C60, C70) tels que le [6,6]-phényl-$C_{61}$-butyrate de méthyle ($PC_{61}BM$), les nanotubes de carbone, les dérivés du pérylène et les dérivés du tetracyanoquinodiméthane (TCNQ).

Selon une forme de réalisation préférée, le rapport massique composé de formule (I) /accepteur d'électrons varie de 10/1 à 1/3.

Selon l'invention, le substrat est de préférence un substrat transparent en un matériau qui peut être souple ou rigide, par exemple du verre, et sur lequel se trouve déposée une électrode positive, constituée d'oxyde de métaux par exemple d'oxyde d'indium-étain (ITO selon la dénomination anglophone « *Indium Tin Oxide »).*

L'électrode négative est de préférence une électrode d'aluminium ou une électrode bicouche de calcium/aluminium.

Une couche tampon peut être intercalée entre la couche active et l'électrode positive afin d'améliorer l'interface entre ces deux couches. Une telle couche tampon peut notamment être constituée d'une couche d'un mélange de deux polymères : le poly(3,4-éthylènedioxythiophène) (PEDOT) et le poly(styrène sulfonate) de sodium (PSS) : couche PEDOT :PSS.

Une autre couche tampon peut également être intercalée entre la couche active et l'électrode négative afin d'améliorer, là également, l'interface entre ces deux couches. Une telle couche tampon peut notamment être constituée d'une couche de fluorure de lithium (LiF).

L'électrode positive (cathode) peut également être un oxyde métallique de type $MoO_3$, $MoO_x$, $WO_x$, ZnO ........ ou autre, utilisable pour extraire les charges positives du dispositif.

La cellule photovoltaïque conforme à l'invention peut être préparée selon les techniques connues de l'homme du métier, et notamment selon un procédé consistant à déposer, sur une électrode positive préalablement recouverte d'une couche tampon, une solution d'au moins un composé de formule (I) et d'au moins un accepteur d'électrons dans un solvant approprié tel que par exemple le chloroforme ou le chlorobenzène. Le dépôt de la couche active peut être fait par toute technique appropriée, et de préférence par enduction centrifuge (« spin-coating »).

Le dépôt d'une seconde couche tampon sur la couche active puis de l'électrode négative, peut également être fait par toute technique appropriée et connue de l'homme du métier, et en particulier par dépôt en phase gazeuse.

L'invention a également pour objet un transistor à effet de champ ambipolaire réalisé à partir d'un composé de formule **B4.** Ledit transistor à effet de champ comprend une source, un drain, une grille où est appliquée une tension de commande, ainsi qu'un canal constitué d'un semiconducteur organique ledit canal étant en contact avec l'isolant ou l'oxyde de grille. Il est caractérisé en ce que le semiconducteur organique est un composé de formule **B4** tel que défini ci-dessus.

Plusieurs configurations de transistors à effet de champ sont possibles. Soit les trois contacts sont présents sous le canal constitué d'un composé de la formule (I) (configuration « *bottom contact* »/ « *bottom gate* »). Soit le drain et la source sont en-dessous du canal et la grille est au-dessus (configuration « *bottom contact* »/ « *top gate* »). Soit le drain et la source sont au-dessus du canal et la grille est en-dessous (configuration « *top contact* »/ « *bottom gate* »). A titre d'exemple particulier de réalisation, et selon le premier type de configuration (« *bottom contact* »/ « *bottom gate* »), la grille est constituée d'un substrat de semi-conducteur fortement dopé (ici un substrat de silicium de type n avec $n=3x10^{17}$ /$cm^3$) sur lequel est déposé un oxyde de grille (tel que par exemple l'oxyde de silicium $SiO_2$) d'épaisseur typique voisine de 100 $\mu$m (230 $\mu$m ici). Le drain et la source sont des contacts pré-lithographiés pouvant par exemple être constitués d'une bicouche oxyde d'indium-étain (ITO) (10 nm)/Au (30 nm). La surface d'oxyde de silicium qui servira d'oxyde de grille entre les contacts source et drain inter-digités doit être passivée afin d'éviter la présence de trop nombreux pièges à électrons à sa surface. La passivation peut s'effectuer de différentes manières bien connues de l'homme du métier comme par exemple en déposant une monocouche d'héxaméthyldisilazane (HMDS) à la tournette. Le transistor est terminé en déposant le canal, un des composés de formule (1) dilué dans un solvant tel que le chloroforme ou le chlorobenzène à la tournette. Le transistor à effet de champ est caractérisé par son réseau de caractéristiques de sortie, c'est-à-dire la mesure de l'intensité entre le drain et la source (Ids) en fonction de la différence de potentiel entre le drain et la source (Vds) pour différentes tension de grille (Vg) ainsi que par ses caractéristiques de transfert (Ids en fonction de Vg à Vds fixé). Les caractéristiques de sortie obtenues à partir du composé **B4**, ont montré de manière claire pour l'homme du métier un transport ambipolaire, c'est-à-dire une capacité à transporter à la fois les trous et les électrons. Dans ce composé **B4**, les mobilités des deux types de porteurs (extraites à partir des caractéristiques de transfert en

utilisant le formalisme usuel) sont élevées (supérieures à $10^{-3}$ $cm^2/Vs$) et similaires.

La présente invention est illustrée par les exemples suivants, auxquels elle n'est cependant pas limitée.

## EXEMPLES

Dans les exemples qui suivent, les composés listés ci-après ont été synthétisés selon leur protocole respectif donné dans la littérature :

- Composés **B1** et **B40 :** A. Birghart et al., J. Org. Chem., 1999, 64,7813 ;
- Composés **5** et **8** : K. H. Kim et al., Chem. Mater., 2007, 19, 4925-4932 ;
- Composé **6** : O Gidron et al., Chem. Commun., 2011, 47, 1976-1978 ;
- Composé **10** : N. Leclerc et al., Chem. Mater., 2005, 17(3), 502-513 ;
- Composé **11** : T. Rousseau et al., Chem Commun., 2009, 1673-1675 ;
- Composé **15** : S. U. Ku et al., Macromolecules, 2011, 44, 9533-9538 ;
- Composé **22** : D. W. Chang et al., Journal of Polymer Science, Part A : Polymer Chemistry, 2012, 50, 271-279 ;
- Composé **30**: Demande internationale WO 2010076516 ;
- Composé **B18** : M. R. Rao et al., Journal of Organometallic Chemistry, 2010, 695, 863-869 ;
- Composé **B23** : M. Benstead et al., New Journal of Chemistry, 2011, (35)7, 1410-1417.
- Composé **B37** : A Cui et al., Journal of Photochemistry and Photobiology A : Chemistry, 2007, 186, 85-92.

Dans les exemples qui suivent, les procédures générales suivantes ont été utilisées :

Procédure générale n°1 pour la condensation de type Knoevenagel :

Dans un ballon monocol de 100 ml, on dissout le dérivé du boredipyrrométhène (dont la structure moléculaire est représentée par les formules (I' ou I''') et correspondant au composé de formule (I) que l'on souhaite obtenir, (1 équivalent) et le dérivé aldéhyde (1 à 2,3 équivalents) dans un mélange toluène/pipéridine (10/1, v/v), puis on ajoute une quantité catalytique d'acide para-toluènesulfonique (*p*-TsOH). Le mélange sous agitation est porté à ébullition (température du bain d'huile : 140°C) jusqu'à ce que tout le solvant soit évaporé. L'état d'avancement de la réaction est suivi par chromatographie sur couche mince (CCM). Le brut réactionnel est ensuite dissous dans du dichlorométhane. La phase organique est ensuite lavée avec de l'eau (3x20 ml) puis avec une solution saturée de NaCl (1x20 ml), séchée sur $Na_2SO_4$, $MgSO_4$ ou filtrée sur du coton hydrophile. Après évaporation, le résidu organique est purifié par chromatographie sur colonne de gel de silice avec les solvants adéquats.

Procédure générale n°2 pour la substitution des atomes de fluor par des dérivés acétyléniques (cas où E et/ou E' est un groupement de formule (II)):

À une solution d'un dérivé acétylénique du groupement de formule E/E' (3 à 4 équivalents) dans du THF anhydre, à température ambiante, est ajouté sous argon du bromure d'éthylmagnésium (1,0 M dans le THF, 2,5 à 3,5 équivalents). Le mélange est agité pendant 2 heures à 60°C, puis refroidi à température ambiante. La solution ainsi obtenue est transférée par une canule dans une solution d'un dérivé de boredipyrrométhène de formules (I') ou (I''') ou (I'''') correspondant au composé de formule (I) que l'on souhaite obtenir (1 équivalant dans du THF anhydre. La solution est agitée pendant une nuit à 60°C, puis de l'eau est ajoutée. Cette solution est extraite avec du dichlorométhane. La phase organique est ensuite lavée avec de l'eau (3x20 ml) puis avec une solution saturée de NaCl (1x20 ml). Après évaporation, le résidu organique est purifié par chromatographie sur colonne de gel de silice avec les solvants adéquats.

Procédure générale n°3 pour le couplage de type Suzuki :

À une solution du dérivé de boredipyrrométhène de formule (I') ou (I'''') dans du toluène, est ajoutée une solution à 2 mol/l de $K_2CO_3$ (2 à 4 équivalents) et un dérivé boronate (1 à 3 équivalents) à température ambiante. Le mélange est dégazé sous argon pendant 45 minutes. Après dégazage le catalyseur, tetrakis(triphénylphosphine)palladium ($[Pd(PPh_3)_4]$ 10 % molaire) est ajouté sous argon. Le mélange est agité pendant 12 à 18 heures à 110°C. En fin de réaction, du dichlorométhane est ajouté puis la solution est lavée avec de l'eau (3x20 ml) puis avec une solution saturée de NaCl (1x20 ml), et enfin séchée sur $Na_2SO_4$, $MgSO_4$ ou filtrée sur du coton hydrophile. Après évaporation, le résidu organique est purifié par chromatographie sur colonne de gel de silice avec les solvants adéquats.

Procedure générale n°4 pour la préparation des aldéhydes (formylation de type Vilsmeier):

À une solution de DMF anhydre à 0°C est ajouté 1,5 équivalents de $POCl_3$. Le mélange est laissé sous agitation pendant 1 heure à température ambiante. Le milieu réactionnel est ensuite porté à 0°C et le dérivé aromatique est ajouté sous argon. Le mélange est ensuite chauffé pendant 12 à 18 heures à 60°C. En fin de réaction, de l'éther (ou de l'acétate d'éthyle) est ajouté et la solution est lavée avec de l'eau (3x20 ml) puis avec une solution saturée de NaCl (1x20 ml), et enfin séchée sur $Na_2SO_4$. Après évaporation, le résidu organique est purifié par chromatographie sur colonne de gel de silice avec les solvants adéquats.

**EXEMPLE 1** : **Synthèse des composés B2 et B3**

Les composés B2 et B3 ont été synthétisés selon le schéma de synthèse suivant :

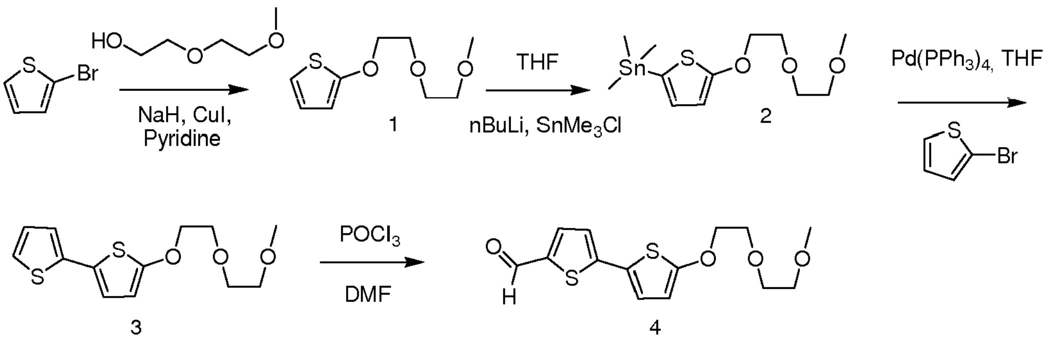


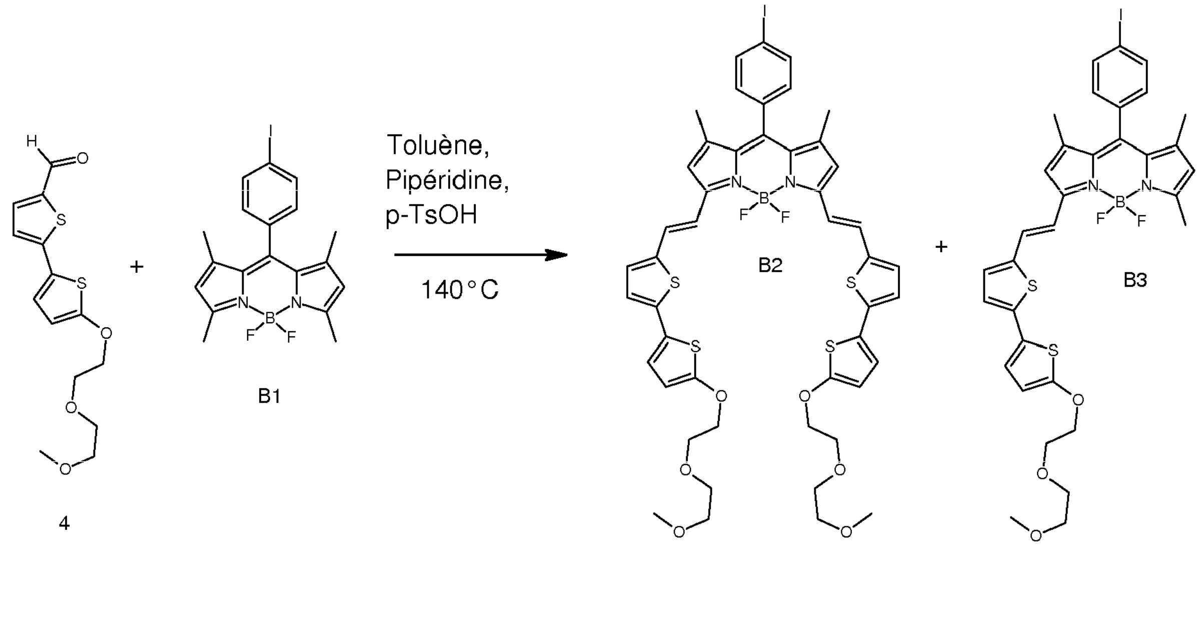

1) Première étape : Synthèse du 2-(2-(2-méthoxyéthoxy)-éthoxy)thiophène (Composé 1)

12,2 mmoles d'iodure de cuivre (CuI) et 92 mmoles d'hydroxyde de sodium (NaOH) ont été ajoutés à une solution de 0,3 mole de 2-(2-méthoxyéthoxy)éthanol dans 20 mL de pyridine sèche, sous agitation à température ambiante pendant 30 min. 61 mmoles de 2-bromothiophène ont ensuite été additionnés et la solution a été chauffée à 100°C pendant 7 jours. Le mélange a ensuite été refroidi à température ambiante et versé dans un mélange d'eau et de dichlorométhane. Ensuite, la solution organique a été extraite 3 fois avec une solution de HCl à 10% pour enlever la pyridine puis avec de l'eau. La phase organique a ensuite été séchée sur $Na_2SO_4$ et le dichlorométhane évaporé sous vide. Le produit brut a été purifié sur colonne chromatographique avec pour éluent un mélange cyclohexane / acétate d'éthyle (80/20) pour obtenir le composé **1** sous la forme d'une huile incolore (Rendement = 34%).
RMN $^1H$ ($CDCl_3$, 300 MHz) : 3,39 (s, 3H) ; 3,58 (dd ; $^3J$ = 5,0 Hz, $^3J$ = 6,4 Hz, 2H) ; 3,71 (dd, $^3J$ = 5,0 Hz, $^3J$ =6,4 Hz, 2H) ; 3,84 (t, $^3J$ = 4,7 Hz, 2H) ; 4,2 (t, $^3J$ = 4,7 Hz, 2H) ; 6,24 (dd, $^3J$ = 5,8 Hz, $^4J$ = 1,3 Hz, 1H) ; 6,55 (dd, $^3J$ = 3,7 Hz, $^4J$ = 1,3 Hz, 1H) ; 6,70 (q, $^3J$ = 5,8 Hz, $^3J$ = 3,7 Hz, 1H).
RMN $^{13}C$ ($CDCl_3$, 50 MHz) : 59,1 ; 69,4 ; 70,8 ; 71,9 ; 73,1 ; 105,2 ; 112,2 ; 124,6 ; 165,3.
SM-ESI : 202,1 ([M], 100).
Analyse élémentaire pour $C_9H_{14}O_3S$ :

| | C | H |
|---|---|---|
| **Calculé** | **53,44** | **6,98** |
| **Trouvé** | **53,25** | **6,84** |

2) Deuxième étape : Synthèse du 2-triméthylétain-5-(2-(2-méthoxyéthoxy)-éthoxy)thiophène (Composé **2**):

A une solution de 13,8 mmol du composé **1** obtenu ci-dessus à l'étape précédente dans 40 mL de THF sec à -78°C, on a ajouté lentement une solution de 2,5M de n-butyl-lithium (nBuLi) dans l'hexane (15,2 mmol). La solution a été agitée pendant 1 heure à -78°C et une solution de chlorure de triméthylétain (1,0 M dans le THF, 18 mmol) a alors été ajoutée. La solution a été réchauffée jusqu'à température ambiante et agitée pendant 12 heures. Ensuite, la solution a été versée dans de l'eau et le produit extrait à l'acétate d'éthyle. La phase organique a été lavée 3 fois à l'eau, puis séchée sur $Na_2SO_4$. L'acétate d'éthyle a été évaporé sous vide. Le produit brut (Composé **2**) a été utilisé dans l'étape suivante sans autre purification.
RMN $^1H$ ($CDCl_3$, 300 MHz) : 0,32 (s, 9H) ; 3,39 (s, 3H) ; 3,58 (dd, $^3J$ = 4,9 Hz, $^3J$ = 6,4 Hz, 2H) ; 3,71 (dd, $^3J$ = 4,9 Hz, $^3J$ = 6,4 Hz, 2H) ; 3,84 (t, $^3J$ = 5,0 Hz, 2H) ; 4,21 (t, $^3J$ = 4,7 Hz, 2H) ; 6,37 (d, $^3J$ = 3,5 Hz, 1H) ; 6,79 (d, $^3J$ = 3,5 Hz, 1H).
RMN $^{13}C$ ($CDCl_3$, 50 MHz) : -8,3 ; 59,1 ; 69,5 ; 70,8 ; 72,0 ; 73,2 ; 107,1 ; 123,0 ; 133,2 ; 170,7.

3) Troisième étape : Synthèse du 5-(2-(2-Méthoxyéthoxy)-éthoxy)-2,2'-bithiophène (Composé **3**)

6,7 mmol du composé **2** obtenu ci-dessus à l'étape précédente et 6,1 mmol de 2-bromothiophène ont été dissous dans 25 mL de THF sec et la solution a été dégazée avec de l'argon. On a ensuite ajouté du tetrakis(triphénylphosphine)palladium [$Pd(PPh_3)_4$] en quantité catalytique et le mélange a été chauffé à 80°C pendant 48 heures sous agitation et sous argon. La solution a ensuite été refroidie à température ambiante et filtrée sur célite. La phase organique a été lavée 3 fois à l'eau, puis séchée sur $Na_2SO_4$. L'acétate d'éthyle a été évaporé sous vide. Le produit brut a été purifié sur colonne chromatographique avec pour éluent un mélange cyclohexane / acétate d'éthyle (80/20) pour obtenir le composé **3** attendu sous la forme d'une huile jaune pâle (rendement = 65%).
RMN $^1H$ (Acétone d6, 300 MHz) : 3,31 (s, 3H) ; 3,52 (dd, $^3J$ = 5,5 Hz, $^3J$ = 6,7 Hz, 2H) ; 3,64 (dd, $^3J$ = 5,5 Hz, $^3J$ = 6,7 Hz, 2H) ; 3,81 (m, 2H) ; 4,24 (m, 2H) ; 6,28 (d, $^3J$ = 3,9 Hz, 1H) ; 6,89 (d, $^3J$ = 3,9 Hz, 1H) ; 7,03 (q, $^3J$ = 5,1 Hz, $^3J$ = 5,1 Hz, 1H) ; 7,09 (dd, $^3J$ = 3,5 Hz, $^4J$ = 1,1 Hz, 1H) ; 7,31 (dd, $^3J$ = 5,1 Hz, $^4J$ = 1,1 Hz, 1H).
RMN $^{13}C$ (Acétone d6, 50 MHz) : 58,8 ; 69,9 ; 71,2 ; 72,7 ; 74,1 ; 106,6 ; 122,4 ; 123,2 ; 124,4 ; 124,5 ; 128,7 ; 138,6 ; 165,3.
SM-ESI : 248,4 ([M], 100).
Analyse élémentaire pour $C_{13}H_{16}O_3S_2$ :

| | C | H |
|---|---|---|
| **Calculé** | **54,90** | **5,67** |
| **Trouvé** | **54,68** | **5,74** |

4) Quatrième étape : Synthèse du composé **4**

Le composé **4** a été synthétisé suivant la procédure générale n°4 à partir de 600 mg (2,1 mmol, 1 équiv.) du composé **3** obtenu ci-dessus à l'étape précédente et 300 μL d'oxychlorure de phosphore ($POCl_3$) (3,15 mmol, 1,5 équiv.). Un mélange 80/20 éther de pétrole/acétate d'éthyle a été utilisé pour la purification du composé désiré. On a obtenu 480 mg (1,53 mmol, rendement : 73%) du composé **4.**
RMN $^1H$ (200 MHz, $CDCl_3$) : 3,39 (s, 3H) ; 3,55-3,60 (m, 2H) ; 3,67-3,72 (m, 2H) ; 3,83-3,87 (m, 2H) ; 4,22-4,26 (m, 2H) ; 6,21 (d, 1H, $^3J$= 4,1 Hz) ; 7,01-7,05 (m, 2H) ; 7,61 (d, 1H, $^3J$= 4,1 Hz) ; 9,80 s, 1H).
RMN $^{13}C$ ($CDCl_3$, 50 MHz) : 59,2 ; 69,4 ;71,0 ; 72,1 ; 73,3 ; 106,6 ; 122,6 ; 122,8 ; 124,6 ; 137,7 ; 140,5 ; 148,4 ; 166,9 ; 182,4.
SM-ESI: 312,1 ([M], 100).
Analyse élémentaire pour $C_{14}H_{16}O_4S_2$ :

| | C | H |
|---|---|---|
| **Calculé** | **53,82** | **5,16** |
| **Trouvé** | **53,69** | **5,04** |

5) Cinquième étape : Synthèse des composés **B2** et **B3.**

Les composés **B2** et **B3** ont été synthétisés suivant la procédure générale n°1 à partir de 360 mg (0,8 mmol, 1 équiv.) du composé **B1** et 250 mg (0,8 mmol, 1 équiv.) du composé **4** tel qu'obtenu ci-dessus à l'étape précédente dans un volume de 20 ml de toluène. Un mélange de 70/30 éther de pétrole / acétate d'éthyle (v/v) a été utilisé pour la purification des composés désirés. Il a été obtenu 78 mg du composé **B3** (0,1 mmol, rendement 13%) et 510 mg (0,49 mmol, rendement 61%) du composé **B2.**
**Composé B3 :** RMN $^1H$ (300 MHz, $CDCl_3$) : 1,43 (s, 3H) ; 1,46 (s, 3H) ; 2,6 (s, 3H) ; 3,41 (s, 3H) ; 3,58-3,61 (m, 2H) ; 3,71-3,74 (m, 2H) ; 3,85-3,88 (m, 2H) ; 4,23-4,26 (m, 2H) ; 6,01 (s, 1H) ; 6,19 (d, 1H, $^3J$ = 4,0 Hz) ; 6,56 (s, 1H) ; 6,88 (d, 1H, $^3J$ = 4,0 Hz) ; 6,92 (d, 1H, $^3J$ = 4,0 Hz) ; 7,05 (d, 1H, $^3J$ = 4,0 Hz), 7,07 (d, 2H, $^3J$ = 8,2 Hz) ;7,27 (d, 1H, $^3J$ = 16,0 Hz) ; 7,35 (d, 1H, $^3J$ = 16,0 Hz) ; 7,86 (d, 2H, $^3J$ = 8,2 Hz).
RMN $^{13}C$ (50 MHz, $CDCl_3$) : 14,8 ; 15,1 ; 59,2 ; 69,5 ; 70,9 ; 72,1 ; 73,3 ; 94,9 ; 106,4 ; 117,7 ; 118,1 ; 121,5 ; 122,4 ; 122,9 ; 124,2 ; 129,2 ; 129,9 ; 130,4 ; 134,8 ; 138,1 ; 138,4 ; 140,1 ; 140,2 ; 142,2 ; 152,8 ; 155,5 ; 165,1 ; 196,1.
SM-ESI : 744,1 ([M], 100).
Analyse élémentaire pour $C_{33}H_{32}BF_2IN_2O_3S_2$ :

| | C | H | N |
|---|---|---|---|
| **Calculé** | **53,24** | **4,33** | **3,76** |
| **Trouvé** | **53,04** | **4.17** | **3.54** |

**Composé B2** : RMN $^1H$ (300 MHz, $CDCl_3$) : 1,47 (s, 6H) ; 3,41 (s, 6H) ; 3,58-3,61 (m, 4H) ; 3,71-3,74 (m, 4H) ; 3,86-3,89 (m, 4H) ; 4,24-4,27 (m, 4H) ; 6,22 (d, 2H, $^3J$ = 4,0 Hz) ; 6,59 (s, 2H) ; 6,93 (d, 2H, $^3J$ = 2,7 Hz) ; 6,95 (d, 2H, $^3J$ = 2,7 Hz) ; 7,07-7,10 (m, 4H) ; 7,29 (superposition avec le solvant, d, 2H, $^3J$ = 16,0 Hz) ; 7,43 (d, 2H, $^3J$ = 16,0 Hz) ; 7,85 (d, 2H, $^3J$ = 8,2 Hz).
RMN $^{13}C$ (50 MHz, $CDCl_3$) : 15,1 ; 59,2 ; 69,5 ; 70,9 ; 72,1 ; 73,2 ; 94,8 ; 106,4 ; 117,9 ; 118,3 ; 122,5 ; 123,1 ; 124,2 ; 129,1 ; 129,8 ; 130,7 ; 135,0 ; 138,4 ; 140,2 ; 141,4 ; 152,2 ; 165,1.
SM-ESI : 1038,1 ([M], 100).
Analyse élémentaire pour $C_{47}H_{46}BF_2IN_2O_6S_4$ :

| | C | H | N |
|---|---|---|---|
| **Calculé** | **54,34** | **4,46** | **2,70** |
| **Trouvé** | **54,47** | **4,38** | **2,52** |

**EXEMPLE 2 : Synthèse des composés B4 et B5**

Les composés **B4** et **B5** ont été synthétisés selon le schéma de synthèse suivant :

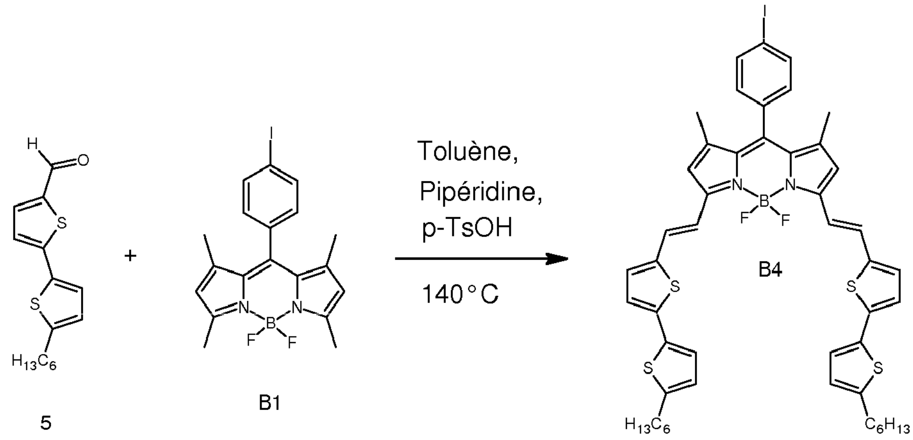


5 B1

Les composés **B4** et **B5** ont été synthétisés suivant la procédure générale n°1 à partir de 310 mg (0,69 mmol, 1 équiv.) de composé **B1**, 287 mg (1,05 mmol, 1,5 équiv.) du composé **5** dans un volume de 20 ml de toluène. Un mélange de 70/10/20 (v/v/v) éther de pétrole / $CH_2Cl_2$ / toluène a été utilisé pour la purification des composés désirés. On a obtenu 402 mg du composé **B4** (0,41 mmol, rendement : 60%) et 74 mg (0,1 mmol, rendement 15%) du composé **B5.**

Composé **B4** : RMN $^1H$ (300 MHz, $CDCl_3$) : 0,91 (t, 6H, $^3J$ = 6,6 Hz) ; 1,26-1,43 (m, 12H) ; 1,47 (s, 6H) ; 1,69 (m, 4H) ; 2,82 (t, 4H, $^3J$ = 7,4 Hz) ; 6,60 (s, 2H) ; 6,73 (d, 2H, $^3J$ = 3,3 Hz) ; 7,04-7,12 (m, 8H) ; 7,30 (superposition avec le solvant d, 2H, $^3J$ = 16,0 Hz) ; 7,45 (d, 2H, $^3J$ = 16,0 Hz) ; 7,85 (d, 2H, $^3J$ = 8,1 Hz).

RMN $^{13}C$ (50 MHz, $CDCl_3$) : 14,2 ; 15,1 ; 22,7 ; 28,9 ; 30,4 ; 31,7 ; 31,8 ; 94,8 ; 118,0 ; 118,3 ; 123,9 ; 124,4 ; 125,2 ; 129,1 ; 129,8 ; 130,8 ; 133,6 ; 134,8 ; 135,0 ; 135,8 ; 138,4 ; 140,1 ; 140,7 ; 141,5 ; 146,6 ; 152,3.

SM-ESI : 970,1 ([M], 100).

Analyse élémentaire pour $C_{49}H_{50}BF_2IN_2S_4$ :

| | C | H | N |
|---|---|---|---|
| **Calculé** | **60,62** | **5,19** | **2,89** |
| **Trouvé** | **60,52** | **4,97** | **2,70** |

**Composé B5 :** RMN $^1H$ (200 MHz, $CDCl_3$) : 0,87-0,93 (m, 3H) ; 1,26-1,34 m, 6H) ; 1,43 (s, 3H) ; 1,46 (s, 3H) ; 1,59-1,69 (m, 2H) ; 2,60 (s, 3H) ; 2,81 (t, 2H, $^3J$ = 6,9 Hz) ; 6,02 (s, 1H) ; 6,56 (s, 1H) ; 6,70 (d, 1H, $^3J$ = 3,3 Hz) ; 7,01-7,09 (m, 5H) ; 7,23-7,43 (superposition avec le solvant, m, 2H) ; 7,85 (d, 2H, $^3J$ = 8,4 Hz).

RMN $^{13}C$ (50 MHz, $CDCl_3$):14,2 ; 14,8 ; 15,1 ; 22,7 ; 28,9 ; 29,8 ; 30,4 ; 31,6 ; 31,7 ; 94,8 ; 117,8 ; 117,9 ; 118,0 ; 118,1 ; 121,5 ; 1216 ; 123,7 ; 124,3 ; 125,2 ; 129,2 ; 129,8 ; 130,4 ; 134,7 ; 134,9 ; 138,4 ; 140,0 ; 140,5 ; 142,2 ; 142,4 ; 146,6 ; 152,7 ; 152,8 ; 155,6 ; 155,7.

SM-ESI : 710,1 ([M], 100).

Analyse élémentaire pour $C_{34}H_{34}BF_2IN_2S_2$ :

| | C | H | N |
|---|---|---|---|
| **Calculé** | **57,48** | **4,82** | **3,94** |
| **Trouvé** | **57.31** | **4.62** | **3.72** |

**EXEMPLE 3 : Synthèse du composé B6**

Le composé B6 a été synthétisé selon le schéma de synthèse suivant :

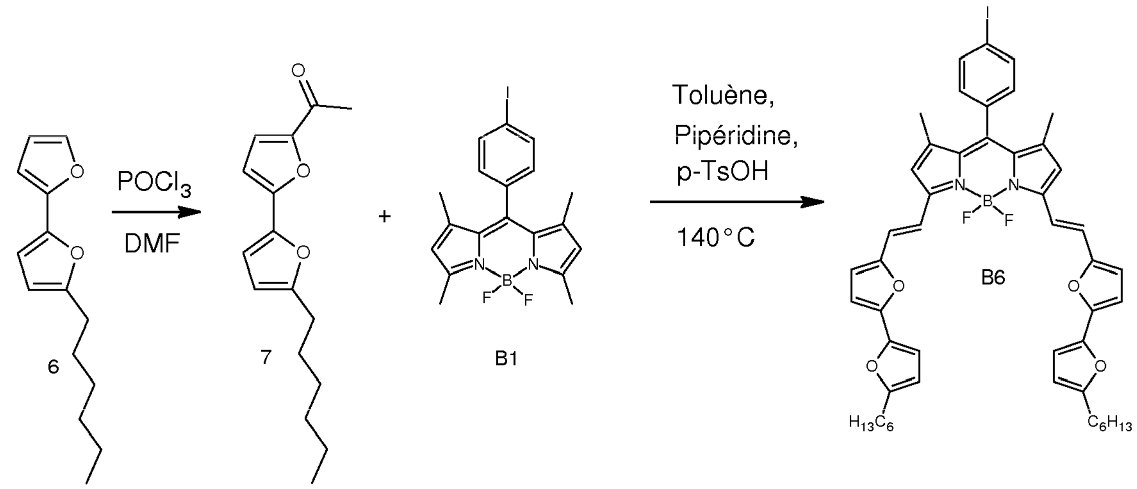


6 7 B1 B6

1) Première étape : Synthèse du composé 7

Le composé 7 a été synthétisé suivant la procédure générale n°4 à partir de 900 mg (2,1 mmol, 1 équiv.) du composé **6** et 575 μL de $POCl_3$ (3,15 mmol, 1,5 équiv.). Un mélange 50/50 (v/v) éther de pétrole/$CH_2Cl_2$ a été utilisé pour la purification du composé désiré. On a obtenu 600 mg (2,43 mmol, 60%) du composé **7** attendu.
RMN $^1$H (300 MHz, $CDCl_3$) : 0,90 (t, 3H, $^3$J = 6,6 Hz) ; 1,29-1,40 (m, 6H) ; 1,66-1,71 (m, 2H) ; 2,68 (t, 2H, $^3$J = 7,6 Hz) ; 6,14 (d, 1H, $^3$J = 3,3 Hz) ; 6,66 (d, 1H, $^3$J = 3,6 Hz) ; 6,82 (d, 1H, $^3$J= 3,3 Hz) ; 7,29 (d, 1H, $^3$J = 3,6 Hz) ; 9,59 (s, 1H).
RMN $^{13}$C (50 MHz, $CDCl_3$) : 14,2 ; 22,7 ; 28,0 ; 28,3 ; 28,9 ; 31,6 ; 106,6 ; 107,7 ; 110,9 ; 123,9 ; 143,3 ; 151,4 ; 152,1 ; 159,3 ; 176,9 ; 195,8.
SM-ESI : 246,1 ([M], 100).

Analyse élémentaire pour $C_{15}H_{18}O_3$ :

| | C | H |
|---|---|---|
| **Calculé** | **73,15** | **7,37** |
| **Trouvé** | **73,01** | **7,21** |

2) Deuxième étape : Synthèse du composé **B6**

Le composé **B6** a été synthétisé suivant la procédure générale n°1 à partir de 200 mg (0,46 mmol, 1 équiv.) de **B1**, 260 mg (1,05 mmol ; 2,3 équiv.) du composé **7** obtenu ci-dessus à l'étape précédente dans un volume de 20 ml de toluène. Un mélange 10/40/50 de $CH_2Cl_2$ / toluène / éther de pétrole (v/v/v) a été utilisé pour la purification du composé désiré. On a obtenu 250 mg du composé **B6** (0,27 mmol, rendement : 60%).

RMN $^1$H (300 MHz, $CDCl_3$) : 0,91 (t, 6H, $^3$J = 6,6 Hz) ; 1,30-1,42 (m, 12H) ; 1,48 (s, 6H) ; 1,65-1,73 (m, 4H) ; 2,70 (t, 4H, $^3$J = 7,3 Hz) ; 6,09 (d, 2H, $^3$ = 3,3 Hz) ; 6,59-6,71 (m, 8H) ; 7,02 (d, 2H, $^3$J = 16,2 Hz) ; 7,10 (d, 2H, $^3$J = 8,2 Hz) ; 7,60 (d, 2H, $^3$J = 16,2 Hz) ; 7,85 (d, 2H, $^3$J = 8,2 Hz).
RMN $^{13}$C (50 MHz, $CDCl_3$) : 14,2 ; 15,1 ; 22,7 ; 28,1 ; 28,3 ; 29,0 ; 31,7 ; 94,8 ; 107,3 ; 108,1 ; 114,5 ; 116,8 ; 118,2 ; 122,7 ; 130,8 ; 135,1 ; 138,3 ; 141,3 ; 144,6 ; 148,4 ; 152,2 ; 157,5.
SM-ESI : 906,2 ([M], 100).

Analyse élémentaire pour $C_{49}H_{50}BF_2IN_2O_4$ :

| | C | H | N |
|---|---|---|---|
| **Calculé** | **64,91** | **5,56** | **3,09** |
| **Trouvé** | **64,71** | **5,34** | **2,78** |

**EXEMPLE 4 : Synthèse du composé B7**

Le composé B7 a été synthétisé selon le schéma de synthèse suivant :

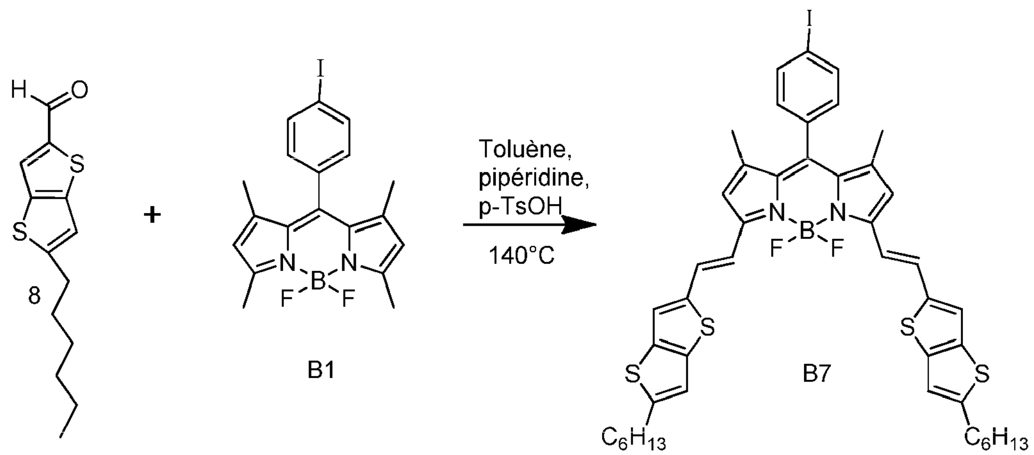


Le composé **B7** a été synthétisé suivant la procédure générale n°1 à partir de 200 mg (0,46 mmol, 1 équiv.) de **B1**, 280 mg (1,1 mmol, 2,5 équiv.) du composé **8** dans un volume de 20 ml de toluène. Un mélange $CH_2Cl_2$ / toluène / éther de pétrole (10/40/50, v/v/v) a été utilisé pour la purification du composé désiré. On a obtenu 285 mg du composé **B7** (0,32 mmol, rendement : 70%).
RMN $^1H$ (200 MHz, $CDCl_3$) : 0,91 (m, 6H) ; 1,35-1,46 (m, 18H) ; 1,70-1,73 (m, 4H) ; 2,90 (t, 4H, $^3J$ = 6,9 Hz) ; 6,60 (s, 2H) ; 6,94 (s, 2H) ; 7,07 (d, 2H, $^3J$ = 8,0 Hz) ; 7,31-7,52 (m, 6H) ; 7,84 (d, 2H, $^3J$ = 8,0 Hz).
RMN $^{13}C$ (50 MHz, $CDCl_3$) : 14,2 ; 15,1 ; 22,7 ; 28,9 ; 31,5 ; 31,6 ; 31,7 ; 94,8 ; 116, 9 ; 117,8 ; 118, 2 ; 120,9 ; 130,0 ; 130,8 ; 133,5 ; 135,0 ; 135,8 ; 138,1 ; 138,4 ; 140,4 ; 141,7 ; 142,9 ; 151,0 ; 150,2.
SM-ESI : 918,1 ([M], 100)

Analyse élémentaire pour $C_{45}H_{46}BF_2IN_2S_4$ :

| | C | H | N |
|---|---|---|---|
| **Calculé** | **58,82** | **5,05** | **3,05** |
| **Trouvé** | **58.61** | **4.74** | **2.83** |

**EXEMPLE 5 : Synthèse des composés B8 et B9**

Les composés **B8** et **B9** ont été synthétisés selon le schéma de synthèse suivant :

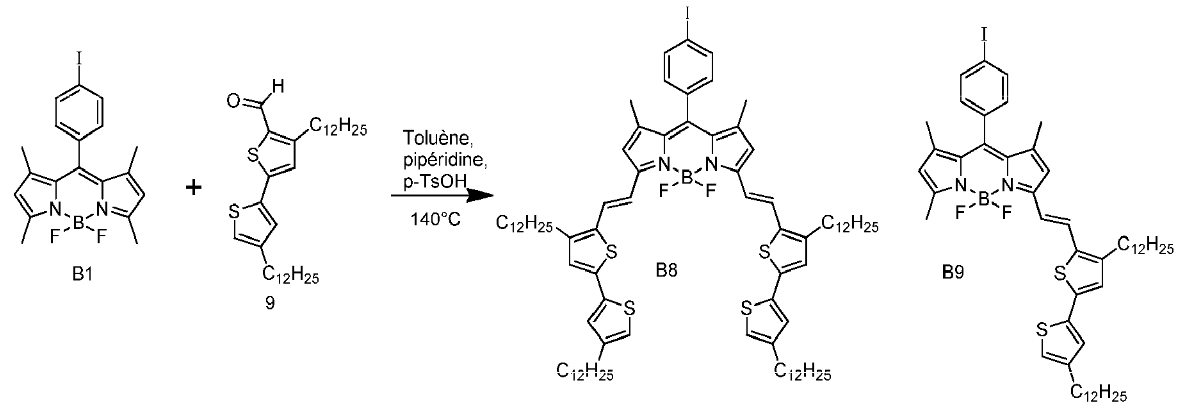


Les composés **B8** et **B9** ont été synthétisés suivant la procédure générale n°1 à partir de 430 mg (0,95 mmol, 1 équiv.) de **B1**, 720 mg (1,35 mmol, 1,4 équiv.) du composé **9** dans un volume de 20 ml de toluène. Un mélange de 70/5/25 (v/v/v) éther de pétorle / $CH_2Cl_2$ / toluène a été utilisé pour la purification des composés désirés. On a obtenu 260 mg du composé **B8** (0,176 mmol, rendement 18%) et 140 mg (0,145 mmol, rendement 15%) du composé **B9.**

**Composé B8** : RMN $^1H$ (300 MHz, $CDCl_3$) : 0,88 (t, 12H, $^3J$ = 6,35 Hz) ; 1,26 (m, 72H) ; 1,49 (s, 6H) ; 1,60-1,65 (m, 8H) ; 2,60 (t, 4H, $^3J$ = 7,5 Hz) ; 2,68 (t, 4H, $^3J$ = 7,5 Hz) ; 6,61 (s, 2H) ; 6,83 (s, 2H) ; 6,97 (s, 2H) ; 7,10 (d, 2H, $^3J$ = 8,3Hz) ; 7,15 (s, 2H) ; 7,40 (s, 4H) ; 7,85 (d, 2H, $^3J$ = 8,3Hz).
RMN $^{13}C$ (50 MHz, $CDCl_3$) : 14,3, 15,1, 22,8, 28,8, 29,5, 29,6, 29,7, 29,8, 30,5, 30,6, 31,1, 32,1, 94,8, 117,4, 118,3,

119,9, 126,0, 127,3, 130,9, 133,6, 135,1, 135,5, 137,1, 138,4, 141,2, 144,5, 145,4, 152,5.
SM-ESI : 1474,7 ([M], 100).

Analyse élémentaire pour $C_{85}H_{122}BF_2IN_2S_4$ :

| | C | H | N |
|---|---|---|---|
| **Calculé** | **69,17** | **8,33** | **1,90** |
| **Trouvé** | **69,04** | **8,17** | **1,74** |

**Composé B9** : RMN $^1H$ (300 MHz, $CDCl_3$) : 0,88 (m, 6H) ; 1,26-1,34 (m, 36H) ; 1,44 (s, 3H) ; 1,48 (s, 3H) ; 1,55-1,65 (m, 4H) ; 2,56-2,66 (m, 7H) ; 6,01 (s, 1H) ; 6,58 (s, 1H) ; 6,83 (s, 1H) ; 7,06-7,09 (m, 3H) ; 7,36 (s, 2H) ; 7,85 (d, 2H, $^3J$= 8,2 Hz) ;
RMN $^{13}C$ (50 MHz, $CDCl_3$) : 14,3 ; 14,8 ; 15,1 ; 22,8 ; 28,8 ; 29,4 ; 29,5 ; 29,6 ; 29,7 ; 29,8 ; 30,5 ; 30,6 ; 31,1 ; 32,1 ; 94,8 ; 117,2 ; 118,0 ; 119,9 ; 121,4 ; 125,9 ; 126,1 ; 127,5 ; 128,9 ; 130,4 ; 131,1 ; 131,6 ; 134,9 ; 135,2 ; 137,0 ; 138,3 ; 138,4 ; 142,0 ; 142,2 ; 144,5 ; 145,4 ; 153,2 ; 155,2.
SM-ESI : 962,4 ([M], 100)

Analyse élémentaire pour $C_{52}H_{70}BF_2IN_2S_2$ :

| | C | H | N |
|---|---|---|---|
| **Calculé** | **64,86** | **7,33** | **2.91** |
| **Trouvé** | **64,97** | **7,52** | **3,05** |

**EXEMPLE 6 : Synthèse des composés B10 et B11**

Les composés B10 et B11 ont été synthétisés selon le schéma de synthèse suivant :

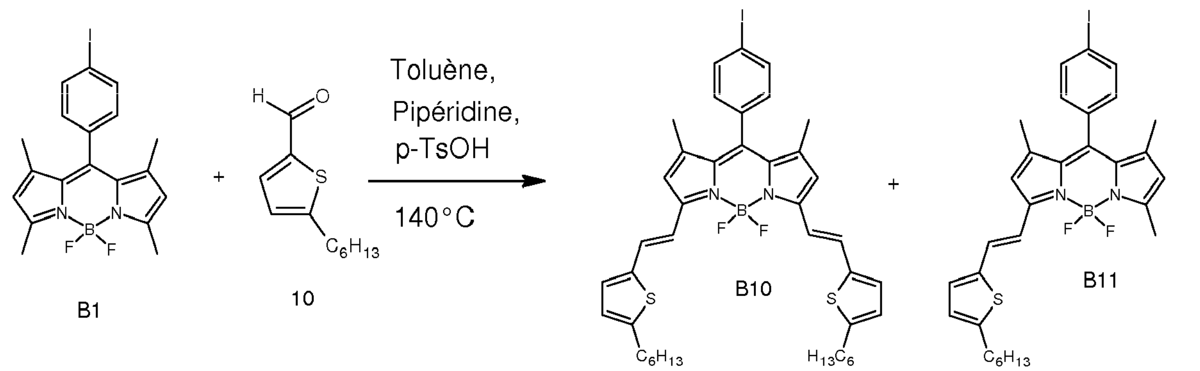


Les composés **B10** et **B11** ont été synthétisés suivant la procédure générale n°1 à partir de 434 mg (0,97 mmol, 1 équiv.) de **B1**, 223 mg (1,44 mmol, 1,5 équiv.) du composé **10** dans un volume de 20 ml de toluène. Un mélange de 70/5/25 (v/v/v) éther de pétrole / $CH_2Cl_2$ / toluène a été utilisé pour la purification des composés désirés. On a obtenu 196 mg du composé **B10** (0,243 mmol, rendement : 25%) et 55 mg (0,088 mmol, rendement 9%) du composé **B11.**

**Composé B10** : RMN $^1H$ (300 MHz, $CDCl_3$) : 0,88-0,93 (m, 6H) ; 1,33-1,42 (m, 12H) ; 1,45 (s, 6H) ; 1,67-1,74 (m, 4H) ; 2,83 (t, 4H, $^3J$ = 7,6 Hz) ; 6,56 (s, 2H) ; 6,72 (d, 2H, $^3J$ = 3,8 Hz) ; 7,04 (d, 2H, $^3J$ = 3,8 Hz) ; 7,08 (d, 2H, $^3J$ = 8,1 Hz) ; 7,27-7,42 (m, 4H) ; 7,84 (d, 2H, $^3J$ = 8,1 Hz).
RMN $^{13}C$ (50 MHz, $CDCl_3$) : 14,0 ; 14,9 ; 22,6 ; 28,8 ; 30,7 ; 31,5 ; 31,6 ; 94,6 ; 117,3 ; 117,9 ; 125,1 ; 125,3 ; 128,6 ; 129,5 ; 130,6 ; 134,9 ; 138,2 ; 140,1 ; 141,2 ; 149,0; 152,5.
SM-ESI : 806,1 ([M], 100).

Analyse élémentaire pour $C_{41}H_{46}BF_2IN_2S_2$ :

| | C | H | N |
|---|---|---|---|
| **Calculé** | **61,05** | **5,75** | **3,47** |
| **Trouvé** | **60,81** | **5,44** | **3,21** |

**Composé B11** : RMN $^1H$ (300 MHz, $CDCl_3$) : 0,90 (t, 3H, $^3J$ = 6,3 Hz) ; 1,33 (s, 6H) ; 1,42-1,45 (m, 6H) ; 1,65-1,72 (m, 2H) ; 2,58 (s, 3H) ; 2,81 (t, 2H, $^3J$ = 7,5 Hz) ; 6,00 (s, 1H) ; 6,54 (s, 1H) ; 6,70 (d, 1H, $^3J$ = 3,5 Hz) ; 7,01

(d, 1H, $^3J$ = 3,5 Hz) ; 7,06 (d, 2H, $^3J$ = 8,2 Hz) ; 7,31 (s, 2H) ; 7,84 (d, 2H, $^3J$ = 8,2 Hz).
RMN $^{13}C$ (50 MHz $CDCl_3$) 14,2 ; 14,8 ; 15,0 ; 22,7 ; 28,9 ; 29,8 ; 30,8 ; 31,6; 31,7; 95,0; 117,2; 117,9; 121,4; 125,4; 129,0; 130,0; 130,4; 131,5; 132,8 ; 134,9 ; 138,1 ; 138,4 ; 140,1 ; 142,0 ; 142,4 ; 149,3 ; 153,3 ; 155,2.
SM-ESI : 628,0 ([M], 100).

Analyse élémentaire pour $C_{30}H_{32}BF_2IN_2S$ :

| | C | H | N |
|---|---|---|---|
| **Calculé** | **57,34** | **5,13** | **4,46** |
| **Trouvé** | **57,12** | **4,98** | **4,31** |

**EXEMPLE 7 : Synthèse des composés B12 et B13**

Les composés B12 et B13 ont été synthétisés selon le schéma de synthèse suivant :

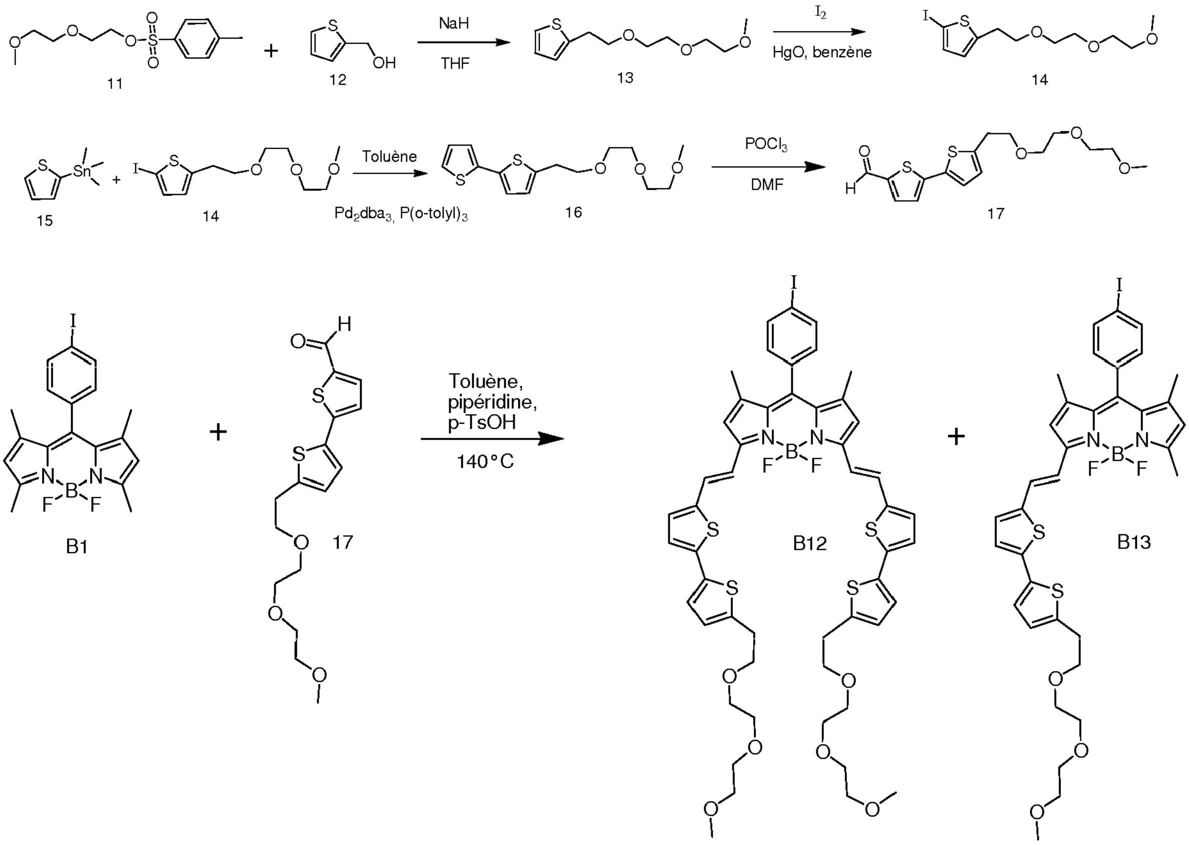


1) Première étape : Synthèse du composé **13.**

A une suspension d'hydrure de sodium (2,044 mmol) dans 5 ml de tétrahydrofurane fraîchement distillé, on a ajouté 1,750 mmol de 2-thiophène éthanol (composé **12**) sous argon. La solution a été laissée à agiter durant 45 min. Après quoi, le 2-(2-méthoxyéthoxy)éthyl 4-méthylbenzènesulfonate (composé **11** ; 1,460 mmol) a été ajouté au goutte à goutte. Une agitation à température ambiante a été maintenue durant une nuit. Le milieu réactionnel a été acidifié à l'aide d'une solution d'acide chlorhydrique jusqu'à revenir à pH 7. La solution a ensuite été lavée à l'eau et extraite à l'acétate d'éthyle. Le composé **13** a été obtenu sous forme d'une huile jaune après purification par chromatographie sur gel de silice avec un mélange de solvants comme éluant (éther de pétrole/acétate d'éthyle 8/2 : v/v) avec un rendement de 75%.
RMN $^1H$ (300 MHz, $(CD_3)_2CO$, $\delta$ (ppm) : 3,06 (t, 2H, $^3J$ = 6,7 Hz) ; 3,28 (s, 3H) ; 3,46 (m, 2H) ; 3,57 (m, 6H) ; 3,67 (t, 2H, $^3J$ = 6,7 Hz), 6,91 (m, 2H) ; 7,23 (dd, 1H, $^3J$ = 8,0 Hz, $^4J$ = 1,4 Hz).
RMN $^{13}C$ (75 MHz, $(CD_3)_2CO$, $\delta$ (ppm) : 30,0 ; 58,8; 71,0 ; 71,1 ; 71,2 ; 72,4 ; 72,7 ; 124,4 ; 126,0 ; 127,4 ; 142,4.
ES-MS: 230,1 (100).

Analyse élémentaire pour $C_{11}H_{18}O_3S$ :

| | C | H |
|---|---|---|
| **Calculé** | **57,36** | **7,88** |
| **Trouvé** | **57,01** | **7,53** |

2) Deuxième étape : Synthèse du 2-iodo-5-(2-(2-(2-méthoxyéthoxy)éthoxy)éthyl)-thiophène (Composé **14**)

A une solution de 100 mg de composé **13** obtenu ci-dessus à l'étape précédente (0,434 mmol) dans une solution de benzène (10 ml), a été ajouté alternativement et en petites proportions de l'oxyde de mercure (0,456 mmol) et de l'iode (0,456 mmol) à 0°C. La solution a été agitée à température ambiante pendant 1 heure avant d'être filtrée sur célite. La phase organique a été lavée à l'aide d'une solution de thiosulfate de sodium et la phase aqueuse extraite à l'éther. Le composé **14** a été obtenu avec un rendement de 87%, sous forme d'une huile jaune après purification par chromatographie sur gel de silice avec un mélange de solvants comme éluant (éther de pétrole/acétate d'éthyle 6/4). RMN $^1H$ (300 MHz, $(CD_3)_2CO$) : 3,07 (t, 2H, $^3J$ = 6,5 Hz) ; 3,39 (s, 3H) ; 3,61 (m, 10H) ; 6,54 (d, 1H, $^3J$ = 3,7 Hz) ; 7,04 (d, 1H, $^3J$ = 3,1 Hz).

RMN $^{13}C$ (75 MHz, $(CD_3)_2CO$) : 30,1 ; 50,8 ; 71,0 ; 71,1 ; 71,2 ; 71,9 ; 72,7 ; 126,0 ; 128,1 ; 137, 5 ; 149,4.
ES-MS: 356,0 (100).
Analyse élémentaire pour $C_{11}H_{17}IO_3$ S :

| | C | H |
|---|---|---|
| **Calculé** | **37,09** | **4,81** |
| **Trouvé** | **36,90** | **4,62** |

3) Troisième étape : Synthèse du 5-(2-(2-(2-méthoxyéthoxy)éthoxy)éthyl)-2,2'-bithiophène (Composé **16**).

1,68 mmol de 2-triméthylétainthiophène, 0,9 mmol du composé **14** obtenu ci-dessus à l'étape précédente et $6,75.10^{-5}$ mol de tri(o-tolyl)phosphine ont été dissous dans 5 mL de toluène sec et la solution a été dégazée à l'aide d'argon. $1,7.10^{-5}$ mol de tris(dibenzylidèneacétone)dipalladium $[Pd_2(dba)_3]$ ont ensuite été additionnées et le mélange a été chauffé à 110°C pendant 24 heures sous agitation et sous argon. La solution a ensuite été ramenée à température ambiante puis filtrée sur célite. La phase organique a été lavée 3 fois à l'eau, puis séchée sur $Na_2SO_4$. L'acétate d'éthyle a été évaporé sous vide. Le produit brut a été purifié sur colonne chromatographique flash avec pour éluent un mélange cyclohexane / acétate d'éthyle (80/20) pour obtenir le composé **16** sous la forme d'une huile jaune pâle (Rendement = 63%).
RMN $^1H$ ($CDCl_3$, 300 MHz) : 3,07 (t, 2H, $^3J$ = 6,8 Hz) ; 3,85 (s, 3H) ; 3,53-3,57 (m, 2H) ; 3,63-3,76 (m, 8H) ; 6,74-6,76 (m, 1H) ; 6,97-7,01 (m, 2H) ; 7,09-7,11 (m, 1H) ; 7,16-7,19 (m, 1H).
RMN $^{13}C$ ($CDCl_3$, 50 MHz) : 30,7 ; 59,1 ; 70,5 ; 70,7 ; 71,8 ; 72,1 ; 123,2 ; 123,5 ; 123,9 ; 126,0 ; 127,7 ; 135,7 ; 137,9 ; 140,8.
ES-MS: 312,1 (100).
Analyse élémentaire pour $C_{15}H_{20}O_3S_2$:

| | C | H |
|---|---|---|
| **Calculé** | **57,66** | **6,45** |
| **Trouvé** | **57,52** | **6,51** |

4) Quatrième étape : Synthèse du composé **17**

Le composé **17** a été synthétisé suivant la procédure générale n°4 à partir de 150 mg (0,476 mmol, 1 équiv.) du composé **16** obtenu ci-dessus à l'étape précédente et 67 $\mu$L de $POCl_3$ (0,714 mmol, 1,5 équiv.). Un mélange 80/20 éther de dichlorométhane/acétate d'éthyle a été utilisé pour la purification du composé désiré. On a obtenu 91 mg (0,266 mmol, rendement 56%) du composé **17.**
RMN $^1H$ (200 MHz, $(CDCl_3)$, $\delta$ (ppm) : 3,06 (t, 3H, $^3J$ = 6,5 Hz) ; 3,35 (s, 3H) ; 3,61 (m, 10H) ; 6,78 (d, 1H, $^3J$ = 3,6 Hz) ; 7,14 (m, 2H) ; 7,61 (d, 1H, $^3J$ = 3,6 Hz) ; 9,79 (s, 1H).
RMN $^{13}C$ (50 MHz, $(CD_3)_2CO$, $\delta$ (ppm): 30,8 ; 59,0 ; 70,4 ; 70,6 ; 71,3 ; 71,9 ; 123,6 ; 126,0 ; 126,6 ; 134,2 ; 137,5 ; 141,1 ; 144,2 ;147,7 ; 182,5.
ES-MS : 340,1 (100)

Analyse élémentaire pour $C_{16}H_{20}O_4S_2$ :

| | C | H |
|---|---|---|
| **Calculé** | **56,44** | **5,92** |
| **Trouvé** | **56,21** | **5,74** |

5) Cinquième étape : Synthèse des composés **B12 et B13.**

Les composés **B12** et **B13** ont été synthétisés suivant la procédure générale n°1 à partir de 106 mg (0,23 mmol, 1 équiv.) de **B1**, 120 mg (0,35 mmol, 1,5 équiv.) du composé **17** obtenu ci-dessus à l'étape précédente dans un volume de 20 ml de toluène. Un mélange 70/20/10 de $CH_2Cl_2$ / toluène / acétate d'éthyle (v/v/v) a été utilisé pour la purification des composés désirés. On a obtenu 25 mg du composé **B13** (32 μmol, rendement : 18%) et 140 mg (0,145 mmol, rendement : 15%) du composé **B12**.

Composé **B13**: RMN $^1H$ (200 MHz, $CDCl_3$) : 1,42 (s, 3H) ; 1,45 (s, 3H) ; 2,59 (s, 3H) ; 3,04-3,11 (m, 2H) ; 3,39 (s, 3H) ; 3,55-3,59 (m, 2H) ; 3,65-3,76 (m, 8H) ; 6,02 (s, 1H) ; 6,56 (s, 1H) ; 6,74-6,79 (m, 2H) ; 6,97-7,19 (m, 4H) ; 7,23-7,35 (superposition avec le solvant, m, 2H) ; 7,85 (d, 2H, $^3J$ = 8,4 Hz).
RMN $^{13}C$ (50 MHz, $CDCl_3$) : 14,8 ; 29,8 ; 30,8 ; 59,1 ; 70,5 ; 70,7 ; 71,8 ; 72,1 ; 94,8 ; 117,9 ; 121,6 ; 123,2 ; 123,5 ; 123,8 ; 124,5 ; 126,0 ; 126,4 ; 126,8 ; 127,8 ; 129,1 ; 129,8 ; 130,3 ; 134,8 ; 135,5 ; 135,7 ; 137,8 ; 138,2 ; 138,4 ; 139,7 ; 140,6 ; 140,8 ; 141,9 ; 142,2 ; 142, 4 ; 152,6 ; 155,6.
SM-ESI : 772,1 ([M] 100)

Analyse élémentaire pour $C_{35}H_{36}BF_2IN_2O_3S_2$ :

| | C | H | N |
|---|---|---|---|
| **Calculé** | **54,42** | **4,70** | **3,63** |
| **Trouvé** | **54.21** | **4.48** | **3.34** |

**Composé B12 :**

RMN $^1H$ (300 MHz, $CDCl_3$) : 1,47 (s, 6H) ; 3,10 (t, 4H, $^3J$=6,7 Hz) ; 3,39 (s, 6H) ; 3,55-3,58 (m, 4H) ; 3,66-3,69 (m, 12H) ; 3,75 (t, 4H, 6,7 Hz) ; 6,60 (s, 2H) ; 6,80 (d, 2H, $^3J$= 3,6 Hz) ; 7,05-7,14 (m, 8H) ; 7,30 (superposition avec le solvant d, 2H, $^3J$ = 16,0 Hz) ; 7,45 (d, 2H, $^3J$= 16,0 Hz) ; 7,85 (d, 2H, $^3J$= 8,2 Hz).
RMN $^{13}C$ (50 MHz, $CDCl_3$) : 15,1 ; 30,9 ; 59,2 ; 70,5 ; 70,7 ; 71,7 ; 72,1 ; 94,8 ; 118,0 ; 118,2 ; 124,1 ; 124,3 ; 126,4 ; 129,0 ; 129,7 ; 130,7 ; 133,6 ; 134,9 ; 135,6 ; 138,3 ; 139,8 ; 140,7 ; 141,5 ; 141,9 ; 152,2.
SM-ESI : 1094,1 ([M], 100).

Analyse élémentaire pour $C_{51}H_{54}BF_2IN_2O_5S_4$ :

| | C | H | N |
|---|---|---|---|
| **Calculé** | **55,94** | **4,97** | **2,56** |
| **Trouvé** | **55,78** | **4,62** | **2,40** |

**EXEMPLE 8 : Synthèse du composé B15**

Le composé **B15** a été synthétisé selon le schéma de synthèse suivant :

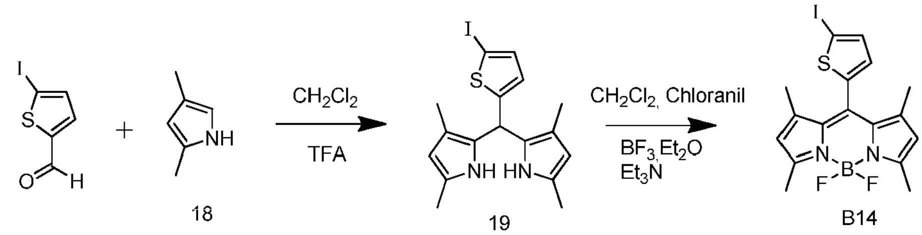


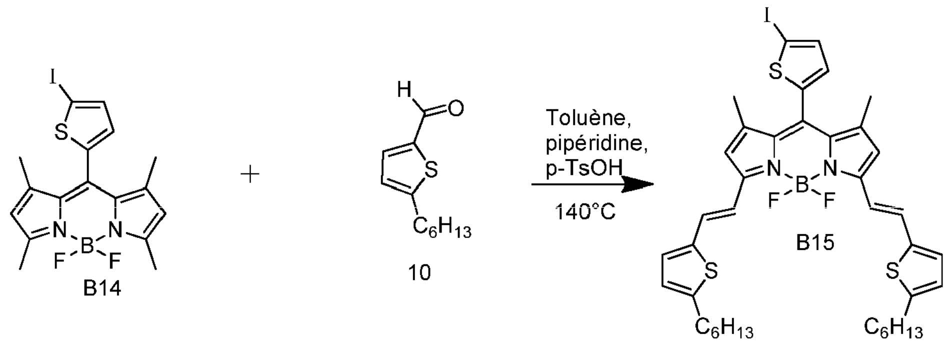


1) Première étape : Synthèse du composé **19**

Dans un ballon Schlenk contenant du dichlorométhane distillé, on a dissous 1,425 g (5,98 mmol, 1 équiv.) de 2-iodo-5-carbaldéhyde thiophène, 1,257 g (12,57 mmol, 2,5 équiv.) de 2,4-diméthylpyrrole (Composé **18**) et une à deux gouttes d'acide trifluoroacétique (TFA). On a laissé le mélange réactionnel sous agitation à température ambiante pendant 2 heures. La phase organique a été lavée avec de l'eau (3x50mL) puis séchée sur $Na_2SO_4$. Un mélange éther de pétrole / $CH_2Cl_2$ (50/50 ; v/v) a été utilisé pour la purification du composé désiré. On a obtenu 2,138 g du composé **19** (5,20 mmol, rendement : 87%).

RMN $^1H$ (300 MHz, $CDCl_3$) : 1,89 (s, 6H) ; 2,18 (s, 6H) ; 5,60 (s, 1H) ; 5,70 (s, 2H) ; 6,48 (d, 1H, $^3J$ = 3,8 Hz) ; 7,09 (d, 1H, $^3J$ = 3,8 Hz) ; 7,32 (s, 2H).

RMN $^{13}C$ (50 MHz $CDCl_3$) : 11,1 ; 13,2 ; 14,0 ; 14,8 ; 36,1 ; 72,0 ; 108,8 ; 115,5 ; 121,8 ; 125,2 ; 126,1 ; 126,9 ; 129,8 ; 137,0 ; 137,5 ; 153,0 ; 156,6.

2) Deuxième étape : Synthèse du composé **B14**

Le composé **B14** a été synthétisé à partir de 1,881 g (4,58 mmol, 1 équiv.) du composé **19** obtenu ci-dessus à l'étape précédente qui a été engagé rapidement après sa purification, et de 1,240 g (5,04 mmol, 1,1 équiv.) de 2,3,5,6-tétrachlorocylcohexa-2,5-diène-1,4dione (Chloranil) dans un volume de 60 mL de dichlorométhane distillé. Une heure après, 2,5 ml (27,59 mmol, 6 équiv.) de triéthylamine puis 7,16 ml (36,64 mmol, 8 équiv.) de trifluorure de bore éthéré ont été ajoutés. La phase organique a été lavée avec une solution saturée de $NaHCO_3$ (2x50mL) et avec de l'eau (3x50mL) puis séchée sur $Na_2SO_4$. Un mélange éther de pétrole / $CH_2Cl_2$ (40/60 ; v/v) a été utilisé pour la purification du composé désiré. On a obtenu 0,849 g du composé **B14** (1,86 mmol, rendement : 41%).
RMN $^1H$ (300 MHz, $CDCl_3$) : 1,67 (s, 6H) ; 2,55 (s, 6H) ; 6,01 (s, 2H) ; 6,69 (d, 1H, $^3J$ = 3,8 Hz) ; 7,28 (d, 1H, $^3J$ = 3,8 Hz).
RMN $^{13}C$ (50 MHz, $CDCl_3$,) : 14,0 ; 14,8 ; 74,8 ; 121,8 ; 121,9 ; 129,8 ; 132,3 ; 132,4 ; 137,6 ; 141,1 ; 143,5 ; 156,7.
SM-ESI : 456,0 ([M], 100)

Analyse élémentaire pour $C_{17}H_{16}BF_2IN_2S$ :

| | C | H | N |
|---|---|---|---|
| **Calculé** | **44,77** | **3,54** | **6,14** |
| **Trouvé** | **44,52** | **3,24** | **5,82** |

3) Troisième étape : Synthèse du composé **B15**

Le composé **B15** a été synthétisé suivant la procédure générale n°1 a partir de 188 mg (0,41 mmol, 1 équiv.) du composé **B14** obtenu ci-dessus à l'étape précédente, 208 mg (1,06 mmol, 2,6 équiv.) du composé **10** dans un volume de 20 ml de toluène. Un mélange éther de pétrole / $CH_2Cl_2$ / toluène (70/5/25 ; v/v/v) a été utilisé pour la purification du

composé désiré. On a obtenu 200 mg du composé **B15** (0,246 mmol, rendement : 60%).
RMN $^1$H (300 MHz, $CDCl_3$) : 0,90 (m, 6H) ; 1,38 (m, 12H) ; 1,71 (m, 10H) ; 2,83 (t, 4H, $^3J$ = 7,4 Hz) ; 6,59 (s, 2H) ; 6,72 (m, 3H) ; 7,04 (m, 2H) ; 7,28 (m, 1H) ; 7,33-7,40 (m, 4H).
RMN $^{13}$C (50 MHz, $CDCl_3$,) : 14,0 ; 14,1 ; 22,6 ; 28,8 ; 30,7 ; 31,5 ; 31,6 ; 117,3 ; 118,1 ; 125,3 ; 127,4 ; 128,9 ; 129,9 ; 130,2 ; 134,2 ; 137,3 ; 140,1 ; 141,5 ; 141,6 ; 149,3 ; 152,3.
SM-ESI : 812,1 ([M], 100).

Analyse élémentaire pour $C_{39}H_{44}BF_2IN_2S_3$ :

| | C | H | N |
|---|---|---|---|
| **Calculé** | **57,64** | **5,46** | **3,45** |
| **Trouvé** | **57,45** | **5,11** | **3,09** |

**EXEMPLE 9 : Synthèse du composé B16**

Le composé **B16** a été synthétisé selon le schéma de synthèse suivant :

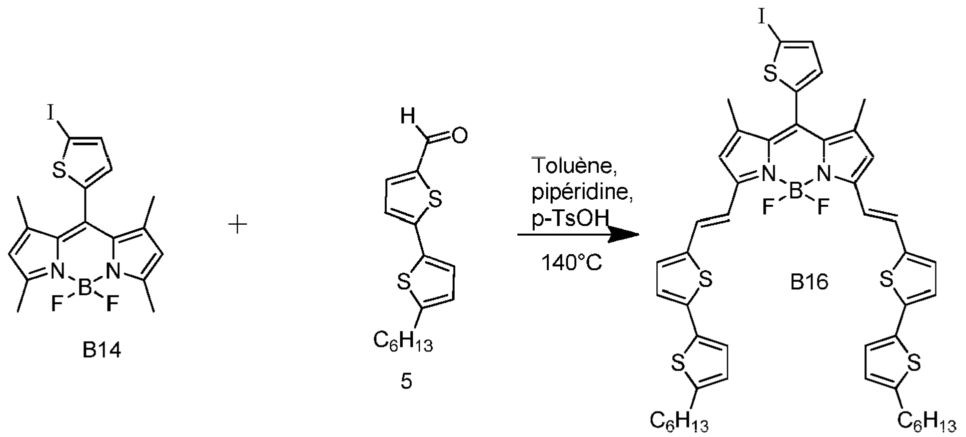


Le composé **B16** a été synthétisé suivant la procédure générale n°1 à partir de 198 mg (0,43 mmol, 1 équiv.) du composé **B14** obtenu ci-dessus à la 2$^{ème}$ étape de l'exemple 8) et de 302 mg (1,08 mmol, 2,5 équiv.) du composé **5** dans un volume de 20 ml de toluène. Un mélange éther de pétrole / $CH_2Cl_2$ / toluène (70/5/25 ; v/v/v) a été utilisé pour la purification du composé désiré. On a obtenu 135 mg du composé **B16** (0,138 mmol, rendement : 32%).
RMN $^1$H (300 MHz, $C_6D_6$) : 0,86-0,91 (m, 6H) ; 1,21-1,28 (m, 12H) ; 1,49-1,55 (m, 10H) ; 2,52-2,58 (m, 4H) ; 5,92-5,94 (m, 1H) ; 6,18 (s, 2H) ; 6,48-6,50 (m, 2H) ; 6,73-6,81 (m, 5H) ; 6,85-6,87 (m, 2H) ; 7,08 (s, 2H) ; 8,14 (s, 1H) ; 8,19 (s, 1H).
RMN $^{13}$C (50 MHz, $C_6D_6$) : 14,1 ; 14,3 ; 23,0 ; 29,1 ; 30,5 ; 31,8 ; 31,9 ; 75,0 ; 118,7 ; 118,9 ; 124,2 ; 125,0 ; 125,5 ; 129,7 ; 130,0 ; 130,6 ; 135,1 ; 135,2 ; 137,5 ; 140,6 ; 141,1 ; 141,3 ; 142,2 ; 146,3 ; 153,0.
SM-ESI : 976,0 ([M], 100).

Analyse élémentaire pour $C_{47}H_{48}BF_2IN_2S_5$ :

| | C | H | N |
|---|---|---|---|
| **Calculé** | **57,78** | **4,95** | **2,87** |
| **Trouvé** | **57,41** | **4,70** | **2,52** |

**EXEMPLE 10 : Synthèse du composé B17**

Le composé **B17** a été synthétisé selon le schéma de synthèse suivant :

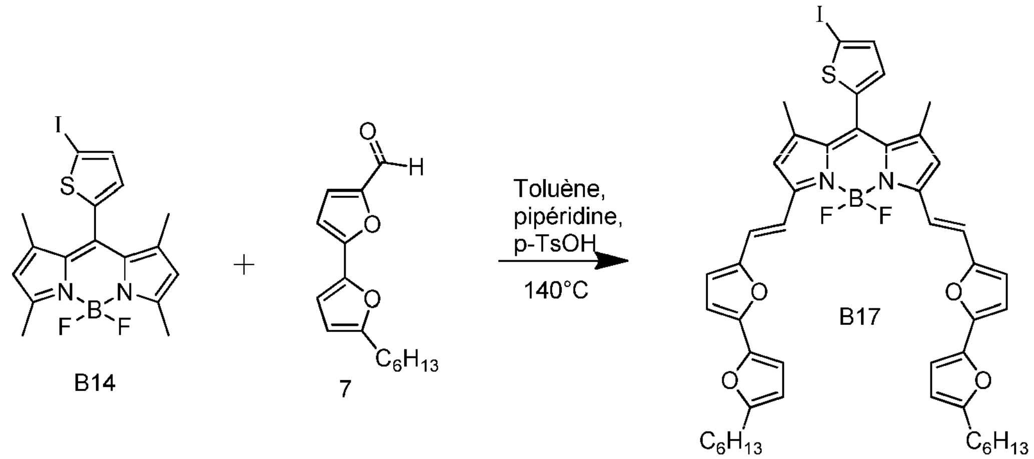


Le composé **B17** a été synthétisé suivant la procédure générale n°1 à partir de 201 mg (0,44 mmol, 1 équiv.) du composé **B14** obtenu ci-dessus à la 2ème étape de l'exemple 8 et de 240 mg (0,97 mmol, 2,2 équiv.) du composé 7 dans un volume de 20 mL de toluène. Un mélange éther de pétrole / $CH_2Cl_2$ / toluène (70/5/25 ; v/v/v) a été utilisé pour la purification du composé désiré. On a obtenu 145 mg du composé **B17** (0,159 mmol, rendement : 36%).

RMN $^1H$ (300 MHz, $C_6D_6$) : 0,87-0,93 (m, 6H) ; 1,28-1,45 (m, 12H) ; 1,66-1,79 (m, 10H) ; 2,66-2,73 (m, 4H) ; 6,10(s, 2H) ; 6,59-6,62 (m, 4H) ; 6,67 (d, 2H, $^3J$ = 3,5 Hz) ; 6,70-6,73 (m, 3H) ; 7,03 (d, 2H, $^3J$ = 16,0 Hz) ; 7,28 (m, 1H) ; 7,59 (d, 2H, $^3J$ = 16,0 Hz).

RMN $^{13}C$ (50 MHz, $C_6D_6$) : 14,3 ; 22,8 ; 28,2 ; 28,4 ; 29,1 ; 31,8 ; 74,7 ; 107,4 ; 107,5; 108,3 ; 114,9 ; 117,0 ; 118,6 ; 123,0 ; 130,5 ; 137,5 ; 141,6 ; 144,7 ; 148,6 ; 152,3 ; 152,6 ; 157,6.

SM-ESI : 912,1 ([M], 100).

Analyse élémentaire pour $C_{47}H_{48}BF_2IN_2O_4S$ :

| | C | H | N |
|---|---|---|---|
| **Calculé** | **61,85** | **5,31** | **3,07** |
| **Trouvé** | **61,54** | **4,92** | **2,74** |

**EXEMPLE 11 : Synthèse du composé B19**

Le composé **B19** a été synthétisé selon le schéma de synthèse suivant :

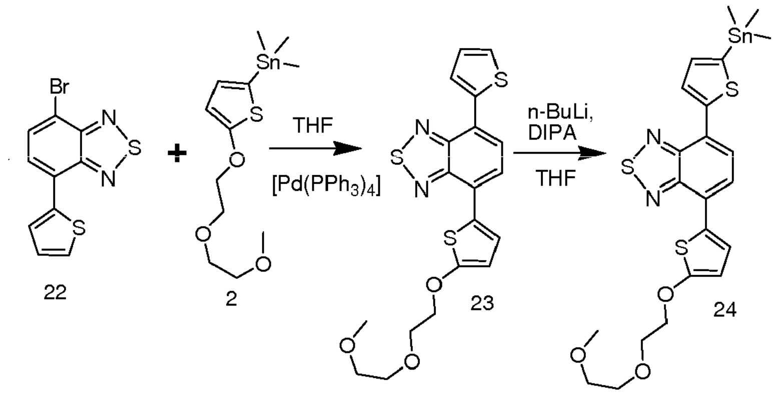


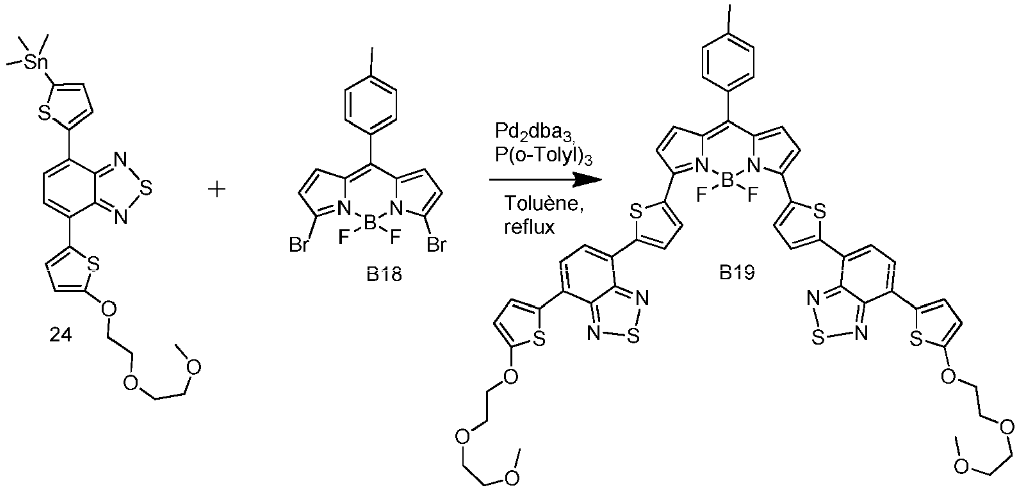


1) Première étape : Synthèse du composé **23** :

Dans un ballon de 100 mL, on a introduit 3,3 g de 2-triméthylstannyl-5-PEGthiophène (composé 2, 12,8 mmol), 0,9 g de composé 22 (3,03 mmol) et 25 mL de THF. La solution a été dégazée à l'aide d'argon pendant 20 minutes, puis on a ajouté 0,35 g de $[Pd(PPh_3)_4]$ (0,3 mmol) et la solution a été chauffée au reflux pendant 1 jour. Après refroidissement, la phase organique a été extraite à l'acétate d'éthyle et le produit brut a été purifié sur colonne chromatographique (éluent 80/20 (v/v), cyclohexane/AcOEt) puis par recristallisation dans l'acétone.

RMN $^1$H (Acétone d6, 300 MHz) : 3,32 (s, 3H) ; 3,54 (t, $^3$J = 5,2 Hz, 2H) ; 3,68 (t, $^3$J = 5,2 Hz, 2H) ; 3,87 (t, $^3$J = 4,6 Hz, 2H) ; 4,34 (t, $^3$J = 4,6 Hz, 2H) ; 6,46 (d, $^3$J = 4,2 Hz, 1H) ; 7,25 (dd, $^3$J = 5,1 Hz, $^3$J = 3,7 Hz, 1H) ; 7,63 (dd, $^3$J = 5,1 Hz, $^4$J = 1,0 Hz, 1H) ; 7,84 (d, $^3$J = 7,7 Hz, 1H) ; 7,82 (d, $^3$J = 4,2 Hz, 1H) ; 7,99 (d, $^3$J = 7,7 Hz, 1H) ; 8,17 (dd, $^3$J = 3,7 Hz, $^4$J= 1,0 Hz, 1H).

RMN $^{13}$C (Acétone d6, 75 MHz) : 59,6 ; 70,7 ; 72,0 ; 73,4 ; 74,7 ; 105,5 ; 125,3 ; 126,1 ; 126,9 ; 127,5 ; 127,7 ; 128,0 ; 128,5 ; 128,8 ; 129,4 ; 140,8 ; 153,8 ; 154,0 ; 168,9.

SM-ESI : 418,0 ([M], 100).

Analyse élémentaire pour $C_{19}H_{18}N_2O_3S_3$ :

| | C | H | N |
|---|---|---|---|
| **Calculé** | **54,52** | **4,33** | **6,69** |
| **Trouvé** | **54,33** | **4,47** | **6,42** |

2) Deuxième étape : Synthèse du composé **24** :

2,5 M de nBuLi dans 0,426 mL d'hexane ont été ajoutés goutte à goutte à 3 mL d'une solution de 0,164 mL diisopropylamine (1,17 mmol) dans du THF à -78°C. La solution a été réchauffée à -40°C pendant 30 min puis refroidie à -78°C. Le composé **23** obtenu ci-dessus à l'étape précédente (0,41g, 0,97 mmol) a ensuite été ajouté en solution dans 5 mL de THF à -78°C. La solution a de nouveau été réchauffée à 0°C pendant 20 min puis on a ajouté du chlorure de

triméthylétain (1,0 M dans THF, 1,17 mL) à la solution à -78°C. La solution a ensuite été agitée à température ambiante pendant 12 heures. La phase organique a été extraite à l'acétate d'éthyle et le produit brut a été utilisé sans purification. La conversion en groupement stannique réactif a été estimée par RMN à 35%.

RMN $^1H$ ($CDCl_3$, 300 MHz) : 0,44 (s, 9H) ; 3,41 (s, 3H), 3,61 (t, $^3J$ = 4,92 Hz,2H) ; 3,74 (t, $^3J$ = 4,52 Hz, 2H) ; 3,89 (t, $^3J$ =4,86 Hz, 2H) ; 4,31 (t, $^3J$ = 4,56 Hz, 2H) ; 6, 33 (d, $^3J$ = 4,24 Hz, 2H) ; 7,28 (d, $^3J$ = 3,45 Hz 1H) ; 7,63 (d, $^3J$ = 7,65 Hz, 1H) ; 7,81 (m, 2H) ; 8,14 (d, $^3J$ = 3,45 Hz, 1H).

3) Troisième étape : Synthèse du composé **B19** :

Dans un tube Schlenk contenant du toluène distillé, on a ajouté 160 mg du composé **24** obtenu ci-dessus à l'étape précédente (0,275 mmol), 48 mg de composé **B18** (0,11 mmol), 7 mg de tri(o-tolyl)phosphine P(o-Tolyl)$_3$ (21 μmol), puis on a dégazé la solution a l'aide d'argon durant 45 min. On a ensuite ajouté 5 mg de [$Pd_2(dba)_3$] (5,5 μmol), puis le milieu réactionnel a été chauffé lentement à 110°C pendant 3 heures. Après refroidissement, la phase organique a été extraite au dichlorométhane et le produit brut purifié sur colonne chromatographique (éluant 90/10 (v/v), $CH_2Cl_2$/AcOEt).

RMN $^1H$ (200 MHz, $CDCl_3$) : 2,47 (s, 3H) ; 3,41 (s, 6H) ; 3,59-3,62 (m, 4H) ; 3,72-3,75 (m, 4H) ; 3,87-3,90 (m, 4H) ; 4,28-4,31 (m, 4H) ; 6,31 (d, 2H, $^3J$ = 4,1 Hz) ; 6,80 (d, 2H, $^3J$= 4,4 Hz) ; 6,92 (s, 2H) ; 7,30 (d, 2H, $^3J$ = 7,8 Hz) ; 7,41 (d, 2H, $^3J$ = 7,8 Hz) ; 7,56-7,61 (m, 2H) ; 7,80-7,83 (m, 4H) ; 8,10 (s large, 2H) ; 8,37 (s large, 2H).

SM-ESI: 1114,1 ([M], 100)

Analyse élémentaire pour $C_{54}H_{45}BF_2N_6O_6S_6$ :

| | C | H | N |
|---|---|---|---|
| **Calculé** | **58,16** | **4,07** | **7,54** |
| **Trouvé** | **57,94** | **3,82** | **7,38** |

**EXEMPLE 12 : Synthèse du composé B20**

Le composé **B20** a été synthétisé selon le schéma de synthèse suivant :

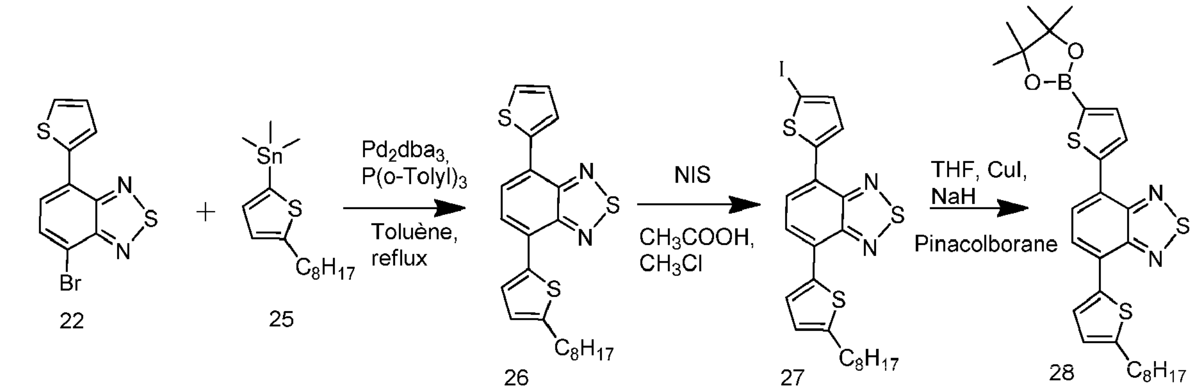

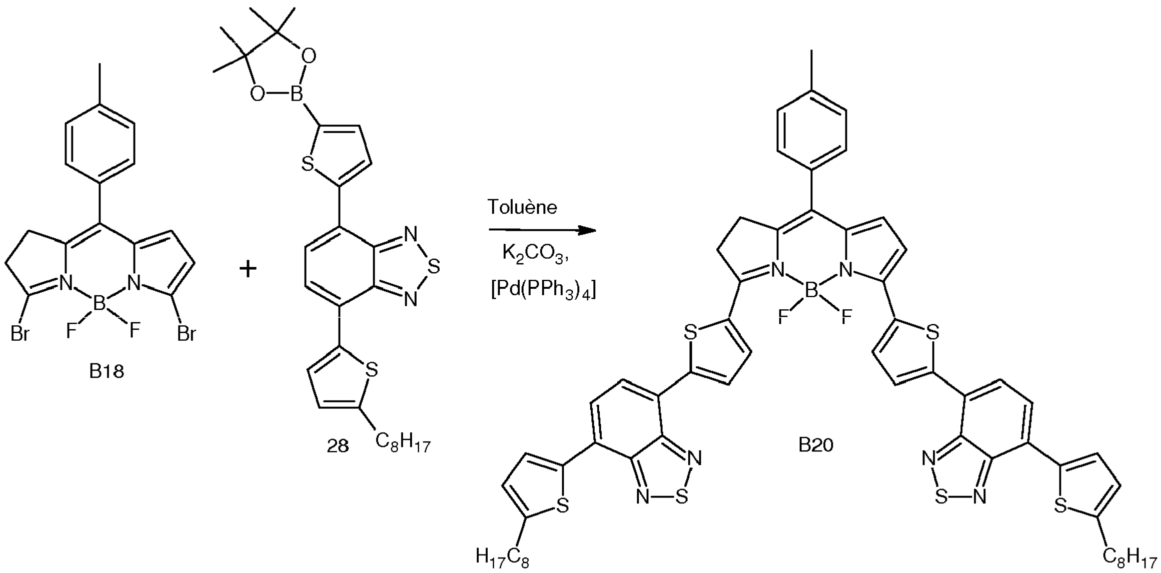


B18 + 28 → B20

1) Première étape : Synthèse du composé **26**

Dans un ballon de 50 mL, on a ajouté 0,54 g de 2-triméthylstannyl-5-octylthiophène (composé **25**, 1,5 mmol), 0,37 g de composé **22** (1,23 mmol), 0,036 g de P(o-tolyl)$_3$ (0,12 mmol) et 8 mL de toluène. La solution a été dégazée à l'aide d'argon pendant 20 minutes, puis 0,027 g de [Pd$_2$(dba$_3$)] (0,03 mmol) a été additionné et la solution a été chauffée au reflux pendant 1 jour. Après refroidissement, la phase organique a été extraite à l'acétate d'éthyle et le produit brut purifié sur colonne chromatographique flash (éluent 80/20 (v/v), éther de pétrole/toluène).

RMN $^1$H ($CDCl_3$, 300 MHz) : 0,89 (t, $^3$J = 5,2 Hz, 3H) ; 1,30 (m, 10H) ; 1,74 (t, $^3$J = 7,6 Hz, 2H) ; 2,90 (t, $^3$J = 7,6 Hz, 2H) ; 6,89 (d, $^3$J = 3,7 Hz, 1H) ; 7,21 (dd, $^3$J = 5,0 Hz, $^3$J= 3,7 Hz, 1H) ; 7,45 (d, $^3$J = 5,0 Hz, 1H) ; 7,80 (d, $^3$J = 7,6 Hz, 1H) ; 7,86 (d, $^3$J = 7,6 Hz, 1H) ; 7,95 (d, $^3$J = 3,6 Hz, 1H) ; 8,10 (dd, $^3$J = 3,6 Hz, $^4$J = 0,6 Hz, 1H).

RMN $^{13}$C ($CDCl_3$, 75 MHz) : 14,1 ; 22,7 ; 29,2 ; 29,2 ; 29,3 ; 30,3 ; 31,6 ; 31,8 ; 125,1 ; 125,2 ; 125,4 ; 125,9 ; 126,4 ; 126,6 ; 127,3 ; 127,6 ; 127,9 ; 136,7 ; 139,5 ; 148,1 ; 152,6 ; 152,7.

SM-ESI: 411,7 ([M], 100).

Analyse élémentaire pour $C_{22}H_{24}N_2S_3$ :

| | C | H | N |
|---|---|---|---|
| **Calculé** | **64,04** | **5,86** | **6,79** |
| **Trouvé** | **63,86** | **5,71** | **6,52** |

2) Deuxième étape : Synthèse du composé **27**

Le composé **26** (0,2 g, 0,48 mmol) obtenu ci-dessus à l'étape précédente a été mis en solution dans un mélange chloroforme/acide acétique (15 mL/10 mL) à l'obscurité. Le N-iodosuccinimide (NIS) (0,130 g, 1,2 équiv.) a été ajouté par portion dans la solution qui a ensuite été agitée pendant 2 heures à température ambiante. La phase organique a ensuite été lavée à l'eau et le produit purifié par colonne (éluent 90/10 (v/v), cyclohexane/toluène).

RMN $^1$H ($CDCl_3$, 300 MHz) : 0,89 (t, $^3$J = 6,1 Hz, 3H) ; 1,31 (m, 10H) ; 1,76 (t, $^3$J = 7,0 Hz, 2H) ; 2,89 (t, $^3$J = 7,5 Hz, 2H) ; 6,88 (d, $^3$J = 3,7 Hz, 1H) ; 7,34 (d, $^3$J = 3,9 Hz, 1H) ; 7,68 (d, $^3$J = 3,9 Hz, 1H) ; 7,77 (s, 2H) ; 7,95 (d, $^3$J = 3,7 Hz, 1H).

RMN $^{13}$C ($CDCl_3$, 75 MHz) : 14,1 ; 22,7 ; 29,1 ; 29,2 ; 29,3 ; 30,3 ; 31,6 ; 31,9 ; 124,2 ; 124,8 ; 125,3 ; 125,5 ; 126,8 ; 127,8 ; 128,0 ; 136,5 ; 137,66 ; 145,3 ; 148,3 ; 152,4.

SM-ESI : 537,7 ([M], 100).

Analyse élémentaire pour $C_{22}H_{23}IN_2S_3$ :

| | C | H | N |
|---|---|---|---|
| **Calculé** | **49,07** | **4,30** | **5,20** |
| **Trouvé** | **48,84** | **4,19** | **5,04** |

3) Troisième étape : Synthèse du composé **28**

À une solution de 0,457 mmol du composé **27** obtenu ci-dessus à l'étape précédente dans 15 ml de tétrahydrofurane fraîchement distillé, on a ajouté de l'hydrure de sodium (0,685 mmol), de l'iodure du cuivre (0,046 mmol) et du 4,4,5,5-tétraméthyl-[1,3,2]dioxaborolane (pinacolborane) (0,133 ml). Une agitation à température ambiante a été maintenue durant 1 heure. Le composé **28** désiré a été obtenu sous la forme d'une huile orange après une purification par chromatographie sur gel de silice en utilisant un mélange de solvants (éther de pétrole/dichlorométhane 8/2 (v/v) puis 0/10 (v/v) puis dichlorométhane/acétate d'éthyle 8/2 (v/v)). (Rendement de synthèse : 61%).
RMN $^1H$ (200 MHz, $CDCl_3$) : 0,88 (t, 3H, $^3J$ = 6,6 Hz) ; 1,32 (m, 10H) ; 1,38 (s, 12H) ; 1,75 (m, 2H) ; 2,88 (t, 2H, $^3J$ = 7,5 Hz) ; 6,88 (d, 1H, $^3J$ = 3,8 Hz) ; 7,71 (d, 1H, $^3J$ = 3,8 Hz) ; 7,85 (ABsyst, 2H, $^3J$ = 7,7 Hz) ; 7,95 (d, 1H, $^3J$ = 3,8 Hz) ; 8,17 (d, 1H, $^3J$ = 3,8 Hz).
RMN $^{13}C$ (50 MHz, ($CDCl_3$) : 14,2 ; 22,7 ; 24,9 ; 29,2 ; 29,3 ; 29,4 ; 30,4 ; 31,7 ; 32,0; 84,3 ; 125,1 ; 125,3 ; 125,4; 126,6; 127,0; 127,9; 128,5 ; 136,8; 138,0 ; 146,2 ; 148,4.
ES-MS: 537,8 (100)

Analyse élémentaire pour $C_{28}H_{35}BN_2O_2S_3$ :

| | C | H | N |
|---|---|---|---|
| **Calculé** | **62,44** | **6,55** | **5,20** |
| **Trouvé** | **62,65** | **6,84** | **5.31** |

4) Quatrième étape : Synthèse du composé **B20**

Le composé **B20** a été synthétisé suivant la procédure générale n°3 à partir de 285 mg (0,54 mmol) du composé **28** obtenu ci-dessus à l'étape précédente, 98 mg (0,22 mmol) de composé **B18**, 123 mg (0,89 mmol) de $K_2CO_3$ et 25 mg (22 $\mu$mol) de $[Pd(PPh_3)_4]$. Un mélange $CH_2Cl_2$/éther de pétrole (40/60, v/v) a été utilisé pour la purification du composé désiré. On a obtenu 130 mg du composé **B20** (rendement : 53%).
RMN $^1H$ (300 MHz, $CDCl_3$) : 0,88-0,90 (m, 6H) ; 1,30-1,39 (m, 20H) ; 1,70-1,77 (m, 4H) ; 2,47 (s, 3H) ; 2,87 (s large, 4H) ; 6,80 (d, 2H, $^3J$ = 4,3 Hz) ; 6,85 (d, 2H, $^3J$ = 3,4 Hz) ; 6,90-6,92 (m, 2H) ; 7,30 (d, 2H, $^3J$ = 7,8 Hz) ; 7,41 (d, 2H, $^3J$= 7,8 Hz) ; 7,71 (d, 2H, $^3J$= 7,5 Hz), 7,84-7,91 (m, 4H) ; 8,12-8,13 (m, 2H) ; 8,39 (s large, 2H).

Analyse élémentaire pour $C_{60}H_{57}BF_2N_6S_6$ :

| | C | H | N |
|---|---|---|---|
| **Calculé** | **64,23** | **4,72** | **8,03** |
| **Trouvé** | **64,02** | **4,52** | **7,69** |

**EXEMPLE 13 : Synthèse du composé B21**

Le composé **B21** a été synthétisé selon le schéma de synthèse suivant :

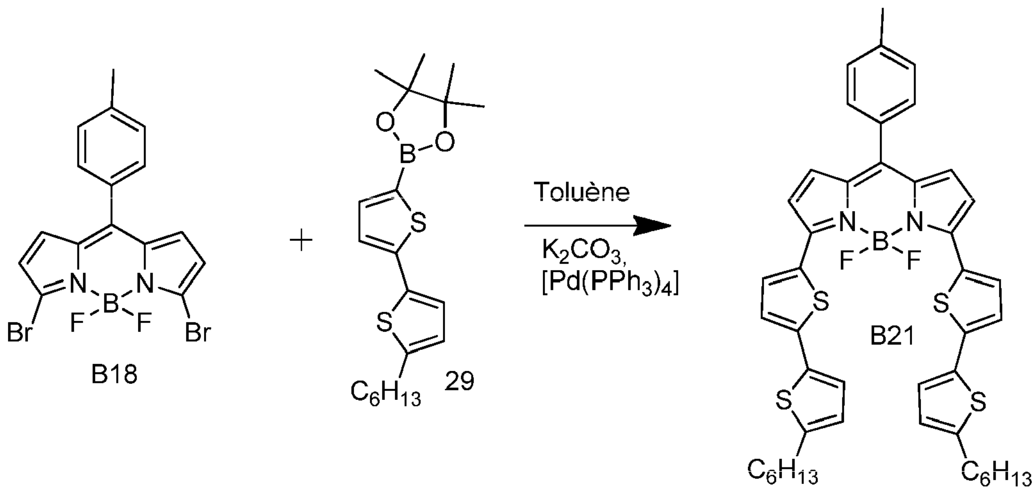

Le composé **B21** a été synthétisé suivant la procédure générale n°3 à partir de 257 mg (0,683 mmol) de composé **29**, 100 mg (0,228 mmol) de composé **B18**, 157 mg (1,14 mmol) de $K_2CO_3$ et 25 mg (22 μmol) de $[Pd(PPh_3)_4]$. Un mélange éther de pétrole/toluène (70/30, v/v) a été utilisé pour la purification du composé désiré. On a obtenu 130 mg du composé **B21** (rendement 53%).
$^1H$ RMN (300 MHz, $C_6D_6$), δ (ppm): 0,88 (t, 6H, $^3J$ = 7,0 Hz) ; 1,25-1,18 (m, 12H) ; 1,55-1,46 (m, 4H) ; 2,11 (s, 3H) ; 2,53 (t, 4H, $^3J$ = 7,5 Hz) ; 6,47 (d, 2H, $^3J$ = 3,6 Hz) ; 6,55 (d, 2H, $^3J$ = 4,2 Hz) ; 6,63 (d, 2H, $^3J$ = 4,2Hz) ; 6,96 (d, 2H, $^3J$ = 3.6 Hz) ; 7,03 (d, 2H, $^3J$ = 4,2 Hz) ; 7,95 (AB sys, 4H, $J_{AB}$ = 8.0 Hz, $v_o\delta$ = 41,7 Hz) ; 8,63 (d, 2H, $^3J$ = 4,2 Hz).
RMN $^{13}C$ (50 MHz, ($CDCl_3$) : 14,1 ; 21,0 ; 22,7 ; 28,8 ; 30,2 ; 31,5 ; 31,6 ; 120,5 ; 124,6 ; 125,3 ; 125,4 ; 127,6 ; 127,7 ; 127,8 ; 128,8 ; 129,5 ; 130,6 ; 132,0 ; 132,9 ; 134,7 ; 137,4 ; 139,5 ; 139,7 ; 141,7 ; 146,5 ; 149,6.
ES-MS: 778,3 (100).

Analyse élémentaire pour $C_{44}H_{45}BF_2N_2S_4$ :

| | C | H | N |
|---|---|---|---|
| **Calculé** | **67,85** | **5,82** | **3,60** |
| **Trouvé** | **67,64** | **5,59** | **3,44** |

**EXEMPLE 14 : Synthèse du composé B22**

Le composé B22 a été synthétisé selon le schéma de synthèse suivant :

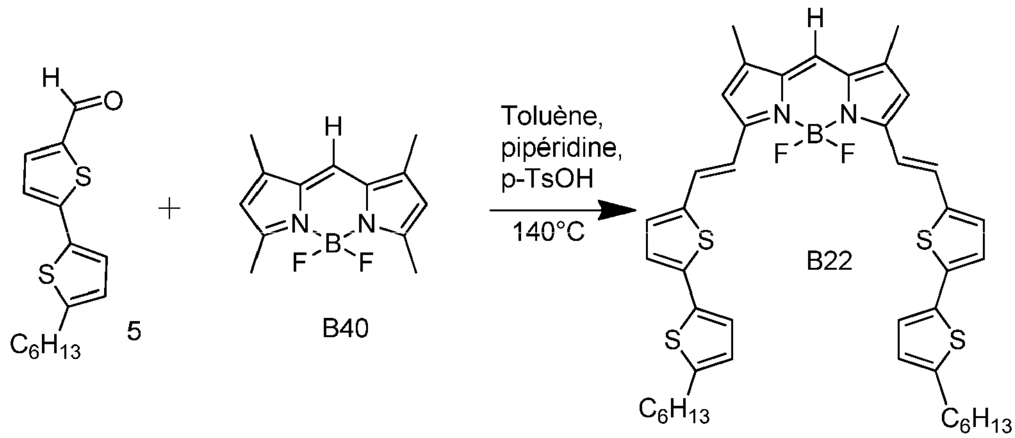


Le composé **B22** a été synthétisé suivant la procédure générale n°1 à partir de 40 mg (0,16 mmol, 1 équiv.) de composé **B40**, 100 mg (0,35 mmol, 2,2 équiv.) de composé 5 dans un volume de 10 ml de toluène. Un mélange éther de pétrole / $CH_2Cl_2$ / toluène (50/10/40, v/v/v) a été utilisé pour la purification du composé désiré. On a obtenu 90 mg du composé **B22** (0,117 mmol, rendement 73%).
RMN $^1H$ (300 MHz, $CDCl_3$) : 0,88 (t, 6H, $^3J$ = 6,7 Hz) ; 1,27-1,40 (m, 12H) ; 1,63-1,73 (m, 4H) ; 2,29 (s, 6H) ; 2,80 (t, 4H, $^3J$ = 7,5 Hz) ; 6,68 (s, 2H) ; 6,72 (d, 2H, $^3J$ = 3,3 Hz) ; 6,99 (s, 1H) ; 7,05 (d, 2H, $^3J$ = 3,6 Hz) ; 7,12 (d, 4H, $^3J$ = 3,3 Hz) ; 7,25 (d, 2H, $^3J$ = 15,8 Hz) ; 7,35 (d, 2H, $^3J$ = 15,8 Hz).
RMN $^{13}C$ (50 MHz, $CDCl_3$) : 11,4 ; 14,1 ; 28,8 ; 30,3 ; 31,6 ; 115,6 ; 115,9 ; 118,1 ; 123,7 ; 124,2 ; 125,1 ; 128,7 ; 129,6 ; 134,7 ; 139,5 ; 140,6 ; 146,4.
SM-ESI : 768,1 ([M], 100) :

Analyse élémentaire pour $C_{43}H_{47}BF_2N_2S_4$ :

| | C | H | N |
|---|---|---|---|
| **Calculé** | **67,17** | **6,16** | **3,64** |
| **Trouvé** | **66,89** | **5,83** | **3,40** |

**EXEMPLE 15 : Synthèse du composé B24**

Le composé **B24** a été synthétisé selon le schéma de synthèse suivant :

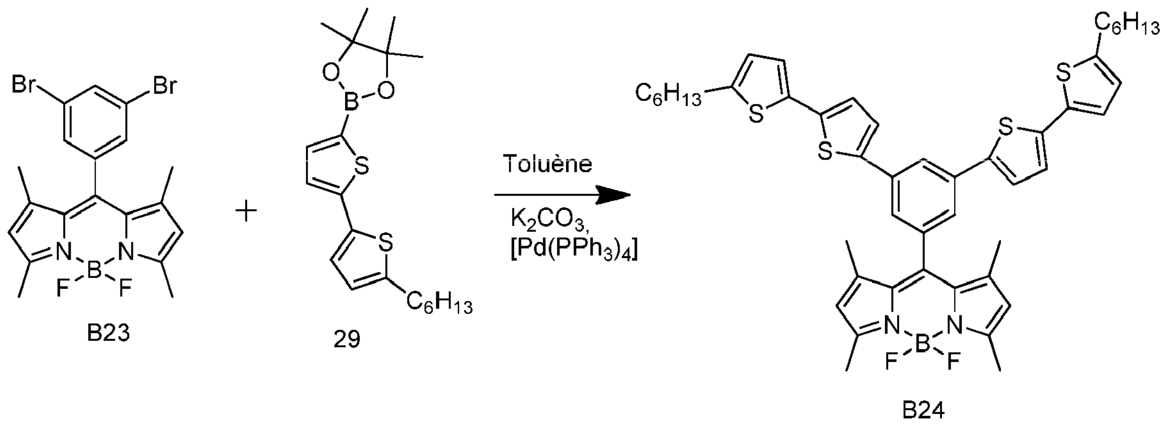


B23 29 B24

Le composé **B24** a été synthétisé suivant la procédure générale n°3 à partir de 200 mg (0,415 mmol, 1 éq) de composé **B23**, 350 mg (0,91 mmol, 2,2 éq) du composé **29**, 0,83 mL d'une solution 2M de $K_2CO_3$ et 5 mg de $[Pd(PPh_3)_4]$ (10% molaire) dans un volume de 10 mL de toluène. Un mélange éther de pétrole / $CH_2Cl_2$ / (80/20, v/v) a été utilisé pour la purification du composé désiré. On a obtenu 222 mg du composé **B24** (0,270 mmol, rendement : 65%).

RMN $^1H$ (200 MHz, $CDCl_3$) : 0,92 (t, 6H, $^3J$ = 6,3 Hz) ; 1,35-1,48 (m, 12H) ; 1,58-1,74 (m, 10H) ; 2,61 (s, 6H) ; 2,81 (t, 4H, $^3J$ = 7,3 Hz) ; 6,03 (s, 2H) ; 6,70 (d, 2H, $^3J$ = 3,4 Hz) ; 7,02-7,09 (m, 4H) ; 7,29 (d, 2H, $^3J$ = 3,9 Hz) ; 7,41 (s, 2H) ; 7,88 (s, 1H).

RMN $^{13}C$ (50 MHz, $CDCl_3$) : 14,2 ; 14,7 ; 15,1 ; 22,7 ; 28,8 ; 30,2 ; 31,6 ; 121,5 ; 122,4 ; 123,5 ; 123,8 ; 124,0 ; 124,7 ; 125,0 ; 131,3 ; 134,4 ; 135,9 ; 136,4 ; 138,5 ; 140,4 ; 140,5 ; 143,1 ; 146,1 ; 155,9.

SM-ESI : 820,2 ([M], 100)

Analyse élémentaire pour $C_{47}H_{51}BF_2N_2S_4$ :

| | C | H | N |
|---|---|---|---|
| **Calculé** | **68,76** | **6,26** | **3,41** |
| **Trouvé** | **68,54** | **6,04** | **3,27** |

**EXEMPLE 16 : Synthèse du composé B25**

Le composé B25 a été synthétisé selon le schéma de synthèse suivant :

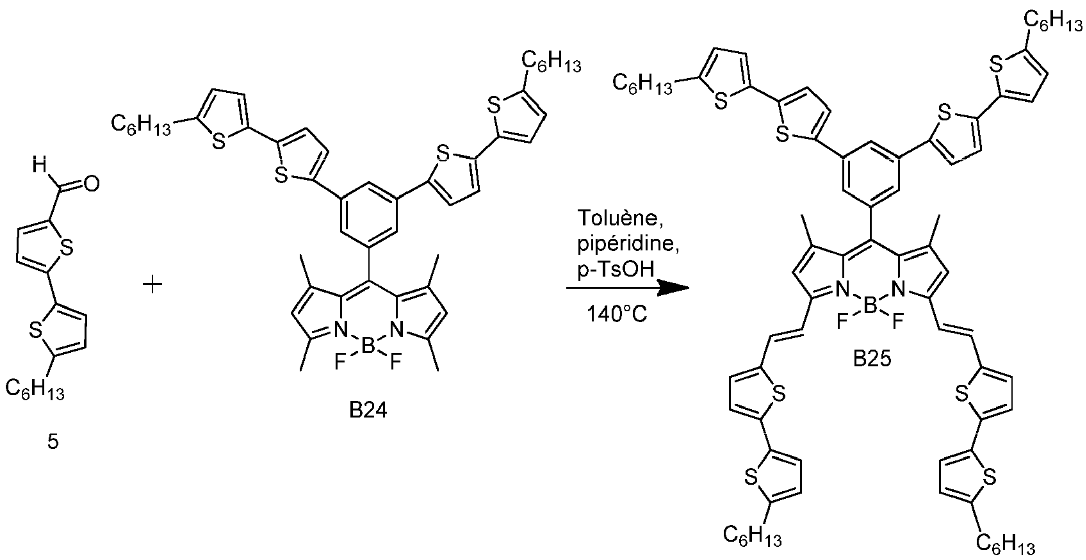


5 B24 B25

Le composé **B25** a été synthétisé suivant la procédure générale n°1 à partir de 210 mg (0,25 mmol, 1 équiv.) du composé **B24** obtenu ci-dessus à l'exemple 15, 160 mg (0,56 mmol, 2,2 équiv.) de composé **5** dans un volume de 20 ml de toluène. Un mélange éther de pétrole / toluène (70/30, v/v) a été utilisé pour la purification du composé désiré.

On a obtenu 232 mg du composé **B25** (0,173 mmol, rendement : 68%).
RMN $^1H$ (200 MHz, $CDCl_3$) : 0,87-0,93 (m, 12H) ; 1,25-1,35 (m, 24H) ; 1,55-1,69 (m, 14H) ; 2,80 (m, 8H) ; 6,62 (s, 2H) ; 6,69-6,73 (m, 4H) ; 7,02-7,14 (m, 10H) ; 7,27-7,35 (superposition avec le solvant m, 4H) ; 7,45-7,52 (m, 4H) ; 7,86-7,88 (m, 1H).
RMN $^{13}C$($CDCl_3$,50 MHz) : 14,2 ; 15,4 ; 22,7 ; 28,9 ; 30,4 ; 31,7 ; 118,1 ; 118,3 ; 122,5 ; 123,9 ; 124,1 ; 124,3 ; 124,8 ; 125,3 ; 129,0 ; 129,8 ; 133,7 ; 134,9 ; 135,9 ; 136,2 ; 136,8 ; 138,6 ; 140,1 ; 140,7 ; 140,8 ; 141,7 ; 146,2 ; 146,6, 152,3.
SM-ESI : 1340,3 ([M], 100)

Analyse élémentaire pour $C_{77}H_{83}BF_2N_2S_8$ :

| | C | H | N |
|---|---|---|---|
| **Calculé** | **68,92** | **6,23** | **2,09** |
| **Trouvé** | **69,27** | **6,54** | **2,38** |

## EXEMPLE 17 : Synthèse du composé B26

Le composé **B26** a été synthétisé selon le schéma de synthèse suivant :

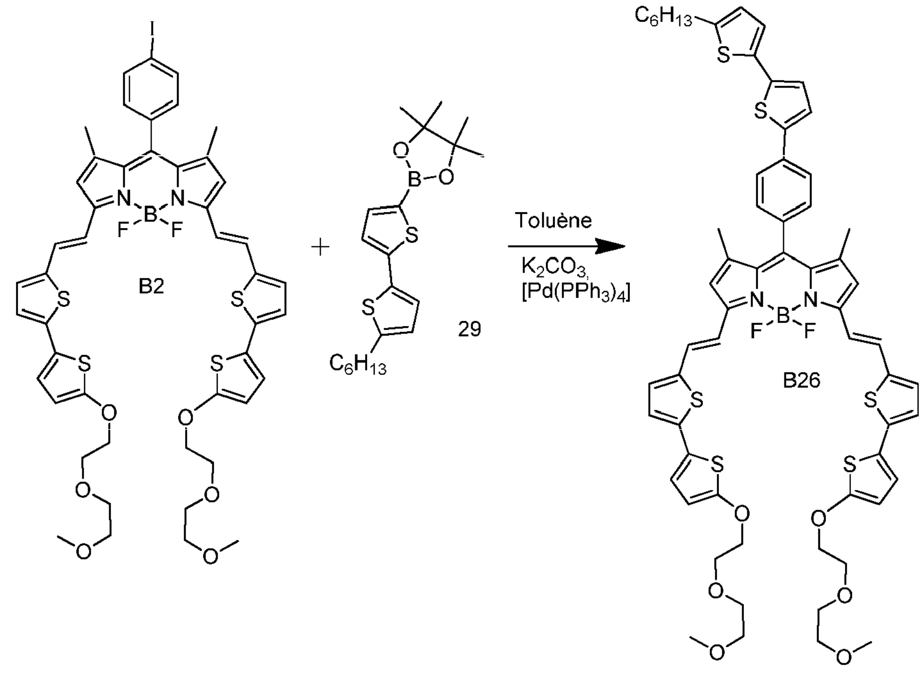


Le composé **B26** a été synthétisé suivant la procédure générale n°3 à partir de 102 mg (98,2 μmol, 1 équiv.) du composé **B2** obtenu ci-dessus à l'exemple 1,45 mg (0,118 mmol, 1,2 équiv.) du composé **29**, 242 μL d'une solution 2M de $K_2CO_3$ et 5 mg de $[Pd(PPh_3)_4]$ (10% molaire) dans un volume de 5 mL de toluène. Un mélange éther de pétrole / acétate d'éthyle (70/30, v/v) a été utilisé pour la purification du composé désiré. On a obtenu 68 mg du composé **B26** (58,9 μmol, rendement 60%).
RMN $^1H$ (200 MHz, $CDCl_3$) : 0,85-0,91 (m, 3H) ; 1,34-1,51 (m, 10H) ; 1,66-1,69 (m, 2H) ; 2,80 (t, 2H, $^3J$ = 7,5 Hz) ; 3,40 (s, 6H) ; 3,56-3,60 (m, 4H) ; 3,69-3,73 m, 4H) ; 3,83-3,87 (m, 4H) ; 4,21-4,25 (m, 4H) ; 6,19 (d, 2H, $^3J$ = 3,7 Hz) ; 6,58 (s, 2H) ; 6,70 (d, 1H, $^3J$ = 3,7 Hz) ; 6,90-6,94 (m, 5H) ; 7,02-7,09 (m, 4H) ; 7,24-7,48 (m, 8H) ; 7,70 (d, 2H, $^3J$ = 8,1 Hz).
RMN $^{13}C$ (50 MHz, $CDCl_3$) : 14,2 ; 15,1 ; 22,7 ; 28,9 ; 30,3 ; 31,7 ; 59,2 ; 69,4 ; 70,9 ; 72,1 ; 73,2 ; 106,4 ; 117,9 ; 118,1 ;122,4 ; 123,1 ; 123,7 ; 124,1 ; 124,2 ; 124,4 ; 125,1 ; 125,8 ; 128,7 ; 129,4 ; 129,7 ; 133,7 ; 133,9 ; 134,2 ; 134,6 ; 136,8 ; 138,1 ; 140,1 ; 141,3 ; 141,6 ; 145,9 ; 152,1 ; 165,1.
SM-ESI: 1160,2 ([M], 100).

Analyse élémentaire pour $C_{61}H_{63}BF_2N_2O_6S_6$ :

| | C | H | N |
|---|---|---|---|
| **Calculé** | **63,09** | **5,47** | **2,41** |
| **Trouvé** | **63,22** | **5,54** | **2,74** |

**EXEMPLE 18 : Synthèse du composé B27**

Le composé **B27** a été synthétisé selon le schéma de synthèse suivant :

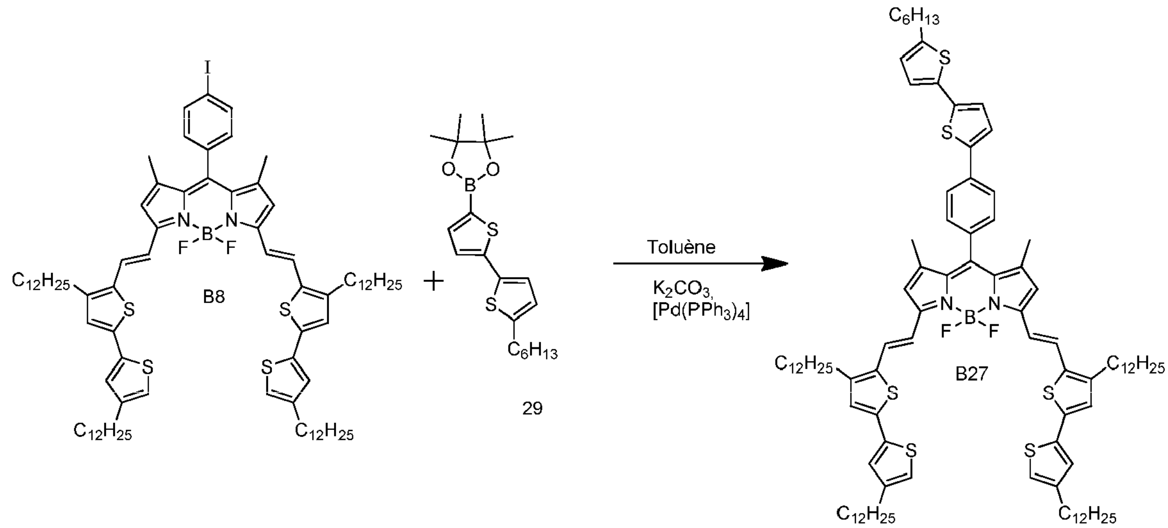


Le composé **B27** a été synthétisé suivant la procédure générale n°3 à partir de 55 mg (37,5 μmol, 1 équiv.) du composé **B8** obtenu ci-dessus à l'exemple 5, 17 mg (45,1 μmol, 1,2 équiv.) du composé **29**, 90 μL d'une solution 2M de $K_2CO_3$ et 5 mg de $[Pd(PPh_3)_4]$ (10% molaire) dans un volume de 5 mL de toluène. Un mélange éther de pétrole / $CH_2Cl_2$ / toluène (75/5/20, v/v/v) a été utilisé pour la purification du composé désiré. On a obtenu 35 mg du composé **B27** (21,9 μmol, rendement 58%).

RMN $^1H$ (300 MHz, $CDCl_3$) : 0,85-0,94 (m, 15H) ; 1,26-1,35 (m, 84H) ; 1,63-1,70 (m, 12H) ; 2,58-2,69 (m, 6H) ; 2,82 (t, 2H, $^3J$ = 7,5 Hz) ; 6,61 (s, 2H) ; 6,72 (d, 1H, $^3J$ = 3,4 Hz) ; 6,83 (s, 2H) ; 6,97 (s, 2H) ; 7,05 (d, 1H, $^3J$ = 3,4 Hz) ; 7,11-7,15 (m, 3H) ; 7,32-7,35 (superposition avec le solvant m, 4H) ; 7,41 (br, 3H) ; 7,74 (d, 2H, $^3J$ = 8,2 Hz).

RMN $^{13}C$ (50 MHz, $CDCl_3$,) : 14,2 ; 15,1 ; 22,7 ; 22,8 ; 28,8 ; 29,5 ; 29,6 ; 29,7 ; 29,8 ; 30,3 ; 30,5 ; 30,7 ; 31,1 ; 31,8 ; 32,1 ; 117,6 ; 118,1 ; 119,8 ; 123,7 ; 124,1 ; 124,4 ; 125,1 ; 125,8 ; 125,9 ; 126,2 ; 127,1 ; 129,5 ; 134,5 ; 134,6 ; 134,8 ; 135,5 ; 137,1 ; 138,1 ; 141,3 ; 141,4 ; 144,4 ; 145,2 ; 146,1 ; 152,4.

SM-ESI : 1596,8 ([M], 100)

Analyse élémentaire pour $C_{99}H_{139}BF_2N_2S_6$ :

| | C | H | N |
|---|---|---|---|
| **Calculé** | **74,39** | **8,77** | **1,75** |
| **Trouvé** | **74,64** | **9,05** | **1,96** |

**EXEMPLE 19 : Synthèse** du composé **B28**

Le composé **B28** a été synthétisé selon le schéma de synthèse suivant :

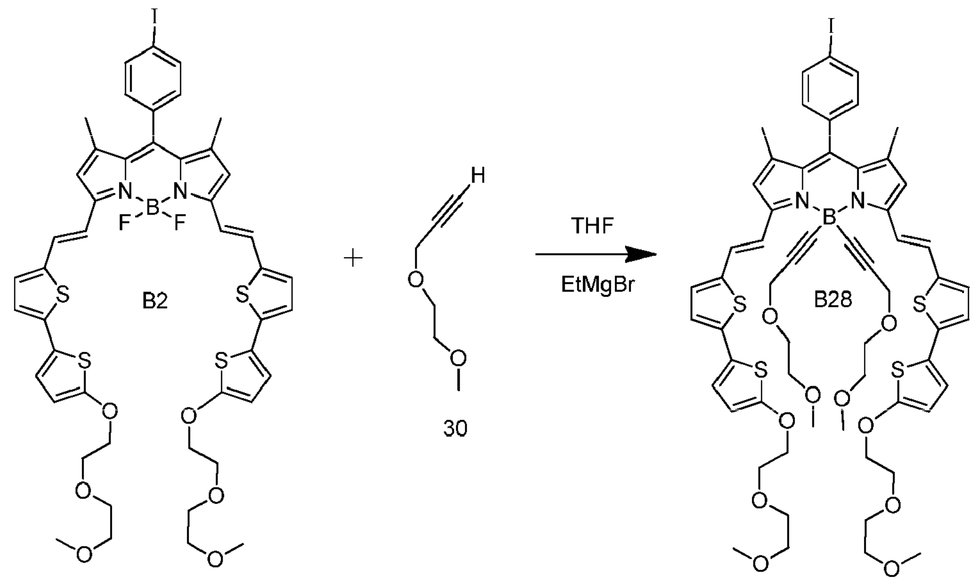


B2 + 30 → B28

Le composé **B28** a été synthétisé suivant la procédure générale n°2 à partir de 230 mg (0,221 mmol, 1 équiv.) du composé **B2** préparé ci-dessus à l'exemple 1, 88 mg (90 μL, 0,774 mmol, 3,5 éq) de composé **30** et 0,664 ml d'une solution de bromure d'éthylmagnésium (0,664 mmol, 3 équiv.) dans un volume de 10 ml de THF. Un mélange éther de pétrole / acétate d'éthyle (60/40, v/v) a été utilisé pour la purification du composé désiré. On a obtenu 244 mg du composé **B28** (0,2 mmol, Rendement : 90%).
RMN $^1H$ (200 MHz, $CDCl_3$) : 1,43 (s, 6H) ; 3,21 (s, 6H) ; 3,32-3,36 (m, 4H) ; 3,40 (s, 6H) ; 3,57-3,74 (m, 12H) ; 3,84-3,89 (m, 4H) ; 4,23-4,27 (m, 8H) ; 6,21 (d, 2H, $^3J$ = 3,6 Hz) ; 6,59 (s, 2H) ; 6,93-6,95 (m, 4H) ; 7,06-7,10 (m, 4H) ; 7,20 (d, 2H, $^3J$ = 15,9 Hz) ; 7,83 (d, 2H, $^3J$ = 8,5 Hz) ; 7,95 (d, 2H, $^3J$ = 15,9 Hz).
RMN $^{13}C$ (50 MHz, $CDCl_3$) : 15,2 ; 58,8 ; 59,2 ; 59,4 ; 68,3 ; 69,4 ; 70,9 ; 71,8 ; 72,0 ; 73,2 ; 91,9 ; 94,6 ; 106,4 ; 118,5 ; 119,8 ; 122,4 ; 123,2 ; 124,1 ; 127,1 ; 129,2 ; 130,8 ; 131,9 ; 135,3 ; 136,1 ; 138,2 ; 139,7, 139,9 ; 140,8 ; 151,4 ; 165,0.
SM-ESI : 1226,1 ([M], 100)

Analyse élémentaire pour $C_{59}H_{64}BIN_2O_{10}S_4$ :

| | C | H | N |
|---|---|---|---|
| **Calculé** | **57,75** | **5,26** | **2,28** |
| **Trouvé** | **57,54** | **4,92** | **1,98** |

## EXEMPLE 20 : Synthèse du composé B29

Le composé **B29** a été synthétisé selon le schéma de synthèse suivant :

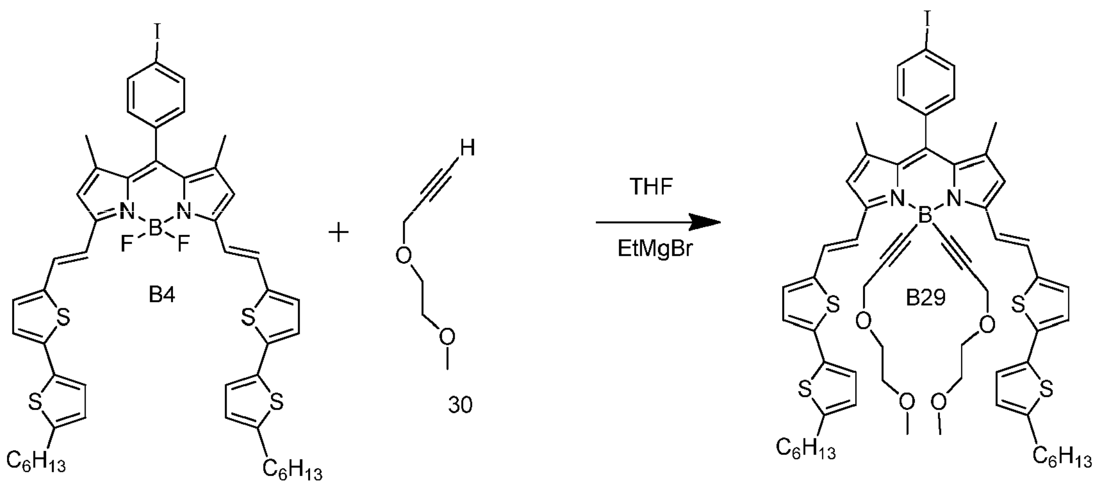


B4 + 30 → B29

Le composé **B29** a été synthétisé suivant la procédure générale n°2 à partir de 120 mg (0,123 mmol, 1 équiv.) du composé **B4** tel que préparé ci-dessus à l'exemple 2, 56 mg (60 µL, 0,49 mmol, 4 équiv.) de composé **30** et 0,430 ml d'une solution de bromure d'éthylmagnésium (EtMgBr) (0,430 mmol, 3,5 équiv.) dans un volume de 10 ml de THF. Un mélange $CH_2Cl_2$ / éther de pétrole (70/30, v/v) a été utilisé pour la purification du composé désiré. On a obtenu 134 mg du composé **B29** (0,115 mmol, Rendement 94%).
RMN $^1H$ (300 MHz, $CDCl_3$) : 0,91 (t, 6H, 6,9 Hz) ; 1,27-1,45 (m, 18H) ; 1,66-1,76 (m, 4H) ; 2,82 (t, 4H, 7,5 Hz) ; 3,22 (s, 6H) ; 3,34-3,37 (m, 4H) ; 3,68-3,71 (m, 4H) ; 4,25 (s, 4H) ; 6,60 (s, 2H) ; 6,73 (d, 2H, $^3J$ = 3,5 Hz) ; 7,05-7,26 (m, 10H) ; 7,84 (d, 2H, $^3J$ = 8,2 Hz) ; 7,99 (d, 2H, 15,9 Hz).
RMN $^{13}C$ (50 MHz, $CDCl_3$) : 14,2 ; 15,2 ; 22,7 ; 28,9 ; 30,4 ; 31,7 ; 58,9 ; 59,5 ; 68,3 ; 71,8 ; 94,7 ; 118,6 ; 120,0 ; 124,1 ; 124,4 ; 125,2 ; 127,1 ; 129,2 ; 130,8 ; 131,9 ; 134,7 ; 135,3 ; 138,2 ; 139,5 ; 140,0 ; 141,3 ; 146,5 ; 151,5.
SM-ESI : 1158,2 ([M], 100)

Analyse élémentaire pour $C_{61}H_{68}BIN_2O_4S_4$ :

| | C | H | N |
|---|---|---|---|
| **Calculé** | **63,20** | **5,91** | **2,42** |
| **Trouvé** | **63,04** | **5,77** | **2,09** |

**EXEMPLE 21 : Synthèse du composé B30**

Le composé **B30** a été synthétisé selon le schéma de synthèse suivant :

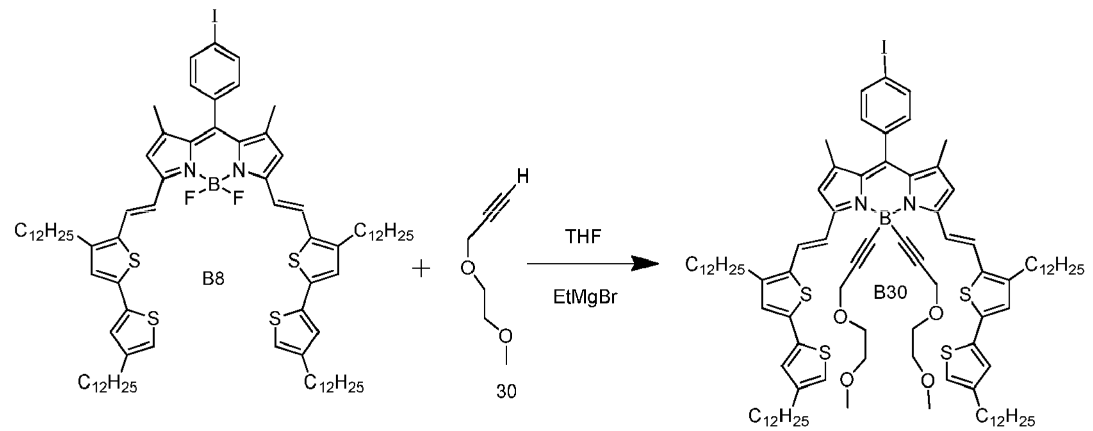


Le composé **B30** a été synthétisé suivant la procédure générale n°2 à partir de 190 mg (0,129 mmol, 1 équiv.) du composé **B8** tel que préparé ci-dessus à l'exemple 5, 52 mg (54 µL, 0,45 mmol, 3,5 équiv.) du composé **30** et 0,387 ml d'une solution de bromure d'éthylmagnésium (0,387 mmol, 3 équiv.) dans un volume de 10 ml de THF. Un mélange éther de pétrole / acétate d'éthyle (90/10, v/v) a été utilisé pour la purification du composé désiré. On a obtenu 200 mg du composé **B30** (0,120 mmol, Rendement : 93%).
RMN $^1H$ (300 MHz, $CDCl_3$) : 0,89 (m, 12H) ; 1,27-1,34 (m, 72H) ; 1,48 (s, 6H) ; 1,66 (br, 8H) ; 2,59-2,71 (m, 8H) ; 3,20 (s, 6H) ; 3,35-3,38 (m, 4H) ; 3,70-3,74 (m, 4H) ; 4,27 (s, 4H) ; 6,64 (s, 2H) ; 6,84 (s, 2H) ; 6.98 (s, 2H) ; 7,11-7,14 (m, 4H) ; 7,32 (d, 2H, $^3J$ = 15,8Hz) ; 7,86 (d, 2H, $^3J$ = 8,20 Hz) ; 7,93 (d, 2H, $^3J$ = 15,8 Hz).
RMN $^{13}C$ (50 MHz, $CDCl_3$,): 14,1 ; 15,1 ; 22,7 ; 28,7, 29,3 ; 29,5, 29,6 ; 29,7 ; 30,4 ; 30,5 ; 31 ; 31,9 ; 58,7; 59,4 ; 68,2 ; 71,7; 91,8 ; 94,5 ; 118,4 ; 119,1 ; 119,6 ; 125,2 ; 125,8 ; 126,3 ; 130,8 ; 135,3 ; 135,8 ; 136,9 ; 137,7 ; 138,1 ; 139,6 ; 144,4 ; 144,7 ; 151,7.
SM-ESI : 1662,1 ([M], 100).

Analyse élémentaire pour $C_{97}H_{140}BIN_2O_4S_4$ :

| | C | H | N |
|---|---|---|---|
| **Calculé** | **70,01** | **8,48** | **1,68** |
| **Trouvé** | **69,72** | **8,34** | **1,45** |

**EXEMPLE 22 : Synthèse du composé B31**

Le composé **B31** a été synthétisé selon le schéma de synthèse suivant :

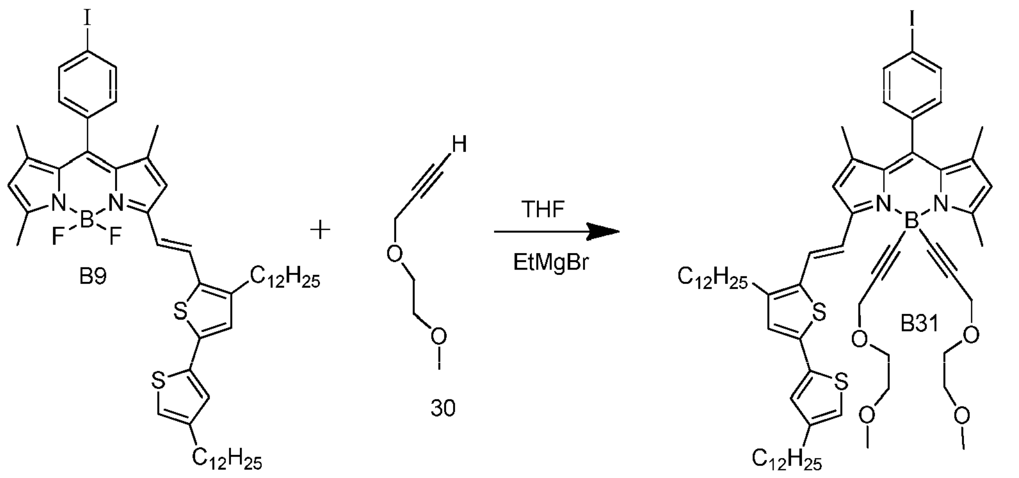


Le composé **B31** a été synthétisé suivant la procédure générale n°2 à partir de 130 mg (0,135 mmol, 1 équiv.) du composé **B9** tel que préparé ci-dessus à l'exemple 5, 54 mg (57 μL, 0,47 mmol, 3,5 équiv.) de composé **30** et 0,4 ml d'une solution de bromure d'éthylmagnésium (0,4 mmol, 3 équiv.) dans un volume de 10 ml de THF. Un mélange éther de pétrole / acétate d'éthyle (90/10, v/v) a été utilisé pour la purification du composé désiré. On a obtenu 140 mg du composé **B31** (0,121 mmol, Rendement 90%).
RMN $^1$H (300 MHz, $CDCl_3$) : 0,86-0,90 (m, 6H) ; 1,27-1,34 (m, 36H) ; 1,43 (s, 3H) ; 1,46 (s, 3H) ; 1,61-1,67 (m, 4H) ; 2,57-2,77 (m, 4H) ; 2,77 (s, 3H) ; 3,26 (s, 6H) ; 3,39-3,43 (m, 4H) ; 3,60-3,71 (m, 4H) ; 4,24 (s, 4H) ; 6,05 (s, 1H) ; 6,60 (s, 1H) ; 6,83 (s, 1H) ; 6,95 (s, 1H) ; 7,07-7,12 (m, 3H) ; 7,25 (d, 1H, $^3J$ = 15,8 Hz) ; 7,85 (d, 2H, $^3J$ = 8,20 Hz) ; 7,92 (d, 1H, $^3J$ = 15,8Hz).
RMN $^{13}$C (50 MHz, $CDCl_3$,): 14,2 ; 15,0 ; 15,2 ; 16,4 ; 22,8 ; 28,7 ; 29,4 ; 29,5 ; 29,6 ; 29,7 ; 29,8 ; 30,5 ; 30,6 ; 31,1 ; 32,1 ; 58,9 ; 59,6 ; 68,5 ; 71,8 ; 91,5 ; 94,6 ; 118,1 ; 119,3 ; 119,8 ; 121,9 ; 124,9 ; 125,7 ; 126,2 ; 130,2 ; 130,6 ; 130,9 ; 135,3 ; 135,8 ; 136,9 ; 137,6 ; 138,2 ; 138,3 ; 140,2 ; 140,7 ; 144,5 ; 151,7 ; 155,7.
SM-ESI : 1150,2 ([M], 100).

Analyse élémentaire pour $C_{64}H_{88}BIN_2O_4S_2$ :

| | C | H | N |
|---|---|---|---|
| **Calculé** | **66,77** | **7,70** | **2,43** |
| **Trouvé** | **66,42** | **7,38** | **2,09** |

**EXEMPLE 23 : Synthèse du composé B32**

Le composé **B32** a été synthétisé selon le schéma de synthèse suivant :

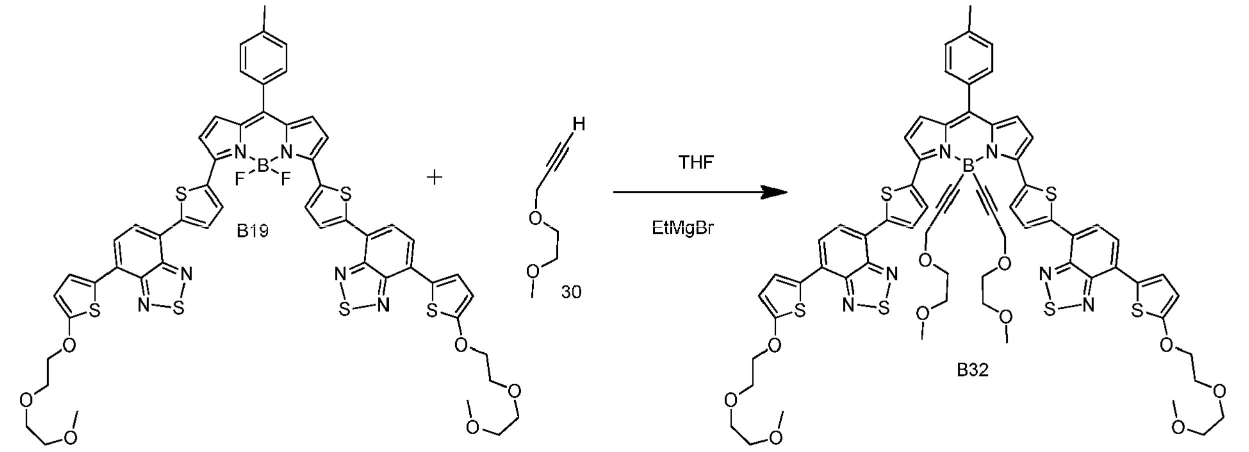


Le composé **B32** a été synthétisé suivant la procédure générale n°2 à partir de 60 mg (53,8 μmol, 1 équiv.) du composé **B19** tel que préparé ci-dessus à l'exemple 11, 25 mg (25 μL, 0,215 mmol, 4 équiv.) de composé **30** et 0,190 ml d'une solution de bromure d'éthylmagnésium (0,190 mmol, 3,5 équiv.) dans un volume de 5 ml de THF. Un mélange éther de pétrole / acétate d'éthyle (70/30, v/v) a été utilisé pour la purification du composé désiré. On a obtenu 56 mg du composé **B32** (43 μmol, Rendement : 80%).

RMN $^1$H (200 MHz, $CDCl_3$) : 2,49 (s, 3H) ; 3,11 (s, 6H) ; 3,23-3,26 (m, 4H) ; 3,34-3,40 (m, 4H) ; 3,42 (s, 6H) ; 3,59-3,61 (m, 4H) ; 3,73-3,76 (m, 4H) ; 3,89-3,92 (m, 4H) ; 4,05 (s, 4H) ; 4,31-4,34 (m, 4H) ; 6,37 (d, 2H, $^3$J = 4,02 Hz) ; 6,84 (d, 2H, $^3$J = 4,35 Hz) ; 7,05 (s, large 2H) ; 7,32 (d, 2H, $^3$J = 7,8 Hz) ; 7,48 (d, 2H, $^3$J = 7,8 Hz) ; 7,70 (d, 2H, $^3$J = 7,4 Hz) ; 7,87 (s large, 4H) ; 8,2 (s large, 2H) ; 8,86-8,90 (m, 2H).

RMN $^{13}$C (50 MHz, $CDCl_3$) : 21,5 ; 29,8 ; 58,9 ; 59,2 ; 59,4 ; 68,3 ; 69,5 ; 71 ; 71,8 ; 72,1 ; 73,1 ; 93,8 ; 106,7 ; 121,6 ; 123,9 ; 124,3 ; 126,1 ; 126,7 ; 127 ; 128,4 ; 128,6 ; 129 ; 130,7 ; 132,1 ; 134,5 ; 136 ; 140 ; 141,8 ; 149 ; 152,6 ; 152,7 ; 167,2.

SM-ESI : 1302,2 ([M], 100).

Analyse élémentaire pour $C_{66}H_{63}BN_6O_{10}S_6$ :

| | C | H | N |
|---|---|---|---|
| **Calculé** | **60,82** | **4,87** | **6,45** |
| **Trouvé** | **60,57** | **4,74** | **6,29** |

**EXEMPLE 24 : Synthèse du composé B33**

Le composé **B33** a été synthétisé selon le schéma de synthèse suivant :

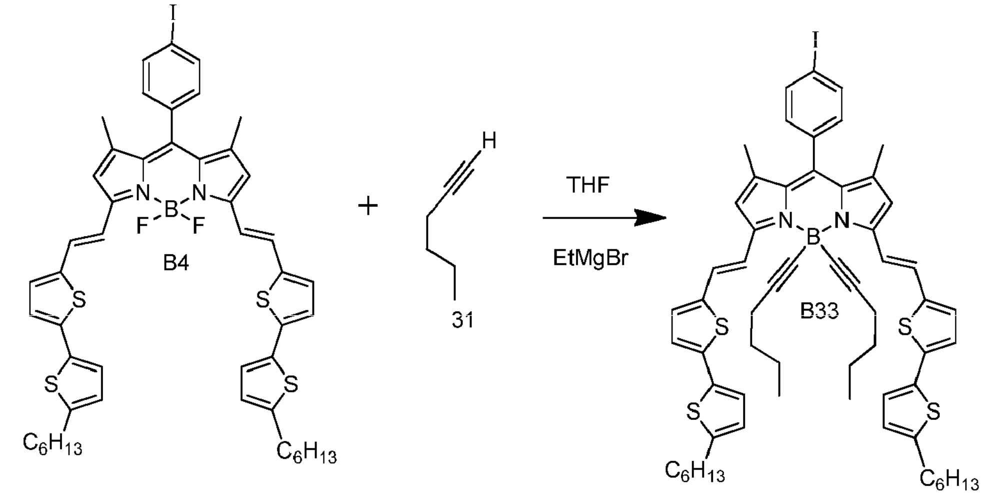


Le composé **B33** a été synthétisé suivant la procédure générale n°2 à partir de 130 mg (0,134 mmol, 1 équiv.)

du composé **B4** tel que préparé ci-dessus à l'exemple 2, 33 mg (47 µL, 0,4 mmol, 3 équiv.) de composé **31** et 0,335 ml d'une solution de bromure d'éthylmagnésium (0,335 mmol, 2,5 équiv.) dans un volume de 10 ml de THF. Un mélange éther de pétrole / toluène (90/10, v/v) a été utilisé pour la purification du composé désiré. On a obtenu 120 mg du composé **B33** (0,109 mmol, Rendement : 81%).
RMN $^1$H (200 MHz, $CDCl_3$) : 0,82-0,94 (m, 12H) ; 1,26-1,75 (m, 26H) ; 1,64-1,75 (m, 4H) ; 2,17-2,23 (m, 4H) ; 2,83 (t, 4H, $^3$J = 7,5 Hz) ; 6,60 (s, 2H) ; 6,73 (d, 2H, $^3$J = 3,8 Hz) ; 7,05-7,25 (m, 10H) ; 7,83 (d, 2H, $^3$J = 8,1 Hz) ; 8,15 (d, 2H, $^3$J = 15,9 Hz).
RMN $^{13}$C (50 MHz, $CDCl_3$): 13,6 ; 14,1 ; 15,2 ; 19,8 ; 22,4 ; 22,5 ; 22,7 ; 28,9 ; 30,4 ; 30,7 ; 31,7 ; 68,1 ; 94,5 ; 118,5 ; 121,0 ; 123,9 ; 124,1 ; 125,1 ; 126,5 ; 128,8 ; 131,0 ; 131,9 ; 135,1 ; 135,7 ; 136,3 ; 138,2 ; 139,1 ; 139,6 ; 141,9 ; 146,2 ; 151,5.
SM-ESI : 1094,2 ([M], 100).

Analyse élémentaire pour $C_{61}H_{68}BIN_2S_4$ :

| | C | H | N |
|---|---|---|---|
| **Calculé** | **66,90** | **6,26** | **2,56** |
| **Trouvé** | **66,69** | **6,09** | **2,28** |

**EXEMPLE 25 : Synthèse du composé B34**

Le composé **B34** a été synthétisé selon le schéma de synthèse suivant :

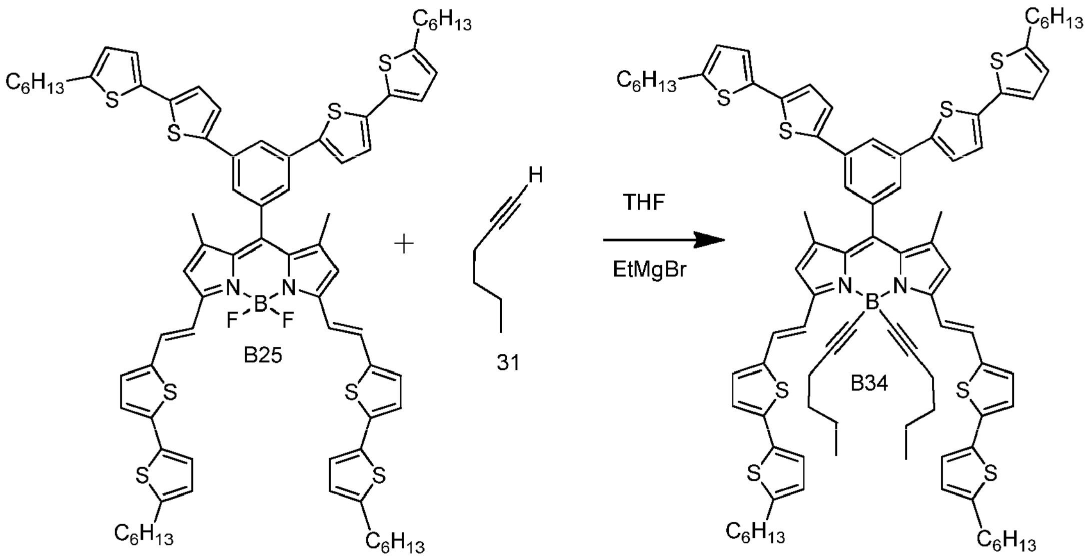


Le composé **B34** a été synthétisé suivant la procédure générale n°2 à partir de 90 mg (67 µmol, 1 équiv.) du composé **B25** tel que préparé ci-dessus à l'exemple 16, 17 mg (24 µL, 0,2 mmol, 3 équiv.) de composé **31** (commercial) et 0,167 ml d'une solution de bromure d'éthylmagnésium (0,167 mmol, 2,5 équiv.) dans un volume de 5 ml de THF. Un mélange éther de pétrole / toluène (90/10, v/v) a été utilisé pour la purification du composé désiré. On a obtenu 90 mg du composé **B34** (61,4 µmol, Rendement : 91%0).
RMN $^1$H (200 MHz, $CDCl_3$) : 0,84-0,95 (m, 18H) ; 1,28-1,36 (m, 28H) ; 1,49-1,71 (m, 16H) ; 2,21-2,24 (m, 4H) ; 2,78-2,87 (m, 10H) ; 6,63 (s, 2H) ; 6,70-3,75 (m, 4H) ; 7,03-7,12 (m, 10H) ; 7,20 (s, 1H) ; 7,27-7,32 (m, 3H) ; 7,49-7,50 (m, 2H) ; 7,84-7,86 (m, 1H) ; 8,20 (d, 2H, $^3$J = 15,9 Hz).
RMN $^{13}$C (50 MHz, $CDCl_3$): 14,1 ; 14,2 ; 15,6 ; 19,8 ; 22,4 ; 22,7 ; 28,9 ; 30,3 ; 30,4 ; 31,7 ; 31,8 ; 96,9 ; 118,5 ; 121,1 ; 122,3 ; 123,8 ; 124,1 ; 124,5 ; 125,1 ; 126,4 ; 128,8 ; 132,1 ; 134,6 ; 135,1 ; 135,6 ; 134,4 ; 138,3 ; 139,0 ; 139,7 ; 140,9 ; 142,0 ; 146,0 ; 146,2 ; 151,5.
SM-ESI : 1464,4 ([M], 100).

Analyse élémentaire pour $C_{89}H_{101}BN_2S_8$ :

| | C | H | N |
|---|---|---|---|
| **Calculé** | **72,91** | **6,94** | **1,91** |
| **Trouvé** | **73,28** | **7,17** | **2,18** |

**EXEMPLE 26 : Synthèse du composé B35**

Le composé **B35** a été synthétisé selon le schéma de synthèse suivant :

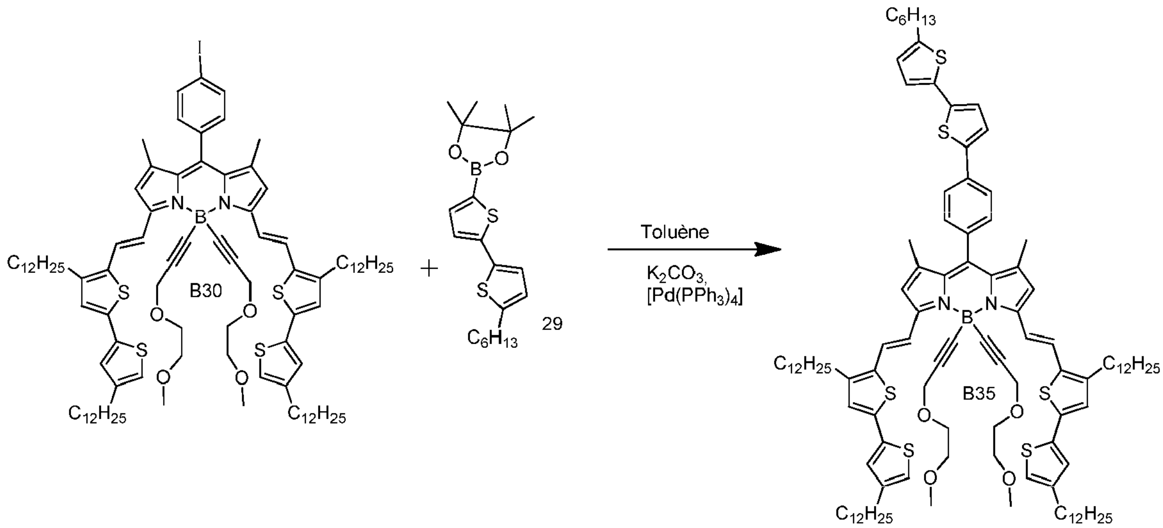


Le composé **B35** a été synthétisé suivant la procédure générale n°3 à partir de 70 mg (42 μmol, 1 équiv.) du composé **B30** tel que préparé ci-dessus à l'exemple 21, 20 mg (50,5 μmol, 1,2 équiv.) de composé **29**, 0,11 mL d'une solution 2M de $K_2CO_3$ et 5 mg de $[Pd(PPh_3)_4]$ (10% molaire) dans un volume de 5 mL de toluène. Un mélange éther de pétrole / acétate d'éthyle (90/10, v/v) a été utilisé pour la purification du composé désiré. On a obtenu 43 mg du composé **B35** (24,3 μmol, Rendement : 58%).
RMN $^1H$ (400 MHz, $CDCl_3$) : 0, 86-0,91 (m 15H) ; 1,27-1,35 (m 78H) ; 1,27-1,35 (m, 16H) ; 2,61 (t, 4H, $^3J$ = 7,8 Hz) ; 2,68 (t, 4H, $^3J$ = 7,8 Hz) : 2,82 (t, 2H, $^3J$ = 7,4 Hz) ; 3,20 (s, 6H) ; 3,35-3,38 (m, 4H) ; 3,71-3,73 (m, 4H) ; 4,28 (s, 4H) ; 6,63 (s, 2H) ; 6,72 (d, 1H, $^3J$ = 3,7 Hz) ; 6,84 (s, 2H) ; 6,97 (s, 2H) ; 7,05 (d, 1H, $^3J$ = 3,3 Hz) ; 7,12 (d, 1H, $^3J$ = 3,7 Hz) 7,14 (s, 2H) ; 7,29-7,37 (m, 5H) ; 7,73 (d, 2H, $^3J$ = 8,2 Hz) ; 7,93 (d, 2H, $^3J$ = 15,6 Hz).
RMN $^{13}C$ (50 MHz, $CDCl_3$) : 14,2 ; 15,3 ; 22,8 ; 28,8 ; 28,9 ; 29,5 ; 29,6 ; 29,7 ; 29,8 ; 30,3 ; 30,5 ; 30,7 ; 31,1 ; 31,7 ; 32,1 ; 58,8 ; 59,6 ; 68,3 ; 71,9 ; 118,4 ; 119,4 ; 119,7 ; 123,7 ; 124,1 ; 124,3 ; 125,0 ; 125,2 ; 125,7 ; 125,9 ; 126,5 ; 128,9 ; 129,6 ; 132,2 ; 134,7 ; 136 ; 137,1 ; 137,7 ; 138,1 ; 140,1 ; 141,5 ; 144,5 ; 144,7 ; 146 ; 151,7.
SM-ESI : 1784,9 ([M], 100).

Analyse élémentaire pour $C_{111}H_{157}BN_2O_4S_6$ :

| | C | H | N |
|---|---|---|---|
| **Calculé** | **74,62** | **8,86** | **1,57** |
| **Trouvé** | **74,89** | **9,02** | **1,76** |

**EXEMPLE 27 : Synthèse du composé B36**

Le composé **B36** a été synthétisé selon le schéma de synthèse suivant :

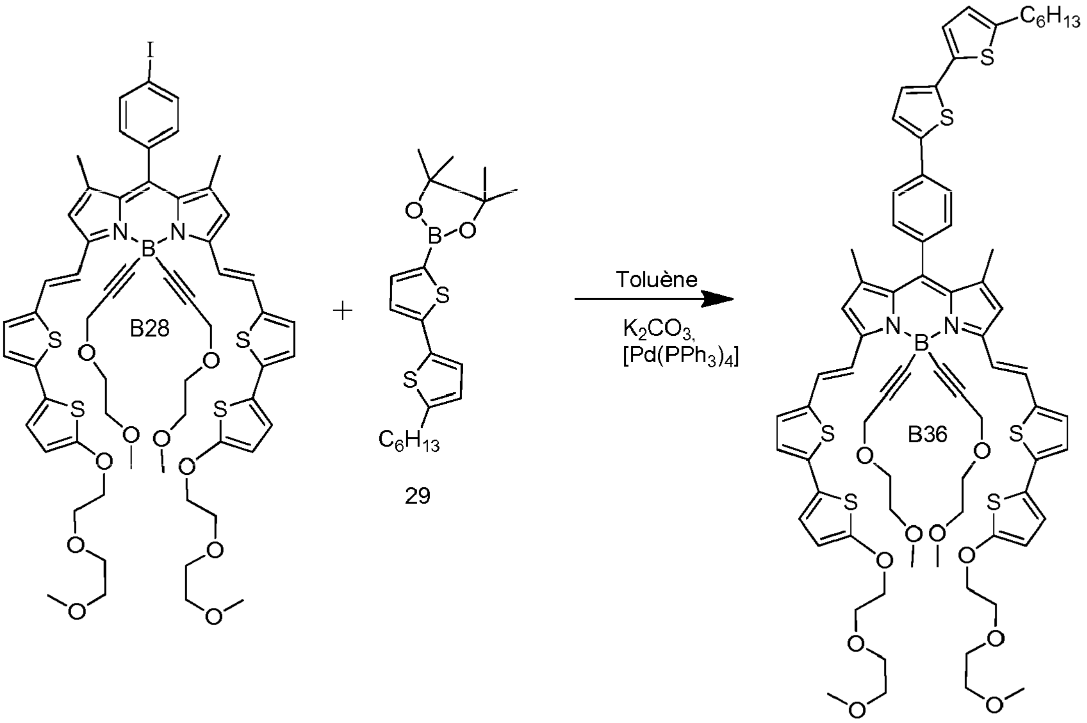


Le composé **B36** a été synthétisé suivant la procédure générale n°3 à partir de 100 mg (81,5 μmol, 1 équiv.) du composé **B28** tel que préparé ci-dessus à l'exemple 19,37 mg (97,8 μmol, 1,2 équiv.) de composé **29**, 0,162 mL d'une solution 2M de $K_2CO_3$ et 5 mg de $[Pd(PPh_3)_4]$ (10% molaire) dans un volume de 5 mL de toluène. Un mélange éther de pétrole / acétate d'éthyle (60/40, v/v) a été utilisé pour la purification du composé désiré. On a obtenu 71 mg du composé **B36** (53 μmol, Rendement : 65%).

RMN $^1H$ (200 MHz, $CDCl_3$) : 0,85-0,91 (m, 3H) ; 1,26-1,41 (m, 12H) ; 1,63-1,71 (m, 2H) ; 2,80 (t, 2H, $^3J$ = 7,3 Hz) ; 3,23 (s, 6H) ; 3,32-3,37 (m, 4H) ; 3,42 (s, 6H) ; 3,58-3,3,76 (m, 12H) ; 3,86-3,90 (m, 4H) ; 4,24-4,29 (m, 8H) ; 6,22 (d, 2H, $^3J$ = 4,2 Hz) ; 6,61 (s, 2H) ; 6,72 (d, 1H, $^3J$ = 3,7 Hz) ; 6,94-6,96 (m, 4H) ; 7,03-7,12 (m, 4H) ; 7,20 (d, 2H, $^3J$ = 15,8 Hz) ; 7,32-7,36 (m, 3H) ; 7,72 (d, 2H, $^3J$ = 8,5 Hz) ; 7,96 (d, 2H, $^3J$ = 15,9 Hz).

RMN $^{13}C$ (50 MHz, $CDCl_3$): 14,2 ;15,3 ; 22,7 ; 28,9 ; 29,8 ; 30,3 ; 31,7 ; 58,9 ; 59,2 ; 59,5 ; 68,4 ; 69,5 ; 70,9 ; 71,8 ; 72,1 ; 73,3 ; 106,4 ; 118,4 ; 120,0 ; 122,5 ; 123,3 ; 123,7 ; 124,1 ; 124,2 ; 124,4 ; 125,1 ; 125,8 ; 126,9 ; 128,5 ; 128,8 ; 129,1 ; 129,5 ; 132,1 ; 134,7 ; 137,5 ; 138,1 ; 139,6 ; 140,2 ; 140,9 ; 141,4 ; 151,3 ; 165,1.

SM-ESI : 1348,2 ([M], 100).

Analyse élémentaire pour $C_{73}H_{81}BN_2O_{10}S_6$ :

| | C | H | N |
|---|---|---|---|
| **Calculé** | **64,96** | **6,05** | **2,08** |
| **Trouvé** | **64,77** | **5,72** | **1,83** |

**EXEMPLE 28 : Synthèse du composé B39**

Le composé **B39** a été synthétisé selon le schéma de synthèse suivant :

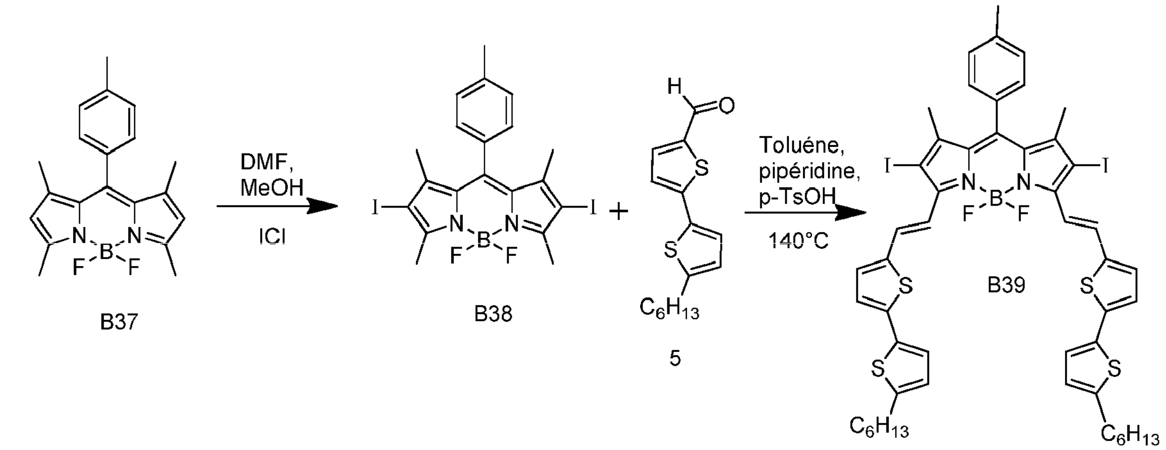


1) Première étape : Synthèse du composé **B38**

A une solution de composé **B37** (500,0 mg ; 1,48 mmol) dans un mélange de méthanol (30 mL) et de diméthylformamide (30 mL), a été ajouté une solution de chlorure d'iode (3,25 mmol) dans du méthanol. La solution a été maintenue sous agitation durant 45 min. La phase organique a été lavée à l'aide d'une solution aqueuse de thiosulfate de sodium et d'eau. La phase aqueuse a été extraite à l'éther. Le composé **B38** attendu a été obtenu avec un rendement de 79%, sous forme d'une poudre rouge après purification par chromatographie sur gel de silice avec un mélange de solvants comme éluant (éther de pétrole/dichlorométhane 7/3, v/v).

RMN $^1$H (200 MHz, ($CDCl_3$), $\delta$ (ppm) : 1,40 (s, 6H) ; 2,46 (s, 3H) ; 6,64 (s, 6H) ; 7,21 (ABsyst, 4H, $^3$J = 7,9 Hz).

RMN $^{13}$C (50 MHz, ($CDCl_3$), $\delta$ (ppm) : 16,1; 17,1 ; 21,6 ; 127,7 ; 130,2 ; 131,5 ; 131,7 ; 131,8 ; 139,6 ; 141,9 ; 145,5 ; 156,7.

ES-MS: 590,0 (100).

Analyse élémentaire pour $C_{20}H_{19}BF_2I_2N_2$ :

| | C | H | N |
|---|---|---|---|
| **Calculé** | **40,71** | **3,25** | **4,75** |
| **Trouvé** | **40,50** | **2,99** | **4,52** |

2) Deuxième étape : Synthèse du composé **B39**

Le composé **B39** a été synthétisé suivant la procédure générale n°1 à partir de 360 mg (0,8 mmol, 1 équiv.) du composé **B38** obtenu ci-dessus à l'étape précédente, et de 395 mg (1,41 mmol, 1 équiv.) de composé **5** dans un volume de 20 ml de toluène. Un mélange éther de pétrole / $CH_2Cl_2$ (70/30, v/v) a été utilisé pour la purification du composé désiré. On a obtenu 330 mg du composé **B39** (0,29 mmol, Rendement : 48%).

RMN $^1$H (400 MHz, ($C_6D_6$) : 0,85-0,90 (m, 6H) ; 1,23-1,26 (m, 12H) ; 1,43 (s, 6H) ; 1,52-1,59 (m, 4H) ; 2,06 (s, 3H) ; 2,58 (t, 4H, $^3$J = 7,7 Hz) ; 6,48 (d, 2H, $^3$J = 3,3 Hz) ; 6,66 (d, 2H, $^3$J = 7,8 Hz) ; 6,83-6,92 (m, 8H) ; 8,04 (d, 2H, $^3$J = 16 Hz) ; 8,53 (d, 2H, $^3$J = 16 Hz).

SM-ESI : 1110,1 ([M], 100).

Analyse élémentaire pour $C_{50}H_{51}BF_2I_2N_2S_4$ :

| | C | H | N |
|---|---|---|---|
| **Calculé** | **33,97** | **2,96** | **2,22** |
| **Trouvé** | **33,84** | **2.72** | **1.96** |

**EXEMPLE 29 : Fabrication de transistors à effet de champ.**

Dans cet exemple, on illustre la fabrication de transistors à effet de champ en mettant en oeuvre des composés de formule (I) conforme à l'invention.

1) Préparation des transistors à effet de champ

Les transistors à effet de champ dans la configuration « *bottom contact* » ont été fabriqués à partir de substrats commerciaux en silicium et tels que décrits dans la notice commerciale disponible à l'adresse suivante : **http:**//www.ipms.fraunhofer.de/content/dam/ipms/common/products/COMEDD/ofe t-e.pdf). Le contact de grille était constitué d'un substrat de silicium de type n (dopage $3x10^{17}/cm^3$) sur lequel a été déposé un oxyde de grille ($SiO_2$) de 230 nm d'épaisseur. Les contacts source et drain pré-lithographiés étaient constitués d'une bicouche ITO (oxyde d'indium et d'étain) de 10 nm comme couche d'accroche, recouverte de 30 nm d'or.

La longueur et la largeur de canal utilisées étaient respectivement 20 μm et 10 mm.

Ces substrats ont été nettoyés en utilisant des bains successifs d'acétone et d'isopropanol puis au final dans un four UV-ozone vendu sous la dénomination commerciale Novascan 4" UV/Ozone System de la société Novascan pendant 15 minutes avant d'être introduits en boîtes à gants sous atmosphère neutre ($N_2$).

Pour passiver la surface de $SiO_2$, de l'hexaméthyldisilazane (HMDS) a été déposé à la tournette (500 tr/min pendant 5 secondes puis 4000 tr/min pendant 50 secondes) avant un recuit thermique à 130°C pendant 15 minutes.

Les composés de formule (I) testés, seuls ou en mélange avec du [6,6]-phényl-$C_{61}$-butyrate de méthyle ($PC_{61}BM$) ont ensuite été déposés à la tournette en utilisant comme solvant du chloroforme ou du chlorobenzène avec des concentrations en composés de formule (I) de l'ordre de 4 mg/ml et les paramètres de dépôt suivants : 2000 tr/min pendant 120 secondes puis 2500 tr/min pendant 120 secondes.

Les transistors, une fois terminés, ont été laissés pendant une nuit sous vide secondaire (< $10^{-6}$ mbar) afin d'éliminer toute trace de solvant.

2) Caractérisation des transistors à effet de champ

Les caractéristiques des transistors (caractéristique de transfert à tension de grille constante : $I_{ds} = f(V_{ds})$ dans laquelle $I_{ds}$ est l'intensité drain source et $V_{ds}$ est la tension drain source) ainsi que leur caractéristique de transfert à tension de drain fixée ($I_{ds} = f(V_g)$ dans laquelle $V_g$ est la tension grille) ont été mesurées sous station sous pointe (atmosphère contrôlée $N_2$) à l'aide d'un analyseur de paramètres modèle 4200 de la société Keithley. Dans tous les cas, la mobilité des porteurs de charge a été estimée à partir des caractéristiques de transfert en mode de saturation en utilisant le formalisme standard.

La Figure 1 représente les caractéristiques de transistors dont le canal est constitué du composé **B4** conforme à l'invention et montre le caractère ambipolaire de cete molécule. La figure la donne les caractéristiques de sortie pour (a) les trous ($I_{ds}$ en μA en fonction de $V_{ds}$ en volts) et (b) pour les électrons ($I_{ds}$ en nA en fonction de $V_{ds}$ en volts).

Les mobilités extraites pour les différentes molécules étudiées (indépendantes du solvant utilisé) sont résumées dans le Tableau 1 ci-après. Les mobilités des électrons ($\mu_e$) et des trous ($\mu_h$) ont été estimées à partir des caractéristiques de transfert des transistors. Seule la molécule **B4** présente un caractère ambipolaire.

**TABLEAU 1**

| Molécule | $\mu_h$ ($cm^2/Vs$) | $\mu_e$ ($cm^2/Vs$) |
|---|---|---|
| **B10** | $1x10^4$ | / |
| **B4** | $1x10^{-3}$ | $1x10^{-3}$ |
| **B2** | $1x10^{-8}$ | / |
| **B12** | $6x10^{-7}$ | / |
| **B8** | $3x10^{-4}$ | / |
| **B9** | $9x10^{-4}$ | / |
| **B35** | $2x10^{-7}$ | / |
| **B28** | $4x10^{-4}$ | / |

3) Fabrication des cellules photovoltaïques

Les cellules photovoltaïques étudiées ont été élaborées de la manière suivante. Des substrats de verre/ITO (Lumtec®, $R_s$ < 15 Ω/□) ont été nettoyés dans un bain à ultrasons (15 minutes, 45°C) successivement à l'acétone, à l'isopropanol puis à l'eau désionisée. Ils ont ensuite été traités dans un four UV-ozone vendu sous la dénomination commerciale Novascan 4" UV/Ozone System par la société Novascan pendant 30 minutes avant dépôt d'une couche

de poly(3,4-éthylènedioxythiophène:poly(styrène sulfonate) de sodium (PEDOT:PSS). Le PEDOT:PSS (société Clevios, grade PH) a été filtré sur une membrane de 0,45 µm, puis déposé à la tournette (1550 tr/min, 180 secondes) pour obtenir une couche homogène d'environ 40 nm. Après dépôt, les échantillons ont étuvés sous vide primaire à 120°C pendant 30 minutes puis introduits en boîtes à gants sous atmosphère inerte ($N_2$).

Des solutions des composés conformes (**$B_n$**) à l'invention en mélange avec du $PC_{61}BM$ (Société NanoC) avec des rapports massiques **$B_n$**:$PC_{61}BM$ variant de 1:0,5 à 1:3 ont été préparées à l'avance en utilisant comme solvant du chloroforme (5 mg/ml de composé **$B_n$**) ou du chlorobenzène (40 mg/ml de **$B_n$**). Les solutions ont été agitées pendant 2 jours minimum à 50°C environ puis à 110°C environ 30 minutes avant le dépôt. Les substrats ont été chauffés à 120°C pendant 30 minutes à l'intérieur de la boîte à gants avant dépôt.

La couche active de **$B_n$**:$PC_{61}BM$ a été déposée à la tournette en utilisant un programme à deux étapes : une première étape de dépôt à 2200 tr/min pendant 180 secondes puis une seconde étape de dépôt à 2500 tr/min pendant 120 secondes.

Le dispositif photovoltaïque a été finalisé par un dépôt métallique de la cathode par effet joule sous vide secondaire (< $10^{-6}$ mbar) à travers un masque d'ombrage. Deux configurations ont été testées : soit une cathode d'aluminium (120 nm), soit une bicouche Ca/Al (20/120 nm). Dans cette seconde configuration, les recuits thermiques (post-élaboration) éventuels ont été effectués avant dépôt de la cathode. Chaque substrat contenait 4 cellules photovoltaïques (3x3 mm2) indépendantes.

4) Caractérisation des cellules photovoltaïques.

Les caractéristiques courant-tension (I-V) des cellules photovoltaïques ainsi préparées ont été mesurées grâce à un sourcemètre (Keithley® 2400 SourceMetre). L'illumination standard a été fournie par un simulateur de rayonnement solaire équipé d'une lampe Xenon de 150 W, vendu par la société Lot Oriel, équipé d'un filtre délivrant un spectre AM1.5G. La puissance reçue par la cellule (100 $mW/cm^2$) a été calibrée à l'aide d'un PuissanceMètre ThorLabs®.

Les paramètres photovoltaïques mesurés sont résumés dans le Tableau 2 ci-après. Les épaisseurs indiquées (d) de la couche active ont été mesurées à l'aide d'un ProfiloMètre Dektak ®.

**TABLEAU 2**

| Molécule | Rapport $TB_n$:$PC_{61}BM$ | $V_{CO}$ (V) | $J_{cc}$ ($mA/cm^2$) | FF (%) | η (%) | Recuit | d (nm) |
|---|---|---|---|---|---|---|---|
| **B10** | 1:2[a)] | 0,76 | 5,84 | 31 | 1,4 | 70°C, 20 min | 110±10 |
| **B4** | 1:0.8 [a)] | 0,60 | 7,7 | 45 | 2,1 | 100°C, 20 min | 110±10 |
| **B2** | 1:2[a)] | 0,56 | 5,1 | 30 | 0,9 | - | 110±10 |
| **B12** | 1:1[a)] | 0,55 | 8,5 | 32 | 1,5 | 80°C, 20 min | 110±10 |
| **B4** | 1:0,8 [b)] | 0,74 | 14,2 | 43 | 4,5 | 100°C, 10 min | 165±10 |
| **B2** | 1:1 [b)] | 0,51 | 3,3 | 33 | 0,6 | 80°C, 10 min | 165±10 |
| **B12** | 1:0,8 [b)] | 0,57 | 2,3 | 30 | 0,4 | - | 165±10 |
| **B4** | 1:0,5[c)] | 0,7 | 14,3 | 47 | 4,7[c)] | 120°C, 20 min | 165±10 |
| **B3** | 1:2 | 0,54 | 2,28 | 29 | 0,36 | - | 80±10 |
| **B28** | 1:1 | 0,4 | 9,57 | 42 | 1,58 | - | 80±10 |
| **B36** | 1:1 | 0,34 | 3,12 | 32 | 0,34 | - | 80±10 |
| **B33** | 1:1 | 0,63 | 3,99 | 30 | 0,76 | - | 80±10 |
| **B29** | 1:1 | 0,48 | 8,00 | 42 | 1,64 | 80°C, 20 min | 80±10 |
| **B12** | 1:1 | 0,68 | 8,83 | 31 | 1,87 | - | 80±10 |
| **B34** | 1:1 | 0,52 | 1,35 | 28 | 0,20 | - | 80±10 |
| **B27** | 1:2 | 0,68 | 3,40 | 31 | 0,71 | - | 110±10 |
| **B35** | 1:1 | 0,52 | 1,99 | 28 | 0,30 | - | 110±10 |
| **B31** | 1:2 | 0,58 | 2,25 | 27 | 0,35 | - | 110±10 |
| **B9** | 1:2 | 0,49 | 1,5 | 19 | 0,20 | - | 110±10 |

(suite)

| Molécule | Rapport $TB_n:PC_{61}BM$ | $V_{CO}$ (V) | $J_{cc}$ (mA/cm$^2$) | FF (%) | η (%) | Recuit | d (nm) |
|---|---|---|---|---|---|---|---|
| **B30** | 1:2 | 0,56 | 2,50 | 29 | 0,42 | - | 110±10 |
| **B8** | 1:2 | 0,52 | 1,77 | 28 | 0,29 | - | 110±10 |
| **B19** | 1:1 | 0,66 | 7,63 | 31 | 1,55 | - | 80±10 |
| **B20** | 1:1 | 0,80 | 3,33 | 27 | 0,72 | 100°C, 10 min | 80±10 |
| **B35** | 1:2 | 0,498 | 2,16 | 28 | 0,30 | - | 110±10 |
| **B6** | 1:0,8 | 0,67 | 1,96 | 33 | 0,43 | 10min, 80°C | 80±10 |
| **B7** | 1:0,8 | 0,57 | 2,15 | 28 | 0,35 | 10min, 80°C | 80±10 |

*Tableau 2* : paramètres photovoltaïques mesurés sur des dispositifs optimisés. $\mathbf{V_{co}}$ : tension de circuit ouvert, $\mathbf{J_{cc}}$ : densité de courant de court-circuit, **FF** : facteur de forme et η : rendement de conversion photovoltaïque. Les conditions d'élaboration sont respectivement a) : solvant chloroforme avec une concentration de 5 mg/ml de $\mathbf{B_n}$ ; b) solvant chlorobenzène avec une concentration de 40 mg/ml de $\mathbf{B_n}$ et une cathode Al ; c) solvant chlorobenzène avec une concentration de 40 mg/ml de $\mathbf{B_n}$ et une cathode Ca/Al.

Le facteur de forme (FF) a été calculé selon la formule suivante :

$$FF = \frac{P\max}{P\max_{abs}} = \frac{Ipm \times Vpm}{Isc \times Voc}$$

dans laquelle :

- Pmax = Puissance électrique maximale mesurée
- $Pmax_{abs}$ = Puissance électrique maximale absolue
- $I_{pm}$ = Intensité du courant à la puissance électrique maximale
- $V_{pm}$ = Tension à la puissance électrique maximale
- $I_{cc}$ = Intensité de court circuit
- $V_{co}$ = Tension de court circuit.

Le rendement ($\eta$) de chacune des cellules a été calculé selon la formule suivante :

$$\eta = \frac{P\max}{Pi} = \frac{Ipm \times Vpm}{Pis \times S} = \frac{FF \times Isc \times Vco}{Pis \times S}$$

dans laquelle :

- Pi = Puissance lumineuse incidente
- Pis = Puissance lumineuse surfacique incidente (fixée à 100 mW/cm$^2$)
- S = Surface de la cellule photovoltaïque

Ces résultats montrent que les cellules de conversion photovoltaïques présentent un $V_{co}$ pouvant atteindre 0,74 V pour la cellule préparée à partir du composé B10, voire 0,76 V pour la cellule préparée avec le composé **B4**, ce qui est supérieur à ce qui est obtenu avec les cellules les plus performantes actuellement dans la littérature actuelle (cellule Konarka P3HT/PCBM : $V_{co}$ < 0,65 V ; C.J. Brabec et al., Adv. Mater., 2009, 21, 1323-1338).

Les courbes (J-V) obtenues avec la molécule **B4** sont représentées sur la Figure 2 annexée sur laquelle la densité de courant (J) en mA/cm$^2$ est fonction de la tension (V) en volts. Sur cette figure, la courbe a) (symbole X) correspond aux conditions d'élaboration solvant chloroforme avec une concentration de 5 mg/ml de $\mathbf{B_n}$ ; la courbe b) (symbole) correspond aux conditions d'élaboration solvant chlorobenzène avec une concentration de 40 mg/ml de $\mathbf{B_n}$ et une cathode Al ; et la courbe c) (symbole ●) correspond aux conditions d'élaboration solvant chlorobenzène avec une concentration de 40 mg/ml de $\mathbf{B_n}$ et une cathode Ca/Al.

La forte densité de courant de court-circuit (environ 14,2 mA/cm$^2$) mesurée dans les conditions b) et c) pour

la molécule **B4** est compatible avec la large réponse spectrale mesurée sur une cellule élaborée selon les conditions b) illustrée sur la Figure 3 annexée sur laquelle le rendement de la cellule photovoltaïque élaborée à partir de **B4** dans les conditions : b) solvant chlorobenzène avec une concentration de 40 mg/ml de $\mathbf{B_n}$ et une cathode Al (en %) est fonction de la longueur d'onde $\lambda$ (en nm). Cette réponse spectrale a été mesurée sur un banc dédié avec pour source lumineuse une lampe halogène Oriel 250 W passant à travers une roue à filtres optiques passe bande.

Les figures 4 et 5 annexées donnent respectivement les courbes (J-V) obtenues avec les molécules **B19** (sans traitement thermique ; $V_{co}$ = 0,66 V ; $J_{cc}$ = 7,63 mA/cm$^2$ ; FF = 0,31 ; PCE = 1,55 %.) et **B20** (après traitement thermique à 100°C pendant 10 min. ; $V_{co}$ = 0,80 V ; $J_{cc}$ = 3,33 mA/cm$^2$ ; FF = 0,27 ; PCE = 0,72 %.). Sur ces figures, la densité de courant (J) en mA/cm$^2$ est fonction de la tension (V) en volts, et ce sans éclairage (courbe haute et pratiquement plate) et sous éclairage standard (100 mW/cm$^2$).

**Revendications**

1. Dérivé de boredipyrrométhène de formule (1) suivante :

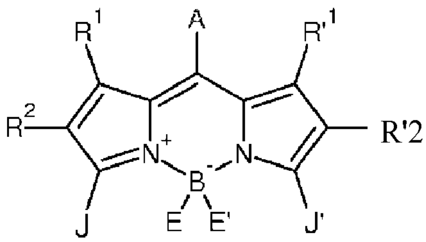

(1)

dans laquelle :

A représente :

- un atome d'hydrogène;
- une chaîne alkyle $C_1$-$C_6$;
- un cycle phényle;
- un cycle phényle substitué par un ou plusieurs groupes W choisis parmi un atome d'halogène, une chaîne carbonée en $C_2$-$C_{20}$, linéaire ou ramifiée pouvant contenir un ou plusieurs hétéroatomes choisis parmi S, O et N, un groupe formyle, carboxyle, thiophène, bis-thiophène ou ter-thiophène, un cycle phényle, un cycle phényle substitué par une chaîne carbonée en $C_2$-$C_{20}$, linéaire ou ramifiée, pouvant contenir un ou plusieurs hétéroatomes choisis parmi S, O, Si et N, le ou lesdits groupes W étant en position 3, 4 et/ou 5 dudit cycle phényle; ou
- un cycle aromatique contenant un hétéroatome choisi parmi S, O, N et Si, ledit cycle aromatique étant éventuellement substitué par un atome d'halogène ou une chaîne carbonée en $C_2$-$C_{20}$, linéaire ou ramifiée pouvant contenir un ou plusieurs hétéroatomes choisis parmi S, O et N ;

$R^1$ $R^2$, $R'^1$ $R'^2$, représentent un atome d'hydrogène ;
E et E', identiques ou différents, représentent un atome de fluor ou un groupe de formule (II) suivante: (II): -C≡C-L, dans laquelle L est choisi parmi une liaison simple; un alkénylène en $C_1$-$C_{10}$ et une chaîne carbonée saturée, linéaire ou ramifiée, en $C_1$-$C_{20}$ interrompue par 1 à 10 atomes d'oxygène et dans lequel cas L est terminé par un groupement choisi parmi un radical alkyle en $C_1$-$C_4$, un groupement phosphate ou un groupement silylé ; L peut également représenter un motif polyaromatique substitué ou comportant des hétéroatomes S, O ou N tel qu'un groupement thiophène, polythiophène, pyrène, pérylène, arylène, triazatruxène ou truxène ;
J représente un groupement de formule (III) suivante :

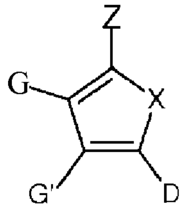

(III)

dans laquelle :

- Z est un lien assurant la liaison avec le groupement boredipyrrométhène de formule (I) et est choisi parmi une fonction vinyle, une fonction acétylène et une liaison C-C directement liée avec le groupement boredipyrrométhène de formule (I) ;
- X est choisi parmi les hétéroatomes, N, O, Si et S ;
- D représente un groupement choisi parmi les groupements arylène, hétéroarylène, benzothiadiazole, et les chaînes carbonées en $C_2$-$C_{20}$, linéaires ou ramifiées;
- G et G', identiques ou différents, représentent un atome d'hydrogène, une chaîne carbonée en $C_2$-$C_{20}$, linéaire ou ramifiée pouvant contenir un ou plusieurs hétéroatomes choisis parmi S, 0, Si et N, étant entendu que G et G' deux à deux, ainsi que G' et D deux à deux, peuvent également former ensemble, et avec les atomes de carbone du cycle auquel ils sont liés, un cycle fusionné choisi parmi les thiènothiophènes et les thiènopyrroles;
- J' représente un groupement méthyle ou un groupement identique au groupement J de formule (III) tel que défini ci-dessus.

2. Dérivé de boredipyrrométhène selon la revendication 1, **caractérisé en ce que** D est choisi parmi une groupe arylène arylène, hétéroarylène, benzothiadiazole, et les chaînes carbonées en $C_2$-$C_{20}$, linéaires ou ramifiées comportant de 2 à 20 atomes de carbone pouvant contenir un ou plusieurs hétéroatomes choisis parmi S, O, Si et N.

3. Dérivé de boredipyrrométhène selon la revendication 1 ou 2, **caractérisé en ce que** A est choisi parmi un atome d'hydrogène, un groupement phényle non substitué, un groupement phényle substitué, un groupement thiophène ou un groupement thiophène substitué.

4. Dérivé de boredipyrrométhène selon l'une quelconque des revendications 1 à 3, **caractérisé en ce que** A est choisi parmi les groupements méthylphényle, iodophényle, et idiothiophène.

5. Dérivé de boredipyrrométhène selon la revendication 1 ou 2, **caractérisé en ce que** A est un cycle phényle.

6. Dérivé de boredipyrrométhène selon l'une quelconque des revendications 1 à 5, **caractérisé en ce que** E et E' répresente chacun un atome de fluor.

7. Dérivé de boredipyrrométhène selon l'une quelconque des revendications 1 à 6, **caractérisé en ce que** D est un groupe thiophène, furane, pyridine, naphtalène, anthracène, pyrène, pérylène, ou un benzothiadiazole, substitué par un ou plusieurs groupements thiophène ou furane et substitué en outre par une ou plusieurs chaînes linéaires ou ramifiées comportant de 2 à 20 atomes de carbone pouvant contenir un ou plusieurs hétéroatomes choisis parmi S, O, Si et N.

8. Dérivé de boredipyrrométhène selon l'une quelconque des revendications 1 à 7, **caractérisé en ce que** D est un groupe thiophène ou furane, substitué par un ou plusieurs groupements thiophène ou furane et substitué en outre par une ou plusieurs chaînes linéaires ou ramifiées comportant de 2 à 20 atomes de carbone pouvant contenir un ou plusieurs hétéroatomes choisis parmi S, O, Si et N.

9. Dérivé de boredipyrrométhène selon l'une quelconque des revendications précédentes **caractérisé en ce qu'**il est choisi parmi les composés B19, B20, B21 et B32 de formules suivantes :

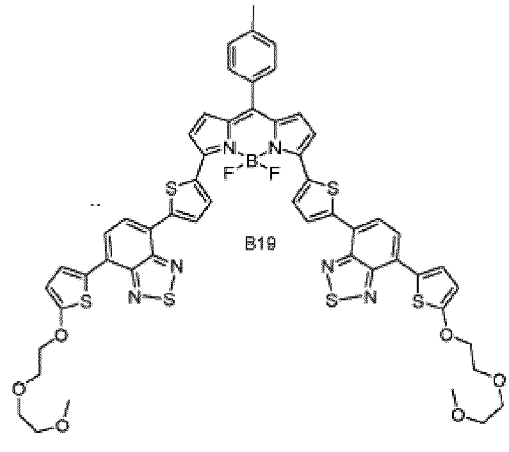

B19

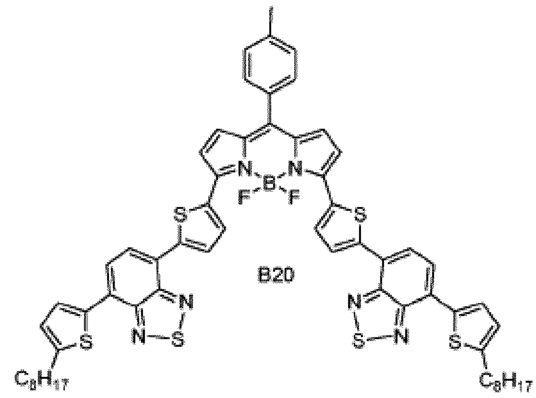

B20

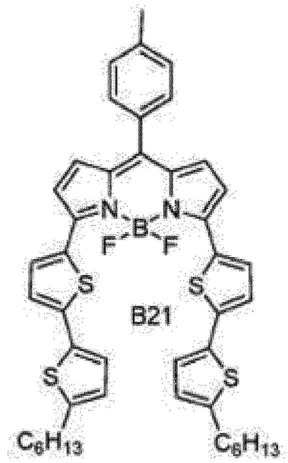

B21

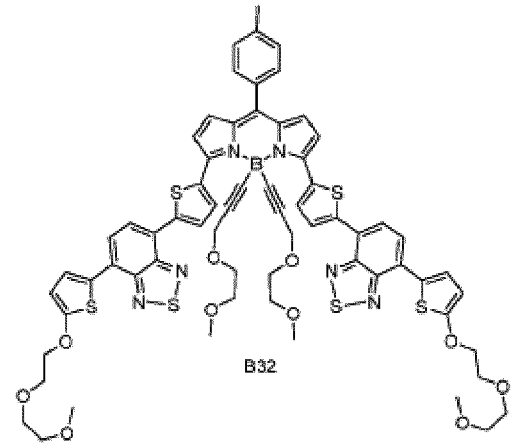

B32

**10.** Utilisation d'au moins un composé de formule (I) tel que défini à l'une quelconque des revendications 1 à 9, à titre de donneurs d'électrons, pour la préparation d'une hétérojonction volumique dans une cellule photovoltaïque.

**11.** Utilisation d'au moins un composé de formule (I) tel que défini à l'une quelconque des revendications 1 à 9, à titre de donneurs d'électrons pour l'élaboration d'un transistor à effet de champ.

**12.** Cellule photovoltaïque comprenant au moins un support, une anode, une couche active comprenant au moins un donneur d'électrons et au moins un accepteur d'électrons, et une cathode, ladite cellule étant **caractérisée en ce que** le donneur d'électrons est choisi parmi les composés de formule (I) tels que définis à l'une quelconque des revendications 1 à 9.

**13.** Cellule photovoltaïque comprenant au moins un support, une anode, une couche active comprenant au moins un donneur d'électrons et au moins un accepteur d'électrons, et une cathode, ladite cellule étant **caractérisée en ce que** le donneur d'électrons est choisi parmi les composés de formule (I) tels que définis à l'une quelconque des revendications 1 à 9.

**14.** Cellule selon la revendication 12 ou 13, **caractérisée en ce que** le rapport massique composé de formule (I)/accepteur d'électrons varie de 10/1 à 1/3.

**15.** Cellule selon l'une quelconque des revendications 12 à 14, **caractérisée en ce que** l'électrode négative est une électrode d'aluminium.

**16.** Cellule selon l'une quelconque des revendications 12 à 13, **caractérisée en ce qu'**une couche tampon est intercalée entre la couche active et l'électrode positive, ladite couche tampon étant constituée d'un mélange de deux polymères : le poly(3,4-éthylènedioxythiophène) et le poly(styrène sulfonate) de sodium.

17. Cellule selon l'une quelconque des revendications 12 à 16, **caractérisée en ce qu'**une couche tampon est intercalée entre la couche active et l'électrode négative, ladite couche tampon étant constituée d'une couche de fluorure de lithium.

## Figure 1

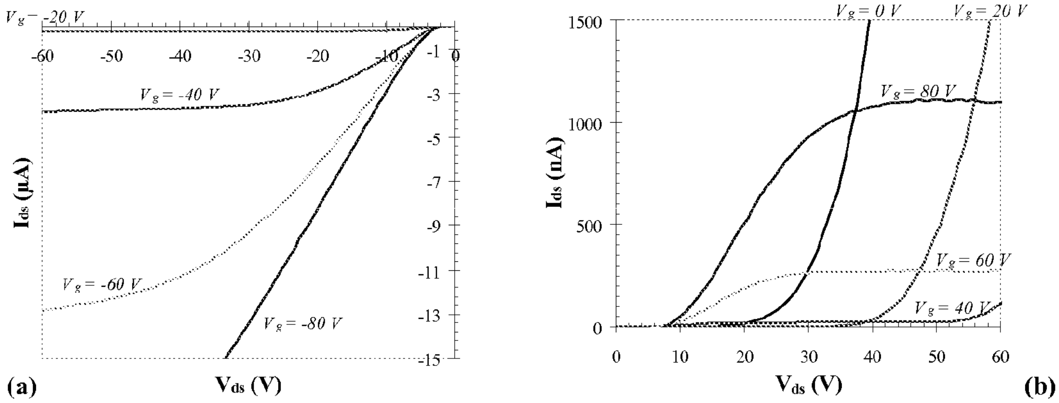


## Figure 2

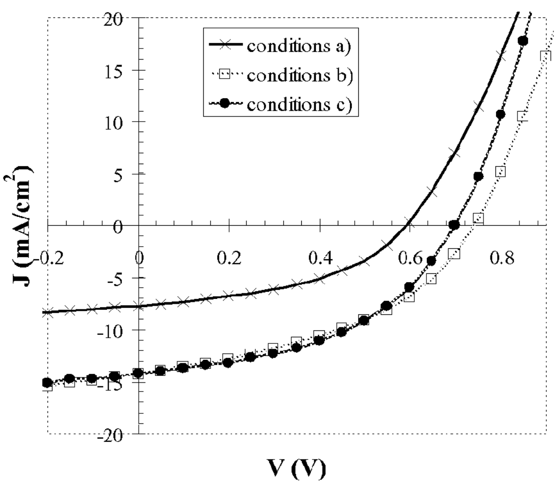


## Figure 3

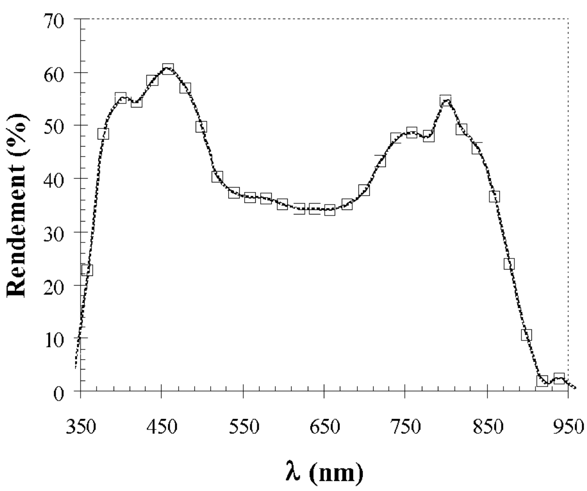

Figure 4

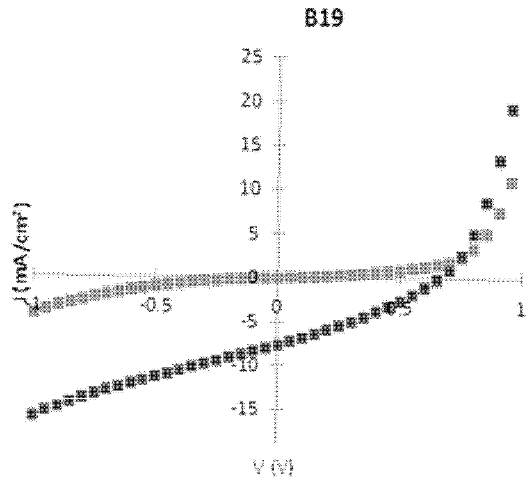


Figure 5

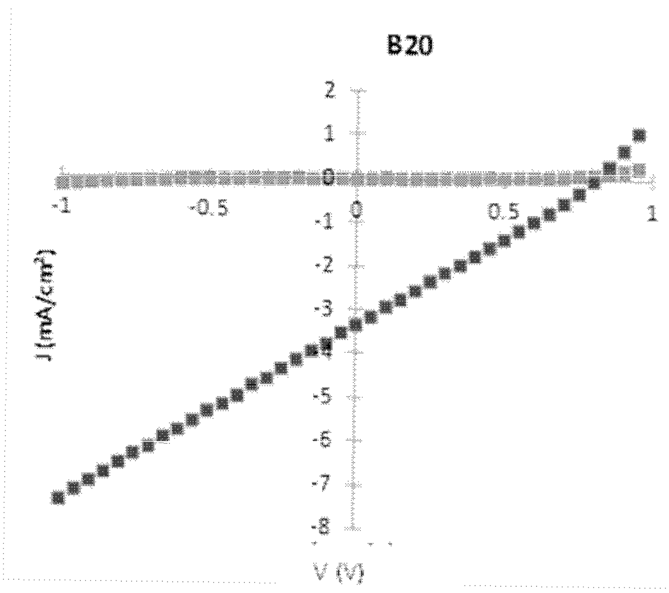

Europäisches Patentamt
European Patent Office
Office européen des brevets

# RAPPORT DE RECHERCHE EUROPEENNE

Numéro de la demande
EP 18 18 5979

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | SULE ERTEN-ELA ET AL: "A Panchromatic Boradiazaindacene (BODIPY) Sensitizer for Dye-Sensitized Solar Cells", ORGANIC LETTERS, vol. 10, no. 15, 1 août 2008 (2008-08-01), pages 3299-3302, XP055041749, ISSN: 1523-7060, DOI: 10.1021/ol8010612 * page 3300; figure 1; composé 2 * | 1-17 | INV. C07F5/02 H01L51/42 |
| X | THEODULF ROUSSEAU ET AL: "BODIPY derivatives as donor materials for bulk heterojunction solar cells", CHEMICAL COMMUNICATIONS, no. 13, 1 janvier 2009 (2009-01-01), page 1673, XP055041764, ISSN: 1359-7345, DOI: 10.1039/b822770e | 1-8, 10-17 | |
| A | * page 1673; composés 1-2 * | 9 | |
| A | DIEGO CORTIZO-LACALLE ET AL: "BODIPY-based conjugated polymers for broadband light sensing and harvesting applications", JOURNAL OF MATERIALS CHEMISTRY, vol. 22, no. 28, 1 janvier 2012 (2012-01-01), page 14119, XP055041766, ISSN: 0959-9428, DOI: 10.1039/c2jm32374e * page 14120; figure 1; composés p(BDP-bisEDOT), p(BDP-bisEDIT) * | 1-17 | DOMAINES TECHNIQUES RECHERCHES (IPC) C07F H01L |

-/--

Le présent rapport a été établi pour toutes les revendications

| Lieu de la recherche | Date d'achèvement de la recherche | Examinateur |
|---|---|---|
| Munich | 14 septembre 2018 | Jeanjean, Fabien |

4

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

Europäisches Patentamt
European Patent Office
Office européen des brevets

# RAPPORT DE RECHERCHE EUROPEENNE

Numéro de la demande
EP 18 18 5979

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | THOMAS BURA ET AL: "Absorption Tuning of Monosubstituted Triazatruxenes for Bulk Heterojunction Solar Cells", ORGANIC LETTERS, vol. 13, no. 22, 18 novembre 2011 (2011-11-18), pages 6030-6033, XP055041774, ISSN: 1523-7060, DOI: 10.1021/ol202443g * page 6031; composés 10-11 * ----- | 1-17 | |
| A | THEODULF ROUSSEAU ET AL: "Multi-donor molecular bulk heterojunction solar cells: improving conversion efficiency by synergistic dye combinations", JOURNAL OF MATERIALS CHEMISTRY, vol. 19, no. 16, 1 janvier 2009 (2009-01-01), page 2298, XP055041782, ISSN: 0959-9428, DOI: 10.1039/b903189h * page 2299; composés 1-2 * ----- | 1-17 | |
| A | WO 2012/071012 A2 (UNIV SINGAPORE [SG]; AGENCY SCIENCE TECH & RES [SG]; CHANG YOUNG-TAE [] 31 mai 2012 (2012-05-31) * page 24; revendication 1 * ----- | 1-17 | DOMAINES TECHNIQUES RECHERCHES (IPC) |
| X | WO 2010/125907 A1 (UNIV KYOTO [JP]; SAJI HIDEO [JP]; ONO MASAHIRO [JP]; KIMURA HIROYUKI [) 4 novembre 2010 (2010-11-04) | 1-3,6,7 | |
| A | * page 12; composé (Ib) * * page 17; tableau 1; composés Ib-1-Ib-5, Ib-26 * ----- | 4,5,8-17 | |
| A | JP 2008 109097 A (TORAY INDUSTRIES) 8 mai 2008 (2008-05-08) * page 2; composé (2) * ----- | 1-17 | |

-/--

Le présent rapport a été établi pour toutes les revendications

| Lieu de la recherche | Date d'achèvement de la recherche | Examinateur |
|---|---|---|
| Munich | 14 septembre 2018 | Jeanjean, Fabien |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

4
EPO FORM 1503 03.82 (P04C02)

Europäisches Patentamt
European Patent Office
Office européen des brevets

# RAPPORT DE RECHERCHE EUROPEENNE

Numéro de la demande
EP 18 18 5979

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | WO 2010/075512 A1 (UNIV MICHIGAN TECH [US]; MA BIWU [US]; LIU HAIYING [US]) 1 juillet 2010 (2010-07-01) * page 84; revendication 10 * ----- | 1-17 | |
| | | | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| Munich | 14 septembre 2018 | Jeanjean, Fabien |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

4

page 3 de 3

## ANNEXE AU RAPPORT DE RECHERCHE EUROPEENNE RELATIF A LA DEMANDE DE BREVET EUROPEEN NO.

EP 18 18 5979

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-09-2018

| Document brevet cité au rapport de recherche | Date de publication | Membre(s) de la famille de brevet(s) | Date de publication |
|---|---|---|---|
| WO 2012071012 A2 | 31-05-2012 | CN 103298820 A | 11-09-2013 |
| | | EP 2643328 A2 | 02-10-2013 |
| | | SG 190173 A1 | 31-07-2013 |
| | | US 2013244251 A1 | 19-09-2013 |
| | | WO 2012071012 A2 | 31-05-2012 |
| WO 2010125907 A1 | 04-11-2010 | AUCUN | |
| JP 2008109097 A | 08-05-2008 | AUCUN | |
| WO 2010075512 A1 | 01-07-2010 | AUCUN | |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- WO 2010076516 A


### Littérature non-brevet citée dans la description


- **FITZNER, R et al.** *Adv. Funct. Mater,* 2011, vol. 21, 897-910
- **WALKER, B et al.** *Adv. Funct. Mater.,* 2009, vol. 19, 3063-3069
- **WEI, G. et al.** *Adv. Eng. Mater.,* 2011, vol. 2, 184-187
- **AJAYAGHOSH, A.** *Acc. Chem. Res.,* 2005, vol. 38, 449-459
- **WONG, W. W. H. et al.** *Adv. Funct. Mater.,* 2010, vol. 20, 927-938
- **KRONENBERG, N. M. et al.** *Chem. Commun.,* 2008, 6489-6491
- **BÜRCKSTÜMMER, H. et al.** *Angew. Chem. Int. Ed.,* 2011, vol. 4506, 11628-11632
- **SUN, Y. et al.** *Nature Mater,* 2011, vol. 11, 44-48
- **A. BIRGHART et al.** *J. Org. Chem.,* 1999, vol. 64, 7813
- **K. H. KIM et al.** *Chem. Mater.,* 2007, vol. 19, 4925-4932
- **O GIDRON et al.** *Chem. Commun.,* 2011, vol. 47, 1976-1978
- **N. LECLERC et al.** *Chem. Mater.,* 2005, vol. 17 (3), 502-513
- **T. ROUSSEAU et al.** *Chem Commun.,* 2009, 1673-1675
- **S. U. KU et al.** *Macromolecules,* 2011, vol. 44, 9533-9538
- **D. W. CHANG et al.** Part A : Polymer Chemistry. *Journal of Polymer Science,* 2012, vol. 50, 271-279
- **M. R. RAO et al.** *Journal of Organometallic Chemistry,* 2010, vol. 695, 863-869
- **M. BENSTEAD et al.** *New Journal of Chemistry,* 2011, vol. 7 (35), 1410-1417
- **A CUI et al.** *Journal of Photochemistry and Photobiology A : Chemistry,* 2007, vol. 186, 85-92
- **C.J. BRABEC et al.** *Adv. Mater.,* 2009, vol. 21, 1323-1338